# EUROPEAN PATENT APPLICATION

(11) **EP 4 770 294 A1**
(43) Date of publication of application: **01.07.2026**
(21) Application number: 24877437.4
(22) Date of filing: 25.09.2024
(51) Int. Cl.: H05K 7/20, H05K 9/00, H04M 1/02, H05K 7/14

(54) **ELECTRONIC DEVICE**

(30) Priority: 12.10.2023 KR 20230136133; 20.12.2023 KR 20230187196
(71) Applicant: Samsung Electronics Co., Ltd., Suwon-si, Gyeonggi-do 16677 (KR)
(72) Inventor: KIM, Seunghun, Suwon-si, Gyeonggi-do 16677 (KR); KIM, Jeongseob, Suwon-si, Gyeonggi-do 16677 (KR); SHIN, Inho, Suwon-si, Gyeonggi-do 16677 (KR); HAN, Junhee, Suwon-si, Gyeonggi-do 16677 (KR)
(74) Representative: Gulde & Partner
(86) International application number: PCT/KR2024/014509
(87) International publication number: WO 2025/079899

(57) **Abstract**

An electronic device according to an embodiment disclosed herein may comprise: a housing that includes an upper surface, a lower surface opposite the upper surface, and a side surface surrounding the upper surface and the lower surface; a display disposed on the upper surface of the housing; a bracket disposed inside the housing; a printed circuit board disposed between the housing and the bracket; a first electronic component disposed on one surface, facing the display, of the printed circuit board; a first shield can surrounding the first electronic component; a heat dissipation member that overlaps a portion of the bracket and the first shield can and is disposed between the first shield can and the display; and a cover plate that is disposed on one region of the heat dissipation member and provided to fix the heat dissipation member to the first shield can. Various other embodiments may be possible.

## Description

### [Technical Field]

Embodiments of the disclosure relate to an electronic device including a cover plate (e.g., a metal plate) for dissipating heat generated by electronic components (e.g., a processor, an integrated circuit (IC), or a memory).

### [Background Art]

An electronic device may refer to a device that performs predetermined functions according to a program installed therein, for example, a home appliance, an electronic notebook, a portable multimedia player, a mobile communication terminal, a tablet PC, a video/audio device, a desktop/laptop computer, or a vehicle navigation system. Electronic devices are being made slimmer, their rigidity is being enhanced, and they are being developed such that their functional elements are differentiated while design aspects are enhanced.

An electronic device may include electronic components (e.g., a processor, an integrated circuit (IC), or a memory) and at least one printed circuit board (PCB) and/or printed board assembly (PBA) on which peripheral circuits are mounted. An electronic device may include shielding components (e.g., shielding members) for shielding noise (e.g., electromagnetic waves) generated by a processor (e.g., an application processor) and electronic components. An electronic device may include a heat transfer member (e.g., a thermal interface material (TIM), a heat spreading member, or a heat spreading plate) for discharging (e.g., dissipating) heat generated by the processor and the electronic components.

The above-described information is provided only as background information for facilitating understanding of the embodiments of the disclosure. It has not yet been determined which of the above contents may be applied as prior art in relation to the disclosure, and no assertion has been made in this regard.

### [Disclosure of Invention]

### [Solution to Problem]

In an electronic device, processors and electronic components having high power consumption per unit area (e.g., power density) are being applied. Since processors and electronic components having a high power consumption per unit area are mounted on printed circuit boards (PCBs, PBAs) having a limited area, heat may be generated in the electronic device. As the temperature of heat generation of an electronic device increases, the performance of the electronic device may be reduced, and the lifetimes of processors and electronic components may be shortened. Due to the increased heat generation temperature, the temperature of an outer surface of the electronic device may increase, which may cause discomfort to a user. In order to dissipate heat generated by electronic components of the electronic device, a heat transfer member (e.g., a TIM, a heat dissipation plate, a heat spreading member, or a heat spreading plate) may be applied. In order to shield noise (e.g., electromagnetic waves) generated by components of the electronic device, a frame made of a metal material (e.g., a metal plate) and a shield can surrounding the processor and the electronic components may be applied. When a force is applied to a display, it may affect the display's performance and cause damage, and therefore, there is a limitation in forming a heat dissipation path from a processor to a display region. Accordingly, heat generated by the processor is dissipated using a shield can. However, since the area of the shield can is limited, the heat generated by the processor may not be effectively dissipated.

Embodiments of the disclosure may provide an electronic device capable of effectively dissipating heat generated by a processor disposed in the electronic device.

Embodiments of the disclosure may provide an electronic device capable of effectively dissipating heat generated by electronic components disposed in the electronic device.

According to embodiments of the disclosure, a heat dissipation member (e.g., a heat dissipation plate or a heat dissipation sheet) may be disposed on a shielding sheet of a shield can, and a cover plate (e.g., a metal plate, a metal sheet, or a cover sheet) may be disposed on the heat dissipation member (e.g., a heat dissipation plate, or a heat dissipation sheet). By bringing the heat dissipation member (e.g., a heat dissipation plate or a heat dissipation sheet) into close contact with the shielding sheet through the cover plate (e.g., a metal plate, a metal sheet, or a cover sheet) so as to form a gap between the display and the heat dissipation member (e.g., a heat dissipation plate or a heat dissipation sheet) and to disperse heat through the heat dissipation member (e.g., a heat dissipation plate or a heat dissipation sheet) and the shielding sheet, an electronic device capable of improving heat dissipation efficiency may be provided .

Technical problems to be achieved by the disclosure are not limited to those mentioned above, and may be variously expanded without departing from the spirit and scope of the disclosure. Other technical problems not mentioned may be clearly understood by those ordinarily skilled in the art to which the disclosure pertains from the following description.

According to an embodiment of the disclosure, an electronic device may include a housing including a top surface, a bottom surface opposite to the top surface, and a side surface surrounding the top surface and the bottom surface, a display disposed on the top surface of the housing, a bracket disposed inside the housing, a printed circuit board disposed between the housing and the bracket, a first electronic component disposed on one surface of the printed circuit board, the one surface facing the display, a first shield can disposed to surround the first electronic component, a heat dissipation member disposed between the first shield can and the display to overlap a portion of the bracket and the first shield can, and a cover plate disposed on a region of the heat dissipation member and disposed to fix the heat dissipation member to the first shield can. Various other embodiments may also be possible.

According to an embodiment of the disclosure, an electronic device may include a housing including a top surface, a bottom surface opposite to the top surface, and a side surface surrounding the top surface and the bottom surface, a display disposed on the top surface of the housing, a bracket disposed inside the housing, a printed circuit board disposed between the housing and the bracket, a first electronic component and a second electronic component disposed on one surface of the printed circuit board, the one surface facing the display, a shield can disposed to surround the first electronic component, a shielding sheet disposed to cover an upper portion of the shield can, a shielding member disposed to surround the second electronic component, and a cover plate (e.g., a metal plate) disposed under the display to overlap a portion of the bracket, the shield can, and the shielding member.

The disclosure may provide an electronic device capable of effectively dissipating heat generated by a processor.

The disclosure may provide an electronic device capable of effectively dissipating heat generated by electronic components.

According to an electronic device of the disclosure, a heat dissipation member (e.g., a heat dissipation plate or a heat dissipation sheet) may be disposed on a shielding sheet (e.g., a shielding plate) of a shield can, and a cover plate (e.g., a metal plate, a metal sheet, or a cover sheet) may be disposed on the heat dissipation member (e.g., a heat dissipation plate or a heat dissipation sheet). The heat dissipation member (e.g., a heat dissipation plate or a heat dissipation sheet) may be brought into close contact with the shielding sheet (e.g., a shielding plate) via a cover plate (e.g., a metal plate, a metal sheet, or a cover sheet) so that a gap may be formed between a display and the heat dissipation member (e.g., a heat dissipation plate or a heat dissipation sheet). Heat dissipation efficiency may be improved by dispersing heat through the heat dissipation member (e.g., a heat dissipation plate or a heat dissipation sheet), the shielding sheet (e.g., a shielding plate), and the cover plate 690 (e.g., a metal plate, a metal sheet, or a cover sheet).

According to an electronic device of the disclosure, damage to a display (e.g., a flexible display) may be prevented when a user presses (e.g., presses in the -z-axis direction) the display with a finger, by allowing a height of a top surface of a cover plate (e.g., a metal plate, a metal sheet, or a cover sheet) and a height of a second portion of a heat dissipation member (e.g., a heat dissipation plate or a heat dissipation sheet) to be substantially the same.

According to an electronic device of an embodiment of the disclosure, heat dissipation efficiency may be improved by allowing heat transferred through a heat dissipation member (e.g., a heat dissipation plate or a heat dissipation sheet) to be spread to a lower structure of a display (e.g., a flexible display) through a thermally conductive compression member (e.g., a thermally conductive gasket) disposed at a position corresponding to a non-display region (e.g., a bezel region) of the display (e.g., a flexible display).

According to an electronic device of an embodiment of the disclosure, heat dissipation efficiency may be improved by allowing heat generated by a processor and at least one electronic component to be dispersed over a wide area through a cover plate (e.g., a vapor chamber, a heat pipe, a heat plate, a metal plate, a metal sheet, or a cover sheet).

According to an electronic device of an embodiment of the disclosure, by bringing a cover plate (e.g., a vapor chamber, a heat pipe, a heat plate, a metal plate, a metal sheet, or a cover sheet) into close contact with a first shielding sheet (e.g., a shielding plate) through the cover plate, a gap may be formed between a display (e.g., a flexible display) and the cover plate (e.g., a vapor chamber, a heat pipe, a heat plate, a metal plate, a metal sheet, or a cover sheet). Heat dissipation efficiency may be improved by dispersing heat through the first shielding sheet (e.g., a shielding plate) and the cover plate (e.g., a vapor chamber, a heat pipe, a heat plate, a metal plate, a metal sheet, or a cover sheet).

The effects that are capable of being obtained by the disclosure are not limited to those described above, and other effects not described above may be clearly understood by a person ordinarily skilled in the art to which the disclosure belongs based on the following description.

### [Brief Description of Drawings]

In connection with the description of the drawings, the same or similar components may be denoted by the same or similar reference numerals.
FIG. 1 is a block diagram of an electronic device according to various embodiments of the disclosure in a network environment.
FIGS. 2A and 2B are views illustrating a first state (e.g., an unfolded state) of an electronic device according to an embodiment of the disclosure, viewed from the front and the rear.
FIGS. 2C and 2D are front and rear views of an electronic device in a second state (e.g., a folded state) according to an embodiment of the disclosure.
FIG. 3A is a perspective view of an electronic device illustrating a first state (e.g., a flat state or an unfolded state) according to an embodiment of the disclosure.
FIG. 3B is a front view of the electronic device in the first state (e.g., an unfolded state) according to an embodiment of the disclosure.
FIG. 3C is a rear view of the electronic device in the first state (e.g., an unfolded state) according to an embodiment of the disclosure.
FIG. 3D is a perspective view of the electronic device illustrating a second state (e.g., a folded state) according to an embodiment of the disclosure.
FIG. 3E is a perspective view of the electronic device illustrating a third state (e.g., an intermediate state) according to an embodiment of the disclosure.
FIGS. 4A and 4B are front and rear views of an electronic device in a first state (e.g., a slide-out state) according to various embodiments of the disclosure.
FIGS. 4C and 4D are front and rear views of the electronic device in a second state (e.g., a slide-in state) according to various embodiments of the disclosure.
FIGS. 5A and 5B are front and rear views of an electronic device in a first state (e.g., the slide-out state) according to an embodiment of the disclosure.
FIGS. 5C and 5D are views illustrating a front surface and a rear surface of an electronic device in a second state (e.g., a slide-in state) according to an embodiment of the present disclosure.
FIG. 6 is an exploded perspective view of an electronic device according to an embodiment of the present disclosure.
FIG. 7 illustrates a state in which the electronic device of FIG. 6 is assembled, in which a housing, a bracket, a heat dissipation member, and a cover plate (e.g., a metal plate, a metal sheet, or a cover sheet) are shown.
FIG. 8 is a cross-sectional view of the electronic device taken along line A-A' of FIG. 7.
FIG. 9 is a cross-sectional view of the electronic device taken along line B-B' of FIG. 7.
FIGS. 10A and 10B are views illustrating a fixing structure of a cover plate (e.g., a metal plate, a metal sheet, or a cover sheet) according to an embodiment of the disclosure.
FIGS. 11 and 12 are cross-sectional views of an electronic device according to an embodiment of the disclosure.
FIGS. 13 and 14 are cross-sectional views of an electronic device according to an embodiment of the disclosure.
FIG. 15 is a cross-sectional view of an electronic device according to an embodiment of the disclosure.
FIGS. 16 and 17 are cross-sectional views of an electronic device according to an embodiment of the disclosure.

It should be noted that throughout the drawings, the same reference numbers are used to describe the same or similar elements, features, and structures.

### [Mode for the Invention]

The following description made with reference to the accompanying drawings is provided to assist in a comprehensive understanding of various embodiments of the disclosure as defined by the claims and their equivalents. Although various specific details are included herein to aid in understanding, they should be regarded as merely illustrative. Accordingly, those ordinarily skilled in the art will recognize that various changes and modifications to the various embodiments described herein may be made without departing from the spirit and scope of the disclosure. Furthermore, descriptions of well-known functions and components may be omitted for clarity and conciseness.

The terms and words used in the following description and claims are not limited to their literal meanings but are used merely by the applicant to enable a clear and consistent understanding of the disclosure. Therefore, it should be apparent to those ordinarily skilled in the art that the following descriptions of various embodiments of the disclosure are provided for illustrative purposes only and are not intended to limit the disclosure as defined by the appended claims and their equivalents.

The singular forms should be understood to include the plural unless the context clearly indicates otherwise. Accordingly, for example, a reference to a "component surface" may include a reference to one or more of such surfaces.

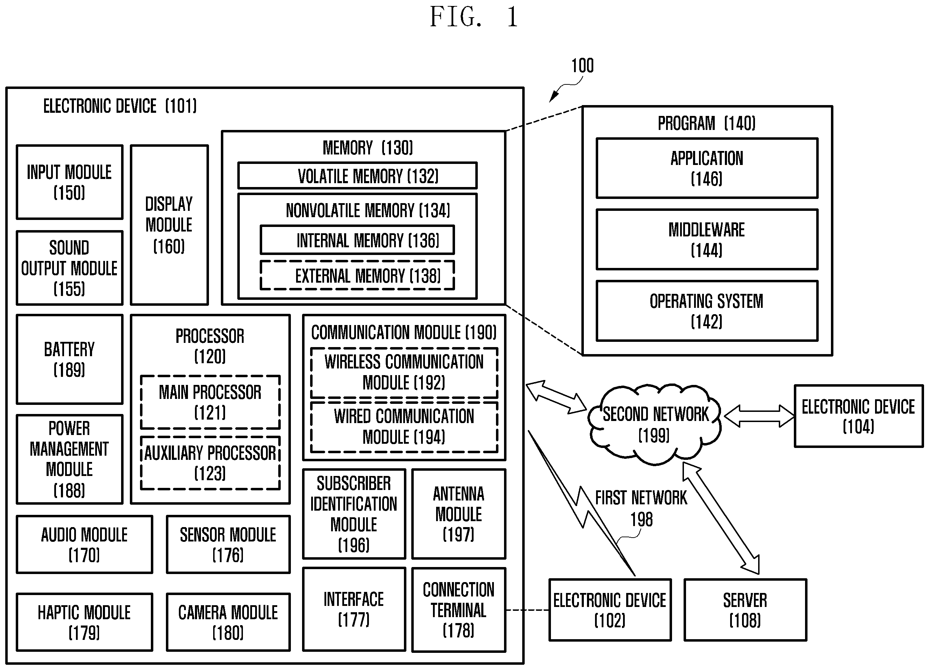

Fig. 1 is a block diagram illustrating an electronic device in a network environment according to various embodiments.

Referring to Fig. 1, the electronic device 101 in the network environment 100 may communicate with an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semisupervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

According to an embodiment, a display module 160 may include a flexible display configured to be foldable or unfoldable.

According to an embodiment, the display module 160 may include a flexible display that is disposed to be slidable in a first direction (e.g., slidable in the x-axis direction) or a second direction (e.g., slidable in the y-axis direction) and provides a screen (e.g., a display screen).

According to an embodiment, the display module 160 may also be referred to as a variable display (e.g., a stretchable display), an expandable display, or a slide-in/out display.

According to an embodiment, the display module 160 may include a bar-type or platetype display.

The electronic device 101 of FIG. 1 may include a touch circuit including a touch sensor and a touch sensor integrated circuit (IC).

The electronic device 101 of FIG. 1 may include an electronic pen (e.g., a stylus pen) and a digitizer.

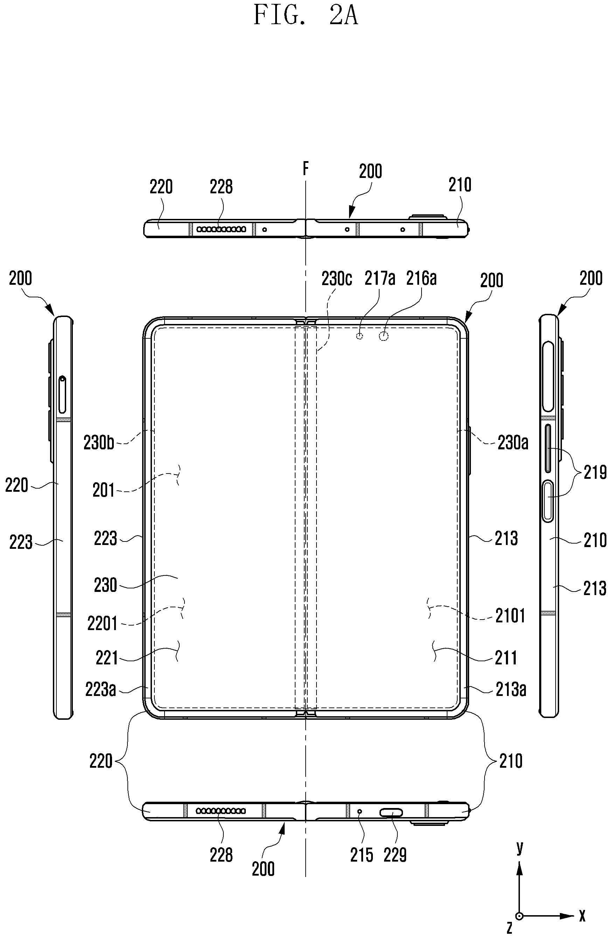

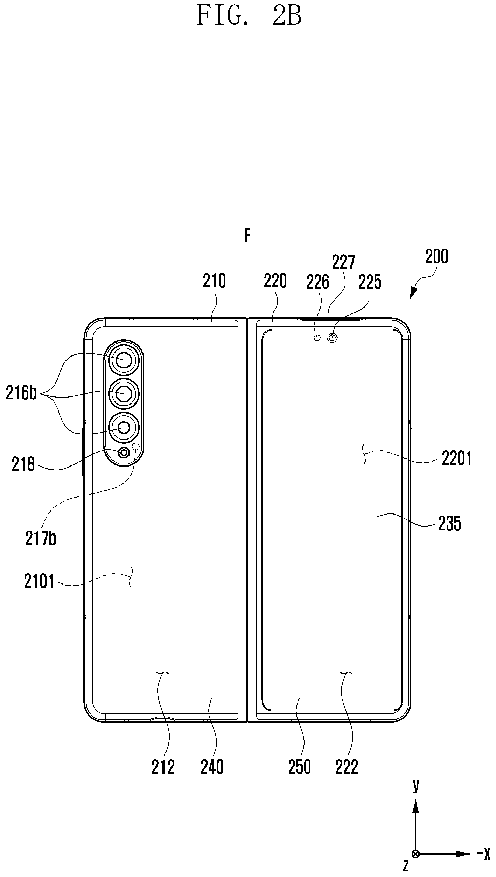

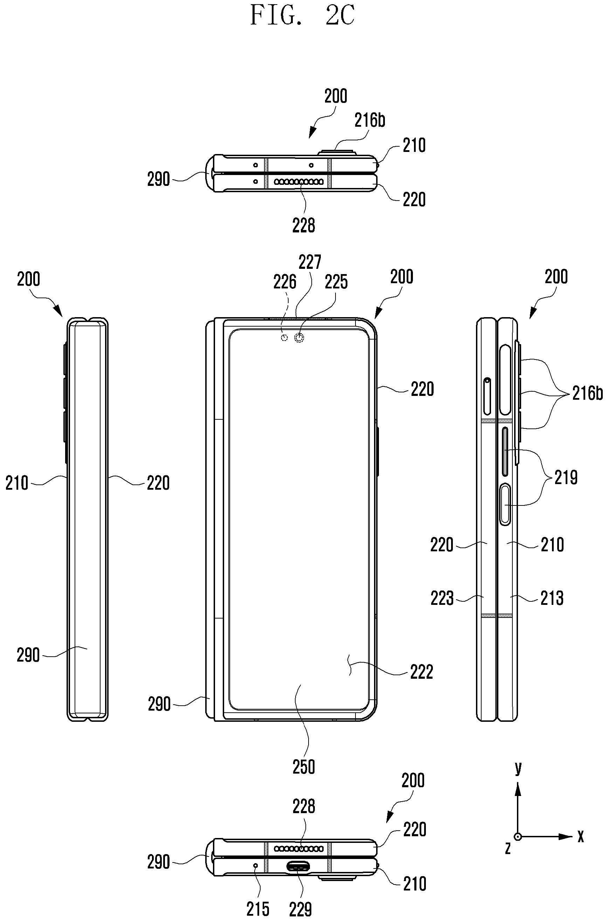

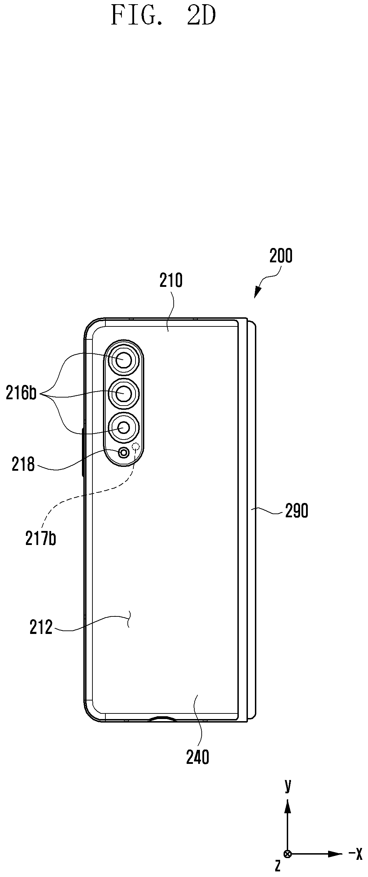

FIGS. 2A and 2B are front and rear views of an electronic device in a first state (e.g., an unfolded state) according to an embodiment of the disclosure. FIGS. 2C and 2D are front and rear views of an electronic device in a second state (e.g., a folded state) according to an embodiment of the disclosure.

The electronic device 200 of FIGS. 2A to 2D may further include embodiments that are at least partially similar to or different from the electronic device 101 of FIG. 1.

Referring to FIGS. 2A to 2D, according to an embodiment of the disclosure, the electronic device 200 (e.g., the electronic device 101 of FIG. 1) may include a pair of housings 210 and 220 (e.g., a foldable housing structure) coupled to each other to be rotatable about a folding axis F via at least one hinge device (e.g., a hinge module or a hinge structure) so as to be foldable relative to each other, a first display 230 (e.g., a flexible display, a foldable display, or a main display) disposed across the pair of housings 210 and 220, and/or a second display 235 (e.g., a sub-display) disposed through the second housing 220.

According to an embodiment, at least a portion of the at least one hinge device may be disposed so as to be invisible from the outside through the first housing 210 and the second housing 220, and in the first state (e.g., the unfolded state), so as to be invisible from the outside through a hinge housing 290 (e.g., a hinge cover) that covers the foldable portion. Herein, the surface on which the first display 230 is disposed may be defined as the front surface of the electronic device 200. Herein, the opposite surface of the front surface may be defined as the rear surface of the electronic device 200. In addition, the surface surrounding the space between the front surface and the rear surface may be defined as the side surface of the electronic device 200.

According to an embodiment, the pair of housings 210 and 220 may include a first housing 210 and a second housing 220 that are foldable relative to each other via at least one hinge device.

According to an embodiment, the pair of housings 210 and 220 are not limited to the shapes and assemblies illustrated in FIGS. 2A to 2D, but may be implemented by other shapes or other combinations and/or assemblies of components.

According to an embodiment, the first housing 210 and the second housing 220 may be disposed on opposite sides of the folding axis F, may have shapes that are generally symmetrical to each other with respect to the folding axis F, and may be folded to match each other.

According to an embodiment, the first housing 210 and the second housing 220 may be folded asymmetrically with respect to the folding axis F.

According to an embodiment, the first housing 210 and the second housing 220 may have different angles or distances from each other depending on whether the electronic device 200 is in a first state (e.g., an unfolded state), a second state (e.g., a folded state), or a third state (e.g., an intermediate state). For example, the electronic device 200 may detect whether it is in the first state (e.g., the unfolded state), the second state (e.g., the folded state), or the third state (e.g., the intermediate state) by using a sensor module (e.g., the sensor module 176 of FIG. 1). The electronic device 200 may detect an angle formed between the first housing 210 and the second housing 220 by using a sensor module (e.g., the sensor module 176 of FIG. 1).

According to an embodiment, the first housing 210 may be connected to at least one hinge device in the first state (e.g., the unfolded state) of the electronic device 200. The first housing 210 may include a first surface 211 disposed to face the front side of the electronic device 200, a second surface 212 facing away from the first surface 211, and/or a first side surface member 213 that surrounds at least a portion of a first space 5101 between the first surface 211 and the second surface 212.

According to an embodiment, the second housing 220 may be connected to at least one hinge device in the first state (e.g., the unfolded state) of the electronic device 200. The second housing 220 may include a third surface 221 disposed to facing the front side of the electronic device 200, a fourth surface 222 facing away from the third surface 221, and/or a second side surface member 223 that surrounds at least a portion of a second space 5201 between the third surface 221 and the fourth surface 222.

According to an embodiment, the first surface 211 may have substantially the same direction as the third surface 221 in the first state (e.g., an unfolded state), and may at least partially face the third surface 221 in the second state (e.g., a folded state).

According to an embodiment, the electronic device 200 may further include a recess 201 defined to accommodate the first display 230 through structural coupling between the first housing 210 and the second housing 220.

According to an embodiment, the recess 201 may have substantially the same size as the first display 230.

According to an embodiment, the first housing 210 may be coupled to the first side surface member 213 when the first display 230 is viewed from above. The first housing 210 may include a first protective frame 213a (e.g., a first decoration member) that covers an edge of the first display 230 so as to be invisible from the outside by overlapping the edge of the first display 230.

According to an embodiment, the first protective frame 213a may be integrated with the first side surface member 213.

According to an embodiment, the second housing 220 may be coupled to the second side surface member 223 when the first display 230 is viewed from above. The second housing 220 may include a second protective frame 223a that covers an edge of the first display 230 so as to be invisible from the outside by overlapping the edge of the first display 230.

According to an embodiment, the second protective frame 223a may be integrated with the second side surface member 223. According to an embodiment, the first protective frame 213a and the second protective frame 223a may be omitted.

According to an embodiment, the hinge housing 290 (e.g., a hinge cover) may be disposed between the first housing 210 and the second housing 220. The hinge housing 290 may be disposed so as to cover at least a portion (e.g., at least one hinge module) of at least one hinge device.

According to an embodiment, the hinge housing 290 may be covered by a portion of the first housing 210 and the second housing 220, or may be exposed to the outside, depending on whether the electronic device 200 is in a first state (e.g., an unfolded state), a second state (e.g., a folded state), or a third state (e.g., a middle state). For example, when the electronic device 200 is in the first state (e.g., the unfolded state), at least a portion of the hinge housing 290 may be covered by the first housing 210 and the second housing 220 to be substantially invisible from the outside.

According to an embodiment, when the electronic device 200 is in the second state (the folded state), at least a portion of the hinge housing 290 may be disposed to be visible from the outside between the first housing 210 and the second housing 220.

According to an embodiment, when the first housing 210 and the second housing 220 are in a third state (intermediate state) in which they form a predetermined angle, the hinge housing 290 may be disposed to at least partially be visible from the outside of the electronic device 200 between the first housing 210 and the second housing 220. For example, the region of the hinge housing 290 exposed to the outside may be smaller than that in the case where the electronic device is fully folded. According to an embodiment, the hinge housing 290 may include a curved surface.

According to an embodiment, when the electronic device 200 is in the first state (e.g., the unfolded state), the first housing 210 and the second housing 220 may form an angle of about 180 degrees, and the first region 230a, the second region 230b, and the folding region 230c of the first display 230 may form a substantially same plane. The first region 230a, the second region 230b, and the folding region 230c of the first display 230 may be oriented in substantially the same direction (e.g., the z-axis direction). As an example, when the electronic device 200 is in the first state (e.g., the unfolded state), the first housing 210 may be rotated relative to the second housing 220 by about 360 degrees so as to be folded in an opposite direction such that the second surface 212 and the fourth surface 222 face each other (e.g., an out-folding type).

According to an embodiment, when the electronic device 200 is in the second state (the folded state), the first surface 211 of the first housing 210 and the third surface 221 of the second housing 220 may be disposed to face each other. In this case, the first region 230a and the second region 230b of the first display 230 may form a narrow angle (e.g., in a range of 0 degrees to about 10 degrees) with each other via the folding region 230c and may be disposed to face each other. According to an embodiment, at least a portion of the folding region 230c may be transformed into a curved shape with a predetermined curvature.

According to an embodiment, when the electronic device 200 is in the third state (intermediate state), the first housing 210 and the second housing 220 may be disposed at a certain angle relative to each other. In this case, the first region 230a and the second region 230b of the first display 230 may form an angle greater than that in the second state (e.g., the folded state) and smaller than that in the first state (e.g., the unfolded state), and the curvature of the folding region 230c may be smaller than that in the second state (e.g., the folded state) and greater than that in the first state (e.g., the unfolded state). According to an embodiment, the first housing 210 and the second housing 220 may form an angle that allows them to stop at a predetermined folding angle between the second state (e.g., a folded state) and the third state (e.g., a middle state) through the at least one hinge device (e.g., a free stop function). According to an embodiment, the first housing 210 and the second housing 220 may be continuously operated while being pressed in the unfolding or folding direction with reference to a predetermined inflection angle via the at least one hinge module.

According to an embodiment, the electronic device 200 may include at least one of the following components: one or more displays 230 and 235, input devices 215, sound output devices 227 and 228, sensor modules 217a, 217b, and 226, camera modules 216a, 216b, and 225, key input devices 219, indicators (not illustrated), or connector ports 229 which are disposed in or on the first housing 210 and/or the second housing 220. According to an embodiment, at least one of the components may be omitted from the electronic device 200 or at least one other component may be additionally included.

According to an embodiment, the one or more displays 230 and 235 may include a first display 230 (e.g., a flexible display) disposed to be supported by the first surface 211 of the first housing 210 and the third surface 221 of the second housing 220 via the at least one hinge device, and a second display 235 disposed in the internal space of the second housing 220 to be at least partially visible from the outside through the fourth surface 222.

According to an embodiment, the second display 235 may be disposed in the internal space of the first housing 210 to be visible from the outside through the second surface 212.

According to an embodiment, the first display 230 may be mainly used in the first state (e.g., the unfolded state) of the electronic device 200. The second display 235 may also be used when the electronic device 200 is in the first state (e.g., the unfolded state).

According to an embodiment, the second display 235 may be mainly used in the second state (e.g., the folded state) of the electronic device 200. The first display 230 may also be used when the electronic device 200 is in the second state (e.g., the folded state).

According to an embodiment, when the electronic device 200 is in the third state (e.g., an intermediate state), the first display 230 and/or the second display 235 may be controlled to be usable based on the folding angle between the first housing 210 and the second housing 220.

According to an embodiment, the first display 230 may be disposed in an accommodation space defined by the pair of housings 210 and 220. For example, the first display 200 may be disposed in the recess 201 defined by the pair of housings 210 and 220, and may be disposed to occupy substantially most of the front surface of the electronic device 200 in the first state (e.g., the unfolded state). According to an embodiment, the first display 230 may include a flexible display, at least a portion of which is transformable into a flat shape or a curved shape.

According to an embodiment, the first display 230 may include a first region 230a facing the first housing 210 and a second region 230b facing the second housing 220. According to an embodiment, the first display 230 may include a folding region 230c including a portion of the first region 230a and a portion of the second region 230b with reference to the folding axis F.

According to an embodiment, at least a portion of the folding region 230c may include a region corresponding to the at least one hinge device.

According to an embodiment, the region division of the first display 230 is merely an exemplary physical division based on the pair of housings 210 and 220 and the at least one hinge device, and in practice, the first display 230 may display a seamless, single entire screen via the pair of housings 210 and 220 and the at least one hinge device.

According to an embodiment, the first region 230a and the second region 230b may have an overall symmetrical shape or a partially asymmetrical shape with respect to the folding region 230c.

According to an embodiment, the electronic device 200 may include a first rear surface cover 240 disposed on the second surface 212 of the first housing 210 and a second rear surface cover 250 disposed on the fourth surface 222 of the second housing 220. According to an embodiment, at least a portion of the first rear surface cover 240 may be formed integrally with the first side surface member 213. According to an embodiment, at least a portion of the second rear surface cover 250 may be formed integrally with the second side surface member 223.

According to an embodiment, at least one of the first rear surface cover 240 and the second rear surface cover 250 may be made of a substantially transparent plate (e.g., a glass plate including various coating layers, or a polymer plate) or an opaque plate. According to an embodiment, the first rear surface cover 240 may be made of, for example, coated or colored glass, ceramic, polymer, metal (e.g., aluminum, stainless steel (STS), or magnesium), or an opaque plate such as a combination of two or more of these materials.

According to an embodiment, the second rear surface cover 250 may be made of a substantially transparent plate such as glass or a polymer. Accordingly, the second display 235 may be disposed in the internal space of the second housing 220 so as to be visible from the outside through the second rear surface cover 250.

According to an embodiment, the input devices 215 may include a microphone. According to an embodiment, the input device 215 may include a plurality of microphones arranged to detect the direction of sound.

According to an embodiment, the sound output devices 227 and 228 may include speakers. According to an embodiment, the sound output devices 227 and 228 may include a call receiver 227 disposed through the fourth surface 222 of the second housing 220, and an external speaker 228 disposed through at least a portion of the second side surface member 223 of the second housing 220.

According to an embodiment, the input device 215, the sound output devices 227 and 228, and the connector port 229 may be disposed in spaces of the first housing 210 and/or the second housing 220. The input devices 215, the sound output devices 227 and 228, and the connector ports 229 may be exposed to an external environment through one or more holes formed in the first housing 210 and/or the second housing 220. According to an embodiment, the holes provided in the first housing 210 and/or the second housing 220 may be commonly used for the input device 215 and the sound output devices 227 and 228. According to an embodiment, the sound output devices 227 and 228 may include a speaker that operates without holes formed in the first housing 210 and/or the second housing 220 (e.g., a piezo speaker).

According to an embodiment, the camera modules 216a, 216b, and 225 may include a first camera module 216a disposed on the first surface 211 of the first housing 210, a second camera module 216b disposed on the second surface 212 of the first housing 210, and/or a third camera module 225 disposed on the fourth surface 222 of the second housing 220.

According to an embodiment, the electronic device 200 may include a flash 218 located near the second camera module 216b. According to an embodiment, the flash 218 may include, for example, a light-emitting diode or a xenon lamp.

According to an embodiment, the camera modules 216a, 216b, and 225 may include one or more lenses, an image sensor, and/or an image signal processor. According to an embodiment, at least one of the camera modules 216a, 216b, and 225 may include two or more lenses (e.g., a wide-angle lens and a telephoto lens) and image sensors, and may be disposed together on one surface of the first housing 210, and/or the second housing 220.

According to an embodiment, the sensor modules 217a, 217b, and 226 (e.g., the sensor module 176 of FIG. 1) may generate an electrical signal or a data value corresponding to an operating state of the inside of the electronic device 200 or an external environment state.

According to an embodiment, the sensor modules 217a, 217b, and 226 (e.g., the sensor module 176 of FIG. 1) may include a first sensor module 217a disposed on the first surface 211 of the first housing 210, a second sensor module 217b disposed on the second surface 212 of the first housing 210, and/or a third sensor module 226 disposed on the fourth surface 222 of the second housing 220.

According to an embodiment, the sensor modules 217a, 217b, and 226 (e.g., the sensor module 176 of FIG. 1) may include at least one of a gesture sensor, a gyro sensor, a grip sensor, a color sensor, an infrared (IR) sensor, an illuminance sensor, an ultrasonic sensor, a proximity sensor, a biometric sensor (e.g., an iris recognition sensor), a distance detection sensor (e.g., a time-of-flight (TOF) sensor, or a light detection and ranging (LiDAR) sensor), a pressure sensor, a magnetic sensor (e.g., a 6-axis sensor or a geomagnetic sensor), an acceleration sensor, a temperature sensor, a humidity sensor, and/or a fingerprint recognition sensor.

According to an embodiment, a processor (e.g., the processor 120 of FIG. 1) of the electronic device 200 may operate the sensor modules 217a, 217b, and 226 (e.g., the sensor module 176 of FIG. 1) to detect illuminance and/or IR intensity around the electronic device 200. The processor 120 may acquire information regarding the illuminance and the IR intensity around the electronic device 200.

According to an embodiment, the electronic device 200 may include at least one of a gesture sensor, a gyro sensor, a grip sensor, a color sensor, an infrared (IR) sensor, an illuminance sensor, an ultrasonic sensor, a proximity sensor, a biometric sensor (e.g., an iris recognition sensor), a distance detection sensor (e.g., a time-of-flight (TOF) sensor or a light detection and ranging (LiDAR) sensor), a pressure sensor, a magnetic sensor (e.g., a 6-axis sensor or a geomagnetic sensor), an acceleration sensor, a temperature sensor, a humidity sensor, and/or a fingerprint recognition sensor, which are not illustrated.

According to an embodiment, the fingerprint recognition sensor may be disposed through at least one side surface member of a first side surface member 213 of the first housing 210 and/or a second side surface member 223 of the second housing 220.

According to an embodiment, the key input devices 219 may be disposed to be exposed to the outside through the first side surface member 213 of the first housing 210. According to an embodiment, key input devices 219 may be disposed to be exposed to the outside through the second side surface member 223 of the second housing 220. According to an embodiment, the electronic device 200 may not include some or all of the key input devices 219, and a key input device 219 not included may be implemented in another form such as a soft key on the at least one display 230 or 235. As an embodiment, the key input devices 219 may be implemented by using a pressure sensor included in the at least one display 230 or 235.

According to an embodiment, the connector port 229 may include a connector (e.g., a USB connector or an interface connector port module (IF module)) configured to transmit/receive power and/or data to/from an external electronic device. According to an embodiment, the connector port 229 may be configured to perform a function for transmitting/receiving an audio signal to and from the external electronic device, or may further include a separate connector port (e.g., an ear jack hole) configured to perform an audio signal transmitting/receiving function.

According to an embodiment, at least one camera module 216a or 225 among the camera modules 216a, 216b, and 225, at least one sensor module 217a or 226 among the sensor modules 217a, 217b, and 226, and/or an indicator may be disposed to be visually exposed through the at least one display 230 or 235. For example, at least one camera module 216a or 225, at least one sensor module 217a or 226, and/or an indicator may be disposed under an active region (display region) of at least one display 230 or 235 in an internal space of at least one housing 210 or 220. At least one camera module 216a or 225, at least one sensor module 217a or 226, and/or an indicator may be disposed so as to be in contact with an external environment through an opening or a transparent region formed in a cover member (e.g., a window layer (not illustrated) of the first display 230 and/or the second rear surface cover 250).

According to an embodiment, a region in which the at least one display 230 or 235 and the at least one camera module 216a or 225 face each other may be provided as a transmissive region with a predetermined transmittance, as a portion of a content display region.

According to an embodiment, the transmissive region may have a transmittance ranging from about 5% to about 20%. The transmissive region may include a region overlapping the effective region (e.g., a field-of-view angle region) of the at least one camera module 216a or 225 through which light passes to be imaged by an image sensor to generate an image. For example, the transmissive region of the display 230 or 235 may include a region having a lower pixel density than the periphery. For example, the transmissive region may replace the opening. For example, the at least one camera module 216a or 225 may include an under-display camera (UDC) or an under-panel camera (UPC). As an embodiment, some camera modules or sensor modules 217a and 226 may be disposed to perform the functions thereof without being visually exposed through a display. For example, the regions facing the camera modules 216a and 225 and/or the sensor modules 217a and 226 disposed under the displays 230 and 235 (e.g., a display panel) may have an under-display camera (UDC) structure, and may not require a perforated opening.

The electronic device 200 of FIG. 2A may include a touch circuit including a touch sensor and a touch sensor integrated circuit (IC).

The electronic device 200 of FIG. 2A may include an electronic pen (e.g., a stylus pen) and a digitizer.

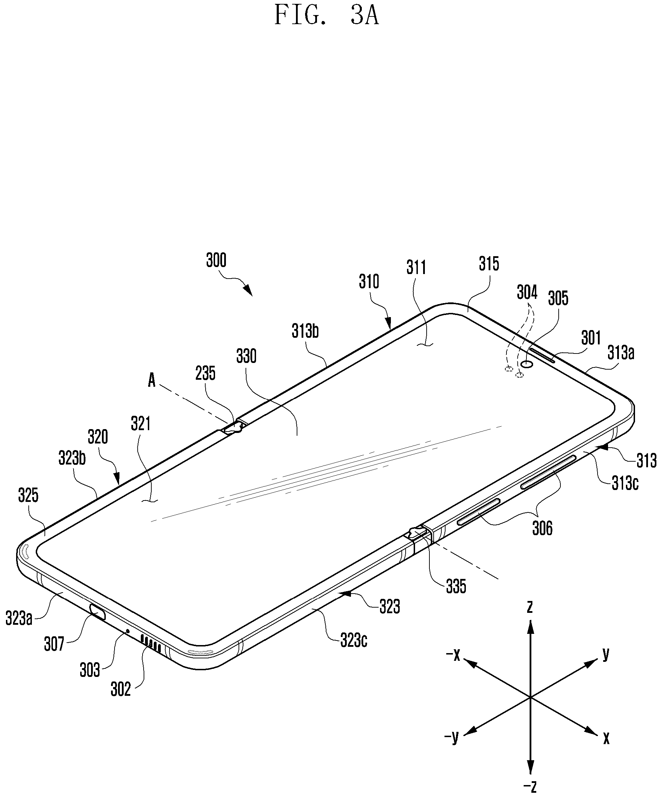

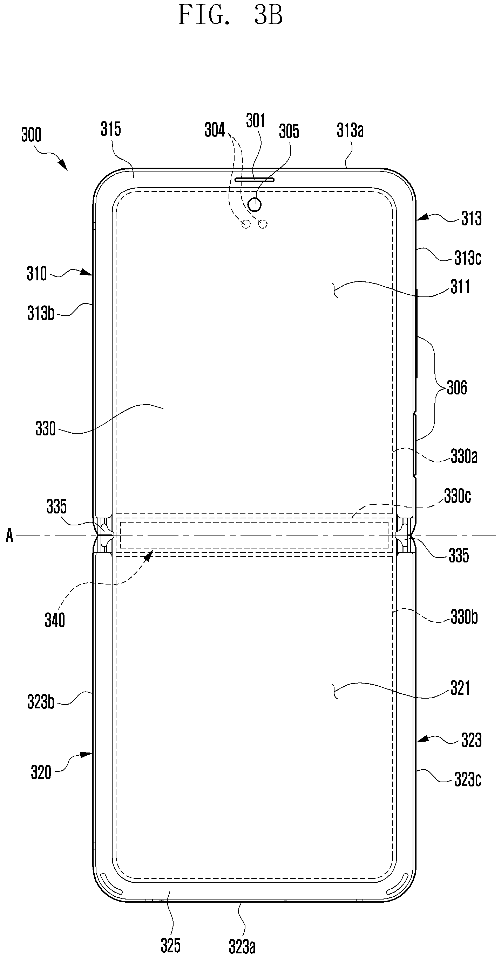

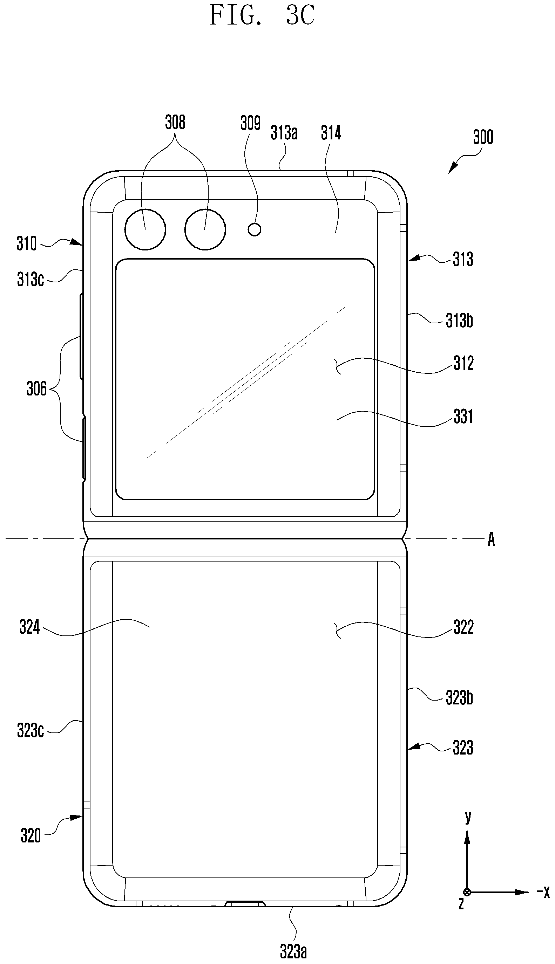

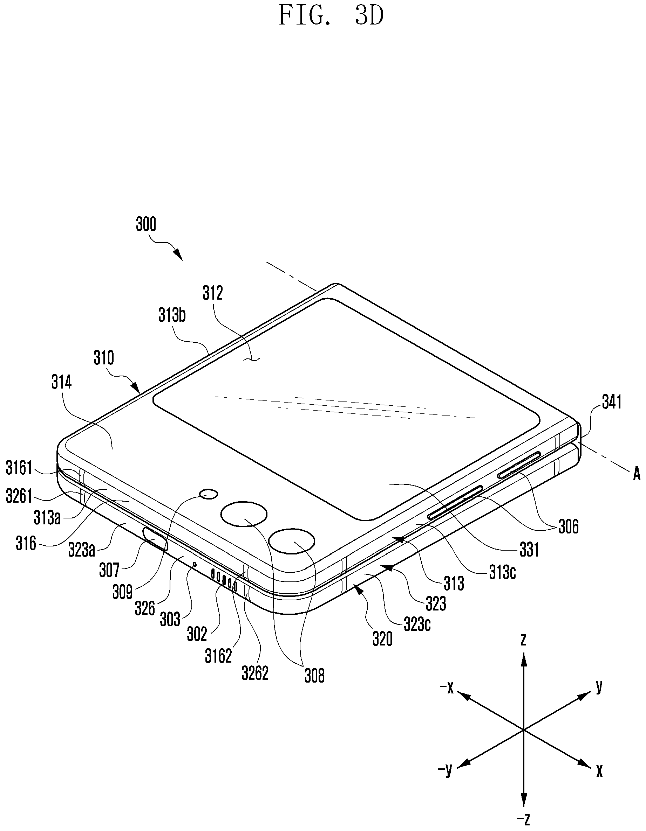

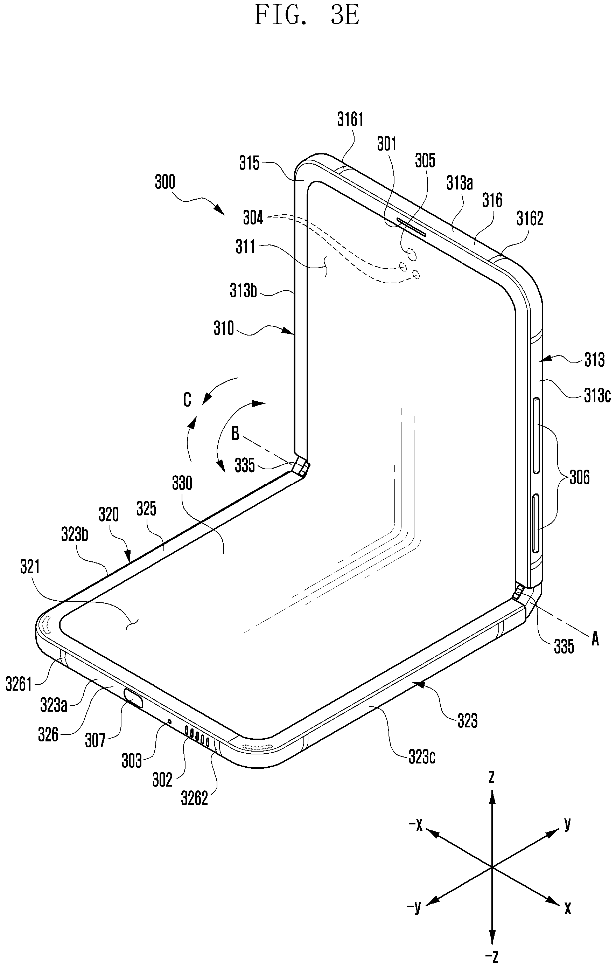

FIG. 3A is a perspective view of an electronic device illustrating a first state (e.g., a flat state or an unfolded state) according to an embodiment of the disclosure. FIG. 3B is a front view of the electronic device in the first state (e.g., an unfolded state) according to an embodiment of the disclosure. FIG. 3C is a rear view of the electronic device in the first state (e.g., an unfolded state) according to an embodiment of the disclosure. FIG. 3D is a perspective view of the electronic device illustrating a second state (e.g., a folded state) according to an embodiment of the disclosure. FIG. 3E is a perspective view of the electronic device illustrating a third state (e.g., an intermediate state) according to an embodiment of the disclosure.

The electronic device 300 of FIGS. 3A to 3E may be at least partially similar to the electronic device 101 of FIG. 1, or may further include other embodiments of an electronic device.

Referring to FIGS. 3A to 3E, the electronic device 300 according to an embodiment of the disclosure may include a pair of housings 310 and 320 (e.g., a foldable housing) that are rotatably coupled so as to be foldable toward each other about a hinge structure (e.g., the hinge structure 340 of FIG. 3B, a hinge device, or a hinge module).

According to an embodiment, the hinge structure 340 may be disposed in the x-axis direction or may be disposed in the y-axis direction. According to an embodiment, two or more hinge structures 340 may be disposed to be folded in the same direction or in different directions.

According to an embodiment, the electronic device 300 may include a flexible display 330 (e.g., a foldable display) disposed in a region formed by the pair of housings 310 and 320.

According to an embodiment, the first housing 310 and the second housing 320 may be disposed on both sides of a folding axis (axis A) and may have shapes that are substantially symmetrical with respect to the folding axis (axis A).

According to an embodiment, the first housing 310 and the second housing 320 may have different angles or distances from each other depending on whether a state of the electronic device 300 is the first state (e.g., a flat state or an unfolded state), the second state (e.g., a folded state), or the third state (e.g., an intermediate state).

According to an embodiment, the pair of housings 310 and 320 may include the first housing 310 (e.g., a first housing structure or a first housing portion) coupled to the hinge structure 340 and the second housing 320 (e.g., a second housing structure or a second housing portion) coupled to the hinge structure 340.

According to an embodiment, the first housing 310 may include, in the first state (e.g., an unfolded state), a first surface 311 oriented in a first direction (e.g., a front direction) (the z-axis direction) and a second surface 312 oriented in a second direction (e.g., a rear direction) (the -z-axis direction) opposite to the first surface 311.

According to an embodiment, the second housing 320 may include, in the first state (e.g., an unfolded state), a third surface 321 oriented in the first direction (the z-axis direction) and a fourth surface 322 oriented in the second direction (the -z-axis direction).

According to an embodiment, when the electronic device 300 is in the first state (e.g., an unfolded state), the first surface 311 of the first housing 310 and the third surface 321 of the second housing 320 may be oriented in substantially the same first direction (the z-axis direction), and in the second state (e.g., a folded state), the first surface 311 and the third surface 321 may operate to face each other.

According to an embodiment, when the electronic device 300 is in the first state (e.g., an unfolded state), the second surface 312 of the first housing 310 and the fourth surface 322 of the second housing 320 may be oriented in substantially the same second direction (the -z-axis direction), and in the second state (e.g., a folded state), the second surface 312 and the fourth surface 322 may operate to face opposite directions. For example, in the second state (e.g., a folded state), the second surface 312 may be oriented in the first direction (the z-axis direction), and the fourth surface 322 may be oriented in the second direction (the -z-axis direction).

According to an embodiment, the first housing 310 may include a first side surface member 313 that forms, at least in part, an exterior of the electronic device 300 and a first rear surface cover 314 coupled to the first side surface member 313 and forming at least a portion of the second surface 312 of the electronic device 300.

According to an embodiment, the first side surface member 313 may include a first side surface 313a, a second side surface 313b extending from one end of the first side surface 313a, and a third side surface 313c extending from the other end of the first side surface 313a. According to an embodiment, the first side surface member 313 may be formed in a rectangular shape (e.g., a square or a rectangle) by the first side surface 313a, the second side surface 313b, and the third side surface 313c.

According to an embodiment, the second housing 320 may include a second side surface member 323 that forms, at least in part, an exterior of the electronic device 300 and a second rear surface cover 324 coupled to the second side surface member 323 and forming at least a portion of the fourth surface 322 of the electronic device 300. According to an embodiment, the second side surface member 323 may include a fourth side surface 323a, a fifth side surface 323b extending from one end of the fourth side surface 323a, and a sixth side surface 323c extending from the other end of the fourth side surface 323a. According to an embodiment, the second side surface member 323 may be formed in a rectangular shape by the fourth side surface 323a, the fifth side surface 323b, and the sixth side surface 323c.

According to an embodiment, the pair of housings 310 and 320 is not limited to the illustrated shapes and couplings, and may be implemented by other shapes or combinations and/or couplings of components. For example, the first side surface member 313 may be formed integrally with the first rear surface cover 314, and the second side surface member 323 may be formed integrally with the second rear surface cover 324.

According to an embodiment, when the electronic device 300 is in the first state (e.g., an unfolded state), the second side surface 313b of the first side surface member 313 and the fifth side surface 323b of the second side surface member 323 may be connected without any gap. According to an embodiment, when the electronic device 300 is in the first state (e.g., an unfolded state), the third side surface 313c of the first side surface member 313 and the sixth side surface 323c of the second side surface member 323 may be connected without any gap.

According to an embodiment, when the electronic device 300 is in the first state (e.g., an unfolded state), a combined length of the second side surface 313b and the fifth side surface 323b may be configured to be greater than a length of the first side surface 313a and/or the fourth side surface 323a. In addition, a combined length of the third side surface 313c and the sixth side surface 323c may be configured to be greater than a length of the first side surface 313a and/or the fourth side surface 323a.

According to an embodiment, the first side surface member 313 and/or the second side surface member 323 may be formed of a metal or may further include a polymer injectionmolded onto a metal. According to an embodiment, the first side surface member 313 and/or the second side surface member 323 may include at least one conductive portion 316 and/or 326 that is electrically segmented through at least one segmentation portion 3161, 3162, and/or 3261, 3262 formed of a polymer. In this case, the at least one conductive portion may be used as an antenna operating in at least one predetermined band (e.g., about 400 MHz to about 6 GHz) by being electrically connected to a wireless communication circuit included in the electronic device 300.

According to an embodiment, the first rear surface cover 314 and/or the second rear surface cover 324 may be formed, for example, of at least one or a combination of at least two of coated or colored glass, ceramic, polymer, or metal (e.g., aluminum, stainless steel (STS), or magnesium).

According to an embodiment, the flexible display 330 may be disposed to extend from the first surface 311 of the first housing 310 across the hinge structure 340 to at least a portion of the third surface 321 of the second housing 320. For example, the flexible display 330 may include a first portion 330a substantially corresponding to the first surface 311, a second portion 330b corresponding to the third surface 321, and a third portion 330c (e.g., a bendable region) connecting the first portion 330a and the second portion 330b and corresponding to the hinge structure 340.

According to an embodiment, the electronic device 300 may include a first protective cover 315 (e.g., a first protective frame or a first decorative member) coupled along an edge of the first housing 310. According to an embodiment, the electronic device 300 may include a second protective cover 325 (e.g., a second protective frame or a second decorative member) coupled along an edge of the second housing 320.

According to an embodiment, the first protective cover 315 and/or the second protective cover 325 may be formed of a metal or a polymer material. According to an embodiment, the first protective cover 315 and/or the second protective cover 325 may be used as a decorative member.

According to an embodiment, the flexible display 330 may be positioned such that an edge of the first portion 330a is interposed between the first housing 310 and the first protective cover 315. According to an embodiment, the flexible display 330 may be positioned such that an edge of the second portion 330b is interposed between the second housing 320 and the second protective cover 325.

According to an embodiment, the flexible display 330 may include a protective cap 335 disposed in a region corresponding to the hinge structure 340.

According to an embodiment, the electronic device 300 may include a hinge housing 341 (e.g., a hinge cover) supporting the hinge structure 340.

According to an embodiment, the flexible display 330 may be disposed so as to extend from at least a portion of the second surface 312 to at least a portion of the fourth surface 322. In this case, the electronic device 300 may be folded to expose the flexible display 330 to the outside (an out-folding type).

According to an embodiment, the electronic device 300 may include a sub-display 331 (e.g., an external display) that is disposed separately from the flexible display 330. According to an embodiment, the sub-display 331 (e.g., an external display) may be disposed to be at least partially exposed on the second surface 312 of the first housing 310, and, in the second state (e.g., a folded state), may display state information (e.g., first state information, second state information, or third state information) of the electronic device 300 in place of the display function of the flexible display 330.

According to an embodiment, the sub-display 331 (e.g., an external display) may be disposed to be visible from the outside through at least a portion of the first rear surface cover 314. According to an embodiment, the sub-display 331 (e.g., an external display) may also be disposed on the fourth surface 322 of the second housing 320. In such a case, the sub-display 331 (e.g., an external display) may be disposed so as to be visible from the outside through at least a portion of the second rear surface cover 324.

According to an embodiment, the electronic device 300 may include at least one of an input device 303 (e.g., a microphone), sound output devices 301 and 302, a sensor module 304, camera devices 305 and 308, a key input device 306, or a connector port 307. The electronic device 300 may further include substantial electronic components (e.g., an input device, a sound output device, a sensor module, or a camera device) that are disposed inside the electronic device 300 and operate through holes or openings.

According to an embodiment, the input device 303 may include at least one microphone 303 disposed in the second housing 320.

According to an embodiment, the sound output devices 301 and 302 may include speakers 301 and 302.

According to an embodiment, at least one connector port 307 may be used to transmit and receive power and/or data to and receive an external electronic device. According to an embodiment, at least one connector port (e.g., an ear-jack hole) may further receive a connector (e.g., an ear-jack) for transmitting and receiving an audio signal to and from an external electronic device.

According to an embodiment, the sensor module 304 may generate an electrical signal or a data value corresponding to an operation state inside the electronic device 300 or an environmental state outside the electronic device. The sensor module 304 may, for example, detect an external environment through the first surface 311 of the first housing 310. According to an embodiment, the electronic device 300 may further include one or more sensor modules that are disposed to detect an external environment through the second surface 312 of the first housing 310.

According to an embodiment, the sensor modules 304 (e.g., a luminance sensor) may be disposed under the flexible display 330 to detect an external environment through the flexible display 330.

According to an embodiment, the sensor modules 304 (e.g., the sensor module 176 of FIG. 1) may include at least one of a gesture sensor, a gyro sensor, a grip sensor, a color sensor, an infrared (IR) sensor, an illuminance sensor, an ultrasonic sensor, a proximity sensor, a biometric sensor (e.g., an iris recognition sensor), a distance detection sensor (e.g., a time-of-flight (TOF) sensor or a light detection and ranging (LiDAR) sensor), a pressure sensor, a magnetic sensor (e.g., a 6-axis sensor or a geomagnetic sensor), an acceleration sensor, a temperature sensor, a humidity sensor, and/or a fingerprint recognition sensor.

According to an embodiment, the camera devices 305 and 308 may include a first camera device 305 (e.g., a front camera device) disposed on the first surface 311 of the first housing 310 and a second camera device 308 disposed on the second surface 312 of the first housing 310. The electronic device 300 may further include a flash 309 that is disposed near the second camera device 308.

According to an embodiment, the camera devices 305 and 308 may further include lenses for time-of-flight (TOF) and/or an image sensor.

According to an embodiment, the key input device 306 (e.g., a key button) may be disposed on the third side surface 313c of the first side surface member 313 of the first housing 310. According to an embodiment, the key input device 306 may be disposed on at least one of the other side surfaces 313a and 313b of the first housing 310 and/or on at least one of the side surfaces 323a, 323b, and 323c of the second housing 320.

According to an embodiment, some of the camera devices 305 and 308 (e.g., the first camera device 305) or the sensor modules 304 may be disposed to be exposed through the flexible display 330. For example, the first camera device 305 or the sensor modules 304 may be disposed in an internal space of the electronic device 300 to be in contact with an external environment through an opening (e.g., a through-hole) formed, at least in part, in the flexible display 330.

According to an embodiment, some of the sensor modules 304 may be disposed in the internal space of the electronic device 300 so as to perform their functions without being visually exposed through the flexible display 330. For example, in such a case, an opening may be omitted from a region of the flexible display 330 that faces the sensor modules 304.

According to an embodiment, the electronic device 300 may be operated to maintain the third state (e.g., the intermediate state) through the hinge structure 340. In this case, the electronic device 300 may control the flexible display 330 to display different pieces of content in a display region corresponding to the first surface 311 and a display region corresponding to the third surface 321.

According to an embodiment, the electronic device 300 may be operated, based on a predetermined inflection angle (e.g., the angle between the first housing 310 and the second housing 320 in the intermediate state), to be substantially in the first state (e.g., the unfolded state (the unfolded state of FIG. 3A)) and/or substantially in the second state (e.g., the folded state (the folded state of FIG. 3D)) through the hinge structure 340. For example, when a pressing force is applied in an unfolding direction (direction B) while the electronic device 300 is in a state unfolded at the predetermined inflection angle via the hinge structure 340, the electronic device 300 may be operated to transition to the first state (e.g., the unfolded state (the unfolded state of FIG. 3A)). For example, when a pressing force is applied in a folding direction (direction C) while the electronic device 300 is in a state unfolded at the predetermined inflection angle via the hinge structure 340, the electronic device 300 may be operated to transition to the second state (e.g., the folded state (the folded state of FIG. 3D)). According to an embodiment, the electronic device 300 may be operated to maintain a state unfolded at various angles (not illustrated) via the hinge structure 340.

According to FIG. 3A, the electronic device 300 may include a touch circuit including a touch sensor and a touch sensor (integrated circuit) IC.

The electronic device 300 of FIG. 3A may include an electronic pen (e.g., a stylus pen) and a digitizer.

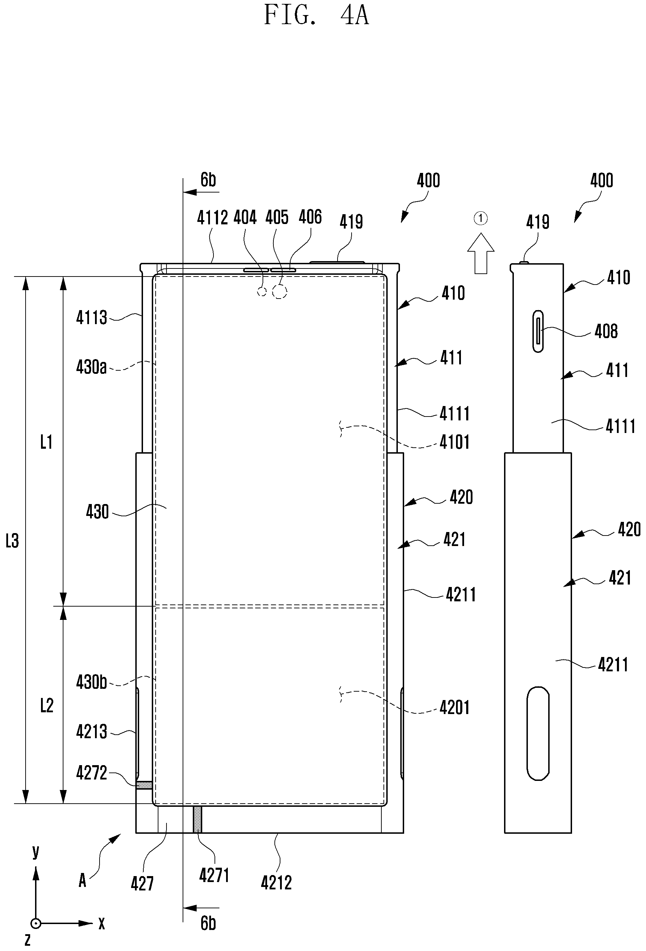

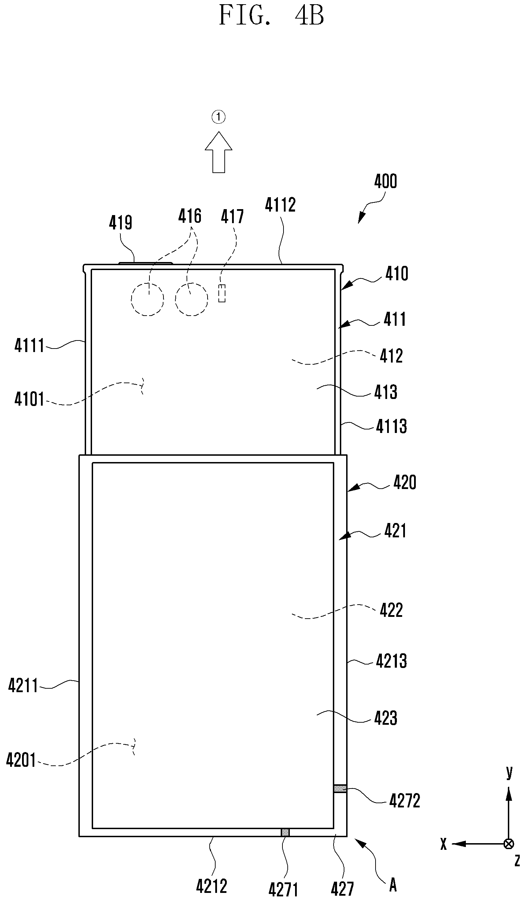

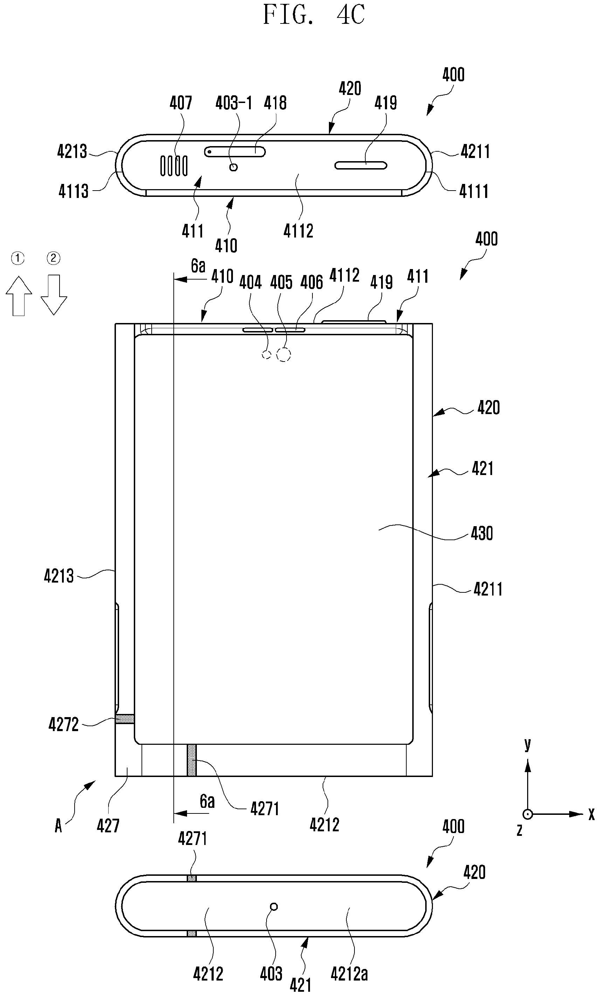

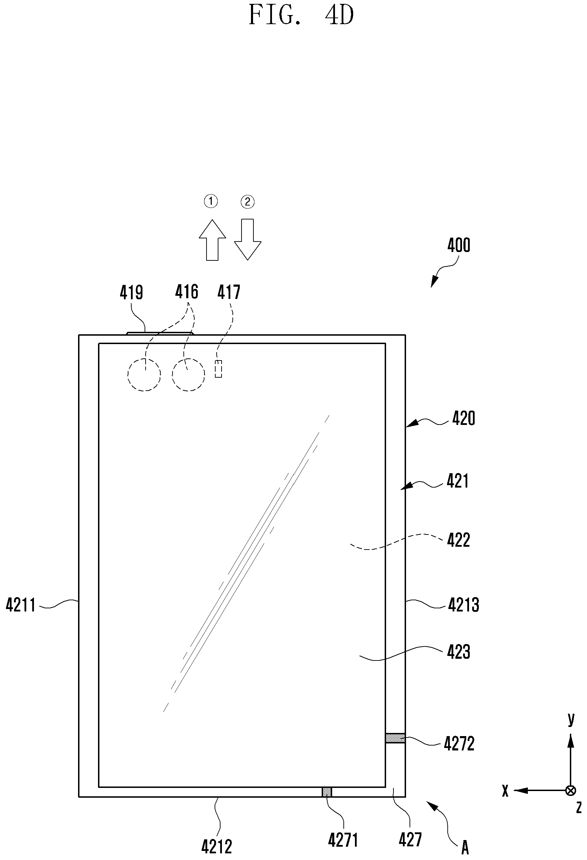

FIGS. 4A and 4B are front and rear views of an electronic device in a first state (e.g., a slide-out state) according to various embodiments of the disclosure. FIGS. 4C and 4D are front and rear views of the electronic device in a second state (e.g., a slide-in state) according to various embodiments of the disclosure.

The electronic device 400 of FIGS. 4A to 4D may be at least partially similar to the electronic device 101 of FIG. 1, or may further include other embodiments of the electronic device.

Referring to FIGS. 4A to 4D, the electronic device 400 according to an embodiment of the disclosure may be configured such that two housings 410 and 420 are slid relative to each other in a predetermined direction (e.g., direction ① or direction ②) (e.g., the +y-axis or -y-axis direction), so that a display area of a rollable display 430 (e.g., a flexible display) may be varied (e.g., increased or decreased). However, the disclosure is not limited thereto, and the electronic device 400 may also be configured to induce variation (e.g., expansion or reduction) of a display area of the rollable display 430 by allowing the two housings 410 and 420 to be slid in a direction perpendicular to a predetermined direction (e.g., the +x-axis or -x-axis direction).

According to an embodiment, the electronic device 400 may include a first housing 410 (e.g., a first housing structure, a moving portion, or a slide housing), a second housing 420 (e.g., a second housing structure, a fixing portion, or a base housing) slidably coupled to the first housing 410 in a predetermined direction (e.g., a direction ① or a direction ② (e.g., the +y-axis direction or -y-axis axis direction), and a rollable display 430 (e.g., a flexible display (e.g., an expandable display or a stretchable display)) disposed to be supported by at least portions of the first housing 410 and the second housing 420.

According to an embodiment, the electronic device 400 may be configured such that, with respect to the second housing 420 gripped by a user, the first housing 410 is slid out in a first direction (direction ① (e.g., the y-axis direction)) or is slid in in a second direction (direction ② (e.g., the -y-axis direction)) opposite to the first direction (direction ①).

According to an embodiment, the first housing 410 including a first space 4101 may be transitioned into a slide-in state by being accommodated, at least in part, in a second space 4201 of the second housing 420. For example, the first housing may be transitioned from the first state (e.g., a slide-out state) to the second state (e.g., a slide-in state).

According to an embodiment, in the slide-out state, the electronic device 400 may include a bendable member (or a bendable support member (e.g., a multi-joint hinge module or a multiple-bar assembly)) configured to form, at least in part, a plane that is the same as at least a portion of the first housing 410.

According to an embodiment, when the electronic device 400 is in the slide-in state, the bendable member (or the bendable support member (e.g., a multi-joint hinge module or a multiple-bar assembly)) may be accommodated, at least in part, into the second space 4201 of the second housing 420.

According to an embodiment, at least a portion of the rollable display 430 may be disposed to be invisible from the outside by being accommodated in the second space 4201 of the second housing 420 in the slide-in state while being supported by the bendable member.

According to an embodiment, at least a portion of the rollable display 430 may be disposed to be visible from the outside in the slide-out state while being supported by the bendable member forming, at least in part, the same plane as the first housing 410.

According to an embodiment, the electronic device 400 may include the first housing 410 including a first side surface member 411 and the second housing 420 including a second side surface member 421.

According to an embodiment, the first side surface member 411 may include a first side surface 4111 having a first length along the first direction (e.g., the y-axis direction), a second side surface 4112 extending from the first side surface 4111 in a substantially perpendicular direction (e.g., the x-axis direction) and having a second length smaller than the first length, and a third side surface 4113 extending from the second side surface 4112 substantially in parallel with the first side surface 4111 and having the first length.

According to an embodiment, the first side surface member 411 may be formed, at least in part, of a conductive member (e.g., metal). For example, the first side surface member 411 may be formed by a combination of a conductive member and a non-conductive member (e.g., polymer).

According to an embodiment, the first housing 410 may include a first support member 412 extending from at least a portion of the first side surface member 411 to at least a portion of the first space 4101.

According to an embodiment, the first support member 412 may be formed integrally with the first side surface member 411. For example, the first support member 412 may be formed separately from the first side surface member 411 and may be structurally coupled to the first side surface member 411.

According to an embodiment, the second side surface member 421 may correspond, at least in part, to the first side surface 4111. The second side surface member 421 may include a fourth side surface 4211 having a third length, a fifth side surface 4212 extending from the fourth side surface 4211 in a direction substantially parallel to the second side surface 4112 and having a fourth length smaller than the third length, and a sixth side surface 4213 extending from the fifth side surface 4212 to correspond to the third side surface 4113 and having the third length.

According to an embodiment, the second side surface member 421 may be formed, at least in part, of a conductive member (e.g., metal). For example, the second side surface member 421 may be formed by a combination of a conductive member and a non-conductive member (e.g., polymer).

According to an embodiment, at least a portion of the second side surface member 421 may include a second support member 422 extending to at least a portion of the second space 4201 of the second housing 420.

According to an embodiment, the second support member 422 may be formed integrally with the second side surface member 421. For example, the second support member 422 may be formed separately from the second side surface member 421 and may be structurally coupled to the second side surface member 421.

According to an embodiment, the first side surface 4111 and the fourth side surface 4211 may be coupled to be slidable with respect to each other.

According to an embodiment, the third side surface 4113 and the sixth side surface 4213 may be coupled to be slidable with respect to each other.

According to an embodiment, in the slide-in state, the first side surface 4111 may be disposed to be substantially invisible from the outside by being overlapped with the fourth side surface 4211.

According to an embodiment, in the slide-in state, the third side surface 4113 may be disposed to be substantially invisible from the outside by being overlapped with the sixth side surface 4213. For example, at least a portion of the first side surface 4111 and the third side surface 4113 may be disposed to be at least partially visible from the outside in the slide-in state.

According to an embodiment, in the slide-in state, the first support member 412 may be disposed to be substantially invisible from the outside by being overlapped with the second support member 422.

According to an embodiment, the first housing 410 may include a first rear surface cover 413 coupled to at least a portion of the first side surface member 411.

According to an embodiment, the first rear surface cover 413 may be disposed to be coupled to at least a portion of the first support member 412. For example, the first rear surface cover 413 may be formed integrally with the first side surface member 411.

According to an embodiment, the first rear surface cover 413 may be formed of polymer, coated or colored glass, ceramic, metal (e.g., aluminum, stainless steel (STS), or magnesium), or a combination of at least two of such materials. For example, the first rear surface cover 413 may extend to at least a portion of the first side surface member 411. For example, at least a portion of the first support member 412 may be replaced with the first rear surface cover 413.

According to an embodiment, the second housing 420 may include a second rear surface cover 423 coupled to at least a portion of the second side surface member 421.

According to an embodiment, the second rear surface cover 423 may be disposed to be coupled to at least a portion of the second support member 422. For example, the second rear surface cover 423 may be formed integrally with the second side surface member 421.

According to an embodiment, the second rear surface cover 423 may be formed of polymer, coated or colored glass, ceramic, metal (e.g., aluminum, stainless steel (STS), or magnesium), or a combination of at least two of such materials. For example, the second rear surface cover 423 may extend to at least a portion of the second side surface member 421. For example, at least a portion of the second support member 422 may be replaced with the second rear surface cover 423.

According to an embodiment, the rollable display 430 may be disposed to be supported by at least a portion of the first housing 410 and the second housing 420.

According to an embodiment, the rollable display 430 may include a first portion 430a (e.g., a flat portion) that is always visible from the outside and a second portion 430b (e.g., a bendable portion) extending from the first portion 430a. The second portion 430b (e.g., the bendable portion) may be at least partially accommodated in the second space 4201 of the second housing 420 in the slide-in state to be invisible from the outside.

According to an embodiment, the first portion 430a may be disposed to be supported by the first housing 410. The second portion 430b may be disposed to be supported, at least in part, by the bendable member.

According to an embodiment, the second portion 430b of the rollable display 430 may extend from the first portion 430a while being supported by the bendable member when the first housing 410 is slid out along the first direction (direction ①). The second portion 430b of the rollable display 430 may be disposed to form substantially the same plane as the first portion 430a and to be visible from the outside when the first housing 410 is slid out along the first direction (direction ①).

According to an embodiment, the second portion 430b of the rollable display 430 may be accommodated in the second space 4201 of the second housing 420 when the first housing 410 is slid in along the second direction (direction ②). The second portion 430b of the rollable display 430 may be disposed to be invisible from the outside when the first housing 410 is slid in along the second direction (direction ②). Accordingly, in the electronic device 400, as the first housing 410 is moved in a sliding manner along a predetermined direction (e.g., the +y-axis or -y-axis direction) from the second housing 420, the display area of the rollable display 430 may be varied (e.g., expanded or reduced).

According to an embodiment, the rollable display 430 may have a variable (e.g., expanded or reduced) length in the first direction (direction ①) according to the sliding movement of the first housing 410, which is moved with respect to the second housing 420. For example, in the slide-in state, the rollable display 430 may have a first display area corresponding to a first length L1 (e.g., a region corresponding to the first portion 430a).

According to an embodiment, when the rollable display 430 is in the slide-out state, the first housing 410 may be slid by a second length L2 with respect to the second housing 420. In the slide-out state, the rollable display 430 may correspond to a third length L3 greater than the first length L1. In the slide-out state, the rollable display 430 may be expanded to have a third display area (e.g., a region including the first portion 430a and the second portion 430b) larger than the first display area.

According to an embodiment, in the first state (e.g., the slide-out state) of the electronic device 400, the screen size (e.g., screen area) of the rollable display 430 that is visible from the outside may be maximum (e.g., substantially maximum).

According to an embodiment, in the second state (e.g., the slide-in state) of the electronic device 400, the screen size (e.g., screen area) of the rollable display 430 that is visible from the outside may be minimum (e.g., substantially minimum).

According to an embodiment, in the third state (e.g., the intermediate state) of the electronic device 400, the screen size (e.g., screen area) of the rollable display 430 that is visible from the outside may be smaller than that in the first state (e.g., the slide-out state) and larger than that in the second state (e.g., the slide-in state). For example, in the third state (e.g., the intermediate state) of the electronic device 400, the screen size (e.g., screen area) of the rollable display 430 that is visible from the outside may be smaller than a maximum size (e.g., a maximum screen area) and larger than a minimum size (e.g., a minimum screen area).

According to an embodiment, the electronic device 400 may include at least one of a sound input device (e.g., a microphone 403-1) disposed in a first space 4101 of the first housing 410, a sound output device (e.g., a receiver 406 for calls or a speaker 407), sensor modules 404 and 417, camera modules (e.g., a first camera module 405 or a second camera module 416), a connector port 408, a key input device 419, or an indicator (not illustrated).

According to an embodiment, the electronic device 400 may include another input device (e.g., a microphone 403) disposed in the second housing 420. In another embodiment, the electronic device 400 may be configured such that at least one of the above-described components may be omitted, or other components may additionally be included. In another embodiment, at least one of the above-described components may be disposed in the second space 4201 of the second housing 420.

According to an embodiment, the sound input device may include the microphone 403-1. In some embodiments, the sound input device (e.g., the microphone 403-1) may include a plurality of microphones arranged to detect a direction of sound. The sound output device may include, for example, a receiver 406 for calls and a speaker 407.

According to an embodiment, the speaker 407 may correspond to the outside through at least one speaker hole formed in the first housing 410 at a position that is always exposed to the outside regardless of whether the device is in the slide-in or slide-out state (e.g., the second side surface 4112).

According to an embodiment, in the slide-out state, the connector port 408 (e.g., a universal serial bus (USB) type-C terminal) may correspond to the outside through a connector-port hole formed in the first housing 410. For example, in the slide-in state, the connector port 408 may correspond to the outside through an opening formed in the second housing 420 to correspond to the connector-port hole. For example, the receiver 406 for calls may include a speaker (e.g., a piezo speaker) that operates without a separate speaker hole.

According to an embodiment, the sensor modules 404 and 417 may generate an electrical signal or a data value corresponding to an operation state inside the electronic device 400 or an environmental state outside the electronic device. According to an embodiment, the sensor modules 404 and 417 may include a first sensor module 404 (e.g., a proximity sensor, an illuminance sensor, an acceleration sensor, or a 6-axis sensor) disposed on a front surface of the electronic device 400, and/or a second sensor module 417 (e.g., a heart rate monitoring (HRM) sensor) disposed on a rear surface of the electronic device 400.

According to an embodiment, the first sensor module 404 may be disposed under (e.g., on a lower side in the z-axis direction) the rollable display 430 on the front surface of the electronic device 400.

According to an embodiment, the first sensor module 404 and/or the second sensor module 417 may include at least one of a proximity sensor, an illuminance sensor, a time-of-flight (TOF) sensor, an ultrasonic sensor, a fingerprint recognition sensor, a gesture sensor, a gyro sensor, a barometric pressure sensor, a magnetic sensor, an acceleration sensor, a grip sensor, a color sensor, an infrared (IR) sensor, a biometric sensor, a temperature sensor, or a humidity sensor.

According to an embodiment, the camera modules may include a first camera module 405 disposed on the front surface of the electronic device 400 and a second camera module 416 disposed on the rear surface of the electronic device 400.

According to an embodiment, the electronic device 400 may further include a flash (not illustrated) located near the second camera module 416.

According to an embodiment, the camera modules 405 and 416 may include one or more lenses, image sensors, and/or an image signal processors.

According to an embodiment, the first camera module 405 may be disposed under (e.g., on a lower side in the z-axis direction) the rollable display 430. The first camera module 405 may be disposed under (e.g., on a lower side in the z-axis direction) the rollable display 430 and may be configured to photograph a subject through at least a portion of an active region (e.g., a display region) of the rollable display 430.

According to an embodiment, among the camera modules, the first camera module 405 may be disposed to detect an external environment through the rollable display 430. Among the sensor modules 404 and 417, at least one sensor module 404 may be disposed to detect an external environment through the rollable display 430. For example, the first camera module 405 or the at least one sensor module 404 may be disposed in the first space 4101 of the first housing 410 to be in contact with the external environment through a transmissive region or a perforated opening formed in the rollable display 430.

According to an embodiment, a region of the rollable display 430 that faces the first camera module 405 is a portion of a content display region and may be formed as a transmissive region having a predetermined transmittance.

According to an embodiment, the transmissive region of the rollable display 430 may be formed to have a transmittance in a range of about 5% to about 20%. The transmissive region may include a region overlapping an effective region (e.g., a field of view region) of the first camera module 405 through which light imaged by an image sensor to generate an image passes. For example, the transmissive region of the rollable display 430 may include a region having a lower pixel density and/or a lower wire density than the surrounding region. For example, the transmissive region may replace the above-mentioned opening. For example, some camera modules 405 may include an under-display camera (UDC). According to an example, the at least one sensor module 404 may be disposed inside an internal space of the electronic device 400 to perform the functions thereof without being visually exposed through the rollable display 430.

According to an embodiment, the electronic device 400 may include a bezel antenna A disposed through the conductive second side surface member 421 of the second housing 420. For example, the bezel antenna A may include a conductive portion 427 disposed in at least a portion of the fifth and sixth side surfaces 4212 and 4213 of the second side surface member 421 and electrically split by one or more split portions 4271 and 4272 made of a non-conductive material (e.g., polymer).

According to an embodiment, a wireless communication circuit (e.g., the wireless communication module 192 of FIG. 1) may be configured to transmit or receive a wireless signal in at least one predetermined frequency band (e.g., about 600 MHz to about 9000 MHz (e.g., a legacy band or an NR band)) through a conductive portion 427.

According to an embodiment, the electronic device 400 may include a side surface cover 4212a disposed on the fifth side surface 4212 to cover at least a portion of at least one segmentation portion 4271. For example, the bezel antenna A may be disposed on at least one of the fourth side surface 4211, the fifth side surface 4212, and the sixth side surface 4213. For example, the bezel antenna A may be disposed on at least one of the first side surface 4111, the second side surface 4112, and the third side surface 4113 of the first housing 410.

According to an embodiment, the electronic device 400 may further include at least one antenna module (e.g., a 5G antenna module or an antenna structure). For example, the at least one antenna module (e.g., a 5G antenna module or an antenna structure) may be disposed in an internal space of the electronic device 400 (e.g., the first space 4101 or the second space 4201). The at least one antenna module (e.g., a 5G antenna module or an antenna structure) may be disposed to transmit or receive a wireless signal in a frequency band ranging from about 3 GHz to about 100 GHz through another wireless communication circuit (e.g., the wireless communication module 192 of FIG. 1).

According to an embodiment, the slide-in/slide-out operation of the electronic device 400 may be performed automatically. For example, the slide-in/slide-out operation of the electronic device 400 may be performed through engagement between a rack gear and a driving motor (e.g., a gear driving unit) including a pinion gear. The rack gear may be disposed in the first space 4101 of the first housing 410. The driving motor (e.g., the gear driving unit) including the pinion gear may be disposed in the second space 4201 of the second housing 420.

For example, when a processor (e.g., the processor 120 of FIG. 1) of the electronic device 400 detects a triggering operation for transitioning from the slide-in state to the slide-out state, the processor may operate the driving motor disposed inside the electronic device 400.

For example, when the processor (e.g., the processor 120 of FIG. 1) of the electronic device 400 detects a triggering operation for transitioning from the slide-out state to the slide-in state, the processor may operate the driving motor disposed inside the electronic device 400.

For example, the triggering operation for a state transition (e.g., a transition to the slide-in state or the slide-out state) of the electronic device 400 may include selecting (e.g., touching) an object displayed on the rollable display 430, or operating a physical button (e.g., a key button) included in the electronic device 400.

According to an embodiment, in the second space 4201 of the second housing 420, the electronic device 400 may have a driving motor disposed at an end portion in the slide-out direction (direction ①) that is closest to the first space 4101 of the first housing 410. The electronic device 400 may have an electrical connection structure to which a first circuit board (e.g., a main board) disposed in the first space 4101 is electrically connected via an electrical connection member.

The electronic device 400 of FIG. 4A may include a touch circuit including a touch sensor and a touch sensor integrated circuit (IC).

The electronic device 400 of FIG. 4A may include an electronic pen (e.g., a stylus pen) and a digitizer.

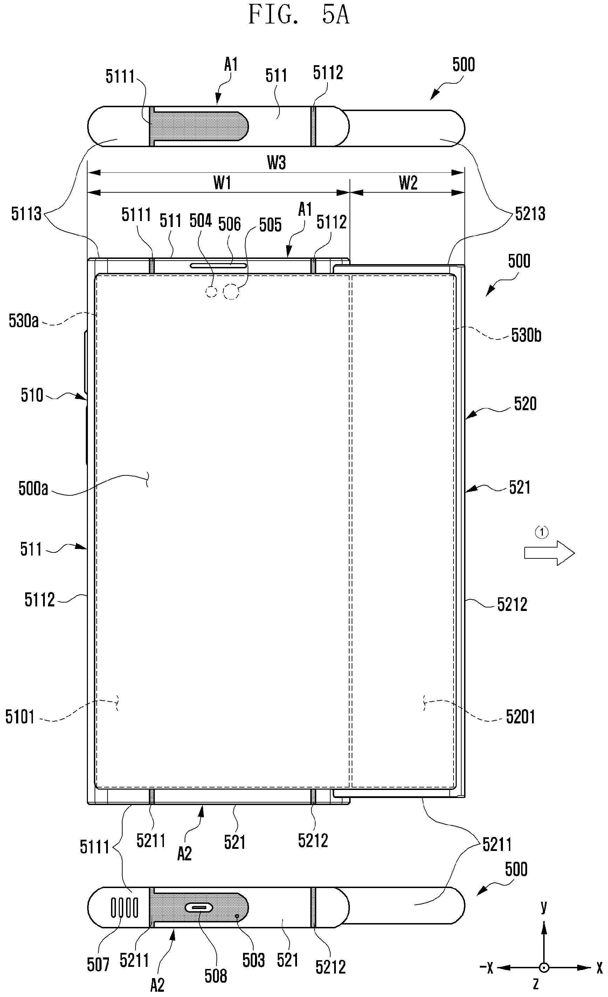

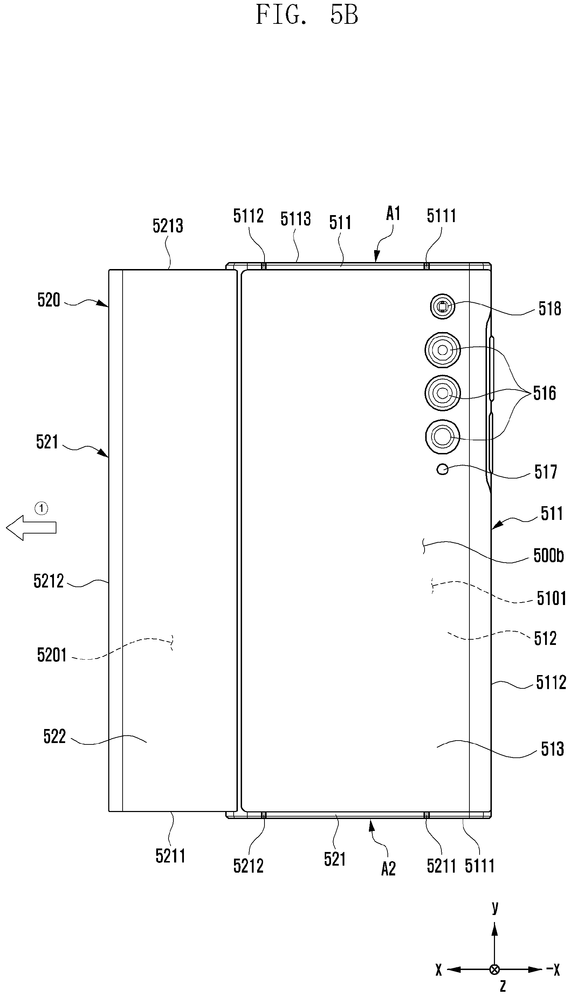

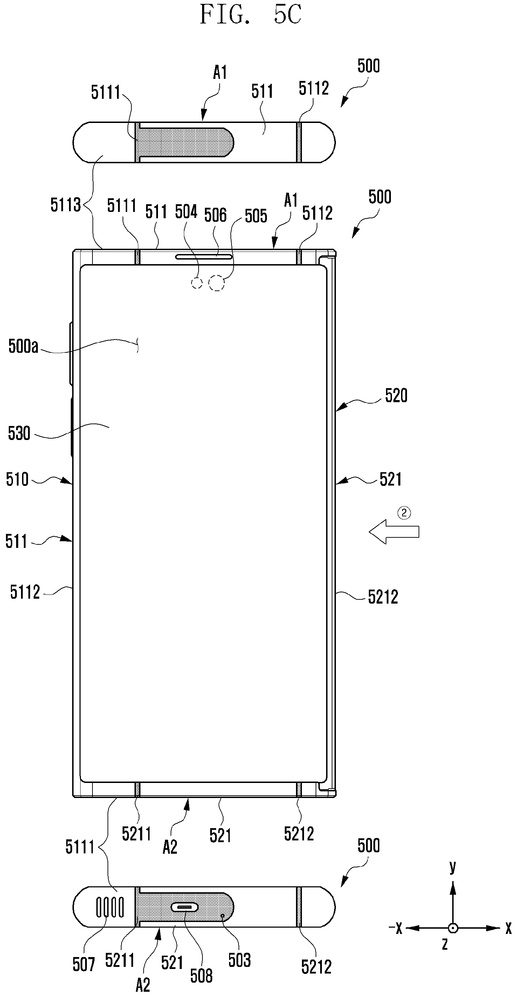

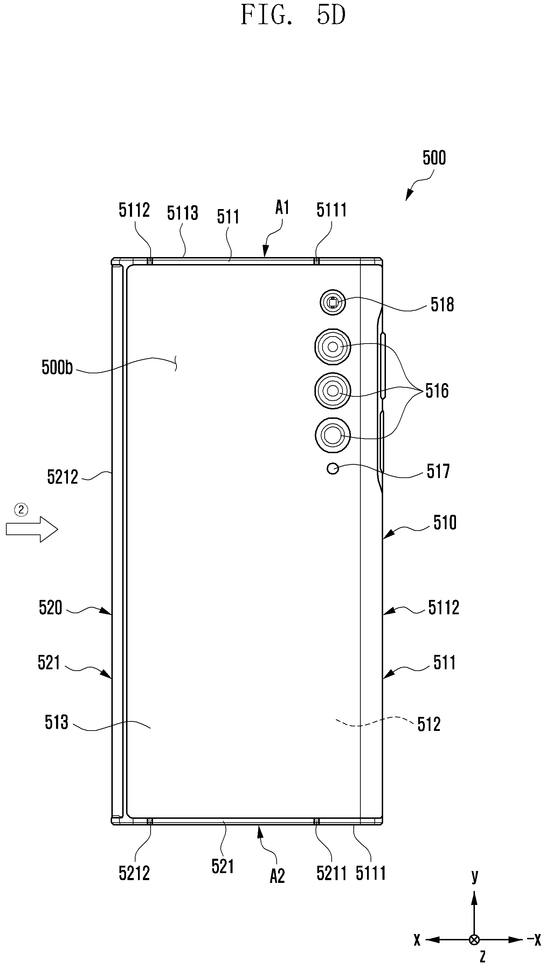

FIGS. 5A and 5B are front and rear views of an electronic device in a first state (e.g., the slide-out state) according to an embodiment of the disclosure. FIGS. 5C and 5D are views illustrating a front surface and a rear surface of an electronic device in a second state (e.g., a slide-in state) according to an embodiment of the present disclosure.

The electronic device 500 of FIGS. 5A to 5D may be at least partially similar to the electronic device 101 of FIG. 1, or may further include other embodiments of the electronic device.

Referring to FIGS. 5A to 5D, the electronic device 500 according to an embodiment of the disclosure may include a first housing 510 (e.g., a first housing structure or a base housing), a second housing 520 (e.g., a second housing structure or a slide housing), and a rollable display 530 (e.g., a flexible display (e.g., an expandable display or a stretchable display)).

According to an embodiment, the rollable display 530 may be disposed to be supported by at least a portion of the first housing 510 and the second housing 520.

According to an embodiment, the first housing 510 and the second housing 520 may be coupled to each other. For example, the second housing 520 may be movably coupled to the first housing 510 within a predetermined distance and in a predetermined direction (e.g., the x-axis direction).

According to an embodiment, in the first state (e.g., the slide-out state), the electronic device 500 may include a bendable member (or a bendable support member (e.g., a multi-joint hinge module or a multiple-bar assembly)) configured to form, at least in part, the same plane as at least a portion of the first housing 510. The bendable member (or bendable support member (e.g., a multi-joint hinge module or a multiple-bar assembly)) may be accommodated, at least in part, in a second space 5201 of the second housing 520 in the second state (e.g., the slide-in state).

According to an embodiment, at least a portion of the second housing 520 may be accommodated in a first space 5101 of the first housing 510 to be transitioned to the second state (e.g., the slide-in state).

According to an embodiment, in the first state (e.g., slide-out state), at least a portion of the rollable display 530 may be disposed to be visible from the outside while being supported by the bendable member forming, at least in part, the same plane as the first housing 510.

According to an embodiment, in the second state (e.g., the slide-in state), at least a portion of the rollable display 530 may be disposed to be invisible from the outside by being accommodated in the internal space 5201 of the second housing 520 while being supported by the bendable member.

According to an embodiment, in the first state (e.g., the slide-out state) of the electronic device 500, the screen size (e.g., screen area) of the rollable display 530 that is visible from the outside may be maximum (e.g., substantially maximum).

According to an embodiment, in the second state (e.g., the slide-in state) of the electronic device 500, the screen size (e.g., screen area) of the rollable display 530 that is visible from the outside may be minimum (e.g., substantially minimum).

According to an embodiment, in the third state (e.g., the intermediate state) of the electronic device 500, the screen size (e.g., screen area) of the rollable display 530 that is visible from the outside may be smaller than that in the first state (e.g., the slide-out state) and larger than that in the second state (e.g., the slide-in state). For example, in the third state (e.g., the intermediate state) of the electronic device 500, the screen size (e.g., screen area) of the rollable display 530 that is visible from the outside may be smaller than a maximum size (e.g., a maximum screen area) and larger than a minimum size (e.g., a minimum screen area).

According to an embodiment, the electronic device 500 may include a front surface 500a (e.g., a first surface or a surface on which a screen is displayed), a rear surface 500b (e.g., a second surface) that is oriented in a direction opposite to the front surface 500a, and a side surface (not illustrated) that surrounds a space between the front surface 500a and the rear surface 500b.

According to an embodiment, the electronic device 500 may include the first housing 510 including a first side surface member 511 and the second housing 520 including a second side surface member 521.

According to an embodiment, the first side surface member 511 may include a first side surface 5111 having a first length along the first direction (e.g., the x-axis direction), a second side surface 5112 extending from the first side surface 5111 in a substantially perpendicular direction (e.g., the y-axis direction) and having a second length greater than the first length, and a third side surface 5113 extending from the second side surface 5112 substantially in parallel with the first side surface 5111 and having the first length.

According to an embodiment, the first side surface member 511 may be formed, at least in part, of a conductive member (e.g., metal). According to an embodiment, at least a portion of the first side surface member 511 may include a first support member 512 extending to at least a portion of the first space 5101 of the first housing 510.

According to an embodiment, the second side surface member 521 may include a fourth side surface 5211 corresponding, at least in part, to the first side surface 5111 and having a third length, a fifth side surface 5212 extending from the fourth side surface 5211 in a direction substantially parallel to the second side surface 5112 and having a fourth length greater than the third length, and a sixth side surface 5213 extending from the fifth side surface 5212 to correspond to the third side surface 5113 and having the third length.

According to an embodiment, the second side surface member 521 may be formed, at least in part, of a conductive material (e.g., a metal). According to an embodiment, at least a portion of the second side surface member 521 may include a second support member 522 extending to at least a portion of the second space 5201 of the second housing 520.

According to an embodiment, the first side surface 5111 and the fourth side surface 5211, and the third side surface 5113 and the sixth side surface 5213 may be slidably coupled to each other. According to an embodiment, in the second state (e.g., the slide-in state), the fourth side surface 5211 may be disposed to be substantially invisible from the outside by being overlapped with the first side surface 5111.

According to an embodiment, in the second state (e.g., the slide-in state), the sixth side surface 5213 may be disposed to be substantially invisible from the outside by being overlapped with the third side surface 5213. According to an embodiment, in the second state (e.g., the slide-in state), at least a portion of the fourth side surface 5211 and the sixth side surface 5213 may be disposed to be at least partially visible from the outside.

According to an embodiment, in the second state (e.g., the slide-in state), the second support member 522 may be disposed to be substantially invisible from the outside by being overlapped with the first support member 512. For example, in the second state (e.g., the slide-in state), a portion of the second support member 522 may be disposed to be invisible from the outside by being overlapped with the first support member 512. The remaining portion of the second support member 522 may be disposed to be visible from the outside.

According to an embodiment, on the rear surface 500b, the electronic device may include a rear surface cover 513 that is disposed on at least a portion of the first housing 510. According to an embodiment, the rear surface cover 513 may be disposed through at least a portion of the first support member 512.

According to an embodiment, the rear surface cover 513 may be integrally formed with the first side surface member 511.

According to an embodiment, the rear surface cover 513 may be formed of polymer, coated or colored glass, ceramic, metal (e.g., aluminum, stainless steel (STS), or magnesium), or a combination of at least two of the foregoing materials. According to an embodiment, the rear surface cover 513 may extend to at least a portion of the first side surface member 511.

According to an embodiment, at least a portion of the first support member 512 may be replaced with the rear surface cover 513. According to an embodiment, the electronic device 500 may further include, in the second housing 520, another rear surface cover (e.g., a second rear surface cover) that is disposed on at least a portion of the second support member 522 or that replaces at least a portion of the second support member 522.

According to an embodiment, the rollable display 530 may include a first portion 530a (e.g., a flat portion) and a second portion 530b (e.g., a bendable portion). For example, the first portion 530a (e.g., a flat portion) may be disposed to be visible from the outside at all times. For example, the second portion 530b (e.g., the bendable portion) may extend from the first portion 530a and may be accommodated, at least in part, in the second space 5201 of the second housing 520 such that the second portion 350b is, at least in part, invisible from the outside in the second state (e.g., the slide-in state).

According to an embodiment, the first portion 530a may be disposed to be supported by the first housing 510.

According to an embodiment, the second portion 530b may be disposed to be supported, at least in part, by the bendable member.

According to an embodiment, the rollable display 530 may be slid out (e.g., expanding the screen) as the second housing 520 moves in a predetermined first direction (direction ①). The rollable display 530 may extend from the first portion 530a while being supported by the bendable member when the second housing 520 is slid out along the predetermined first direction (direction ①). The rollable display 530 may be disposed to form substantially the same plane as the first portion 530a and to be visible from the outside.

According to an embodiment, the rollable display 530 may be slid in (e.g., reducing the screen) as the second housing 520 moves in a predetermined second direction (direction ②). The second portion 530b of the rollable display 530 may be accommodated in the second space 5201 of the second housing 520 and may be disposed to be invisible from the outside when the second housing 520 is slid in along the predetermined second direction (direction ②). Accordingly, as the second housing 520 is moved in a sliding manner in a predetermined direction (e.g., the x-axis direction) from the first housing 510, the electronic device 500 may induce the display area of the rollable display 530 to be variable.

According to an embodiment, the first housing 510 and the second housing 520 may be operated in a sliding manner such that an overall width between the first housing 510 and the second 520 is variable.

According to an embodiment, in the first state (e.g., the slide-out state), the electronic device 500 may be configured such that at least a portion of the bendable member accommodated in the second space 5201 of the second housing 520 is moved to have an additional second width W2, thereby having a third width W3 greater than the first width W1. For example, in the second state (e.g., the slide-in state), the rollable display 530 may have a display area substantially corresponding to the first width W1. In the first state (e.g., the slide-out state), the rollable display 530 may have an expanded display area substantially corresponding to the third width W3.

According to an embodiment, in the second state (e.g., the slide-in state), the electronic device 500 may be configured to have the first width W1 from the second side surface 5112 to the fifth side surface 5212.

According to an embodiment, the slide-in/slide-out operation of the electronic device 500 may be performed automatically. For example, when the electronic device 500 detects a triggering operation for transitioning from the second state (e.g., the slide-in state) to the first state (e.g., the slide-out state) while the driving module is not being operated, the electronic device 500 may operate the driving module disposed inside the electronic device 500. For example, when the electronic device 500 detects a triggering operation for transitioning from the first state (e.g., the slide-out state) to the second state (e.g., the slide-in state) while the driving module is not being operated, the electronic device 500 may operate the driving module disposed inside the electronic device 500.

According to an embodiment, the triggering operation for slide-out/slide-in of the rollable display may include detecting a movement distance corresponding to a push-pull section in which the second housing is moved in the second direction (e.g., direction ②) in which the second housing is to be slid in. For example, the electronic device 500 may operate or stop the driving module through a driving motor control module that is operably connected to a processor (e.g., the processor 120 of FIG. 1) and is configured to control a driving motor of the driving module.

According to an embodiment, the electronic device 500 may include at least one of a sound input device (e.g., a microphone 503) disposed in a first space 5101 of the first housing 510, a sound output device (e.g., a receiver 506 for calls or a speaker 507), sensor modules 504 and 517, camera modules (e.g., a first camera module 505 or a second camera module 516), a connector port 508, a key input device (not illustrated), or an indicator (not illustrated). In an embodiment, the electronic device 500 may be configured such that at least one of the above-described components may be omitted, or other components may additionally be included. In an embodiment, at least one of the above-described components may be disposed in the second space 5201 of the second housing 520.

According to an embodiment, the sound input device may include a microphone 503. In an embodiment, the sound input device (e.g., the microphone 503) may include a plurality of microphones arranged to detect a direction of sound. The sound output device may include, for example, a call receiver 506 and a speaker 507. According to an embodiment, in the first state (e.g., the slide-out state), the speaker 507 may face the outside through at least one speaker hole formed in the first housing 510.

According to an embodiment, in the first state (e.g., the slide-out state), the connector port 508 (e.g., a universal serial bus (USB) type-C terminal) may face the outside through a connector-port hole formed in the first housing 510.

According to an embodiment, the receiver 506 for calls may include a speaker (e.g., a piezo speaker) that operates without a separate speaker hole.

According to an embodiment, the sensor modules 504 and 517 may generate an electrical signal or a data value corresponding to an operation state inside the electronic device 500 or an environmental state outside the electronic device. For example, the sensor modules 504 and 517 may include a first sensor module 504 (e.g., a proximity sensor or an illuminance sensor) disposed on a front surface 500a of the electronic device 500 and/or a second sensor module 517 (e.g., a heart rate monitoring (HRM) sensor) disposed on a rear surface 500b of the electronic device 500.

According to an embodiment, the first sensor module 504 may be disposed below the rollable display 530 (e.g., on a lower side in the z-axis direction) on the front surface 500a of the electronic device 500.

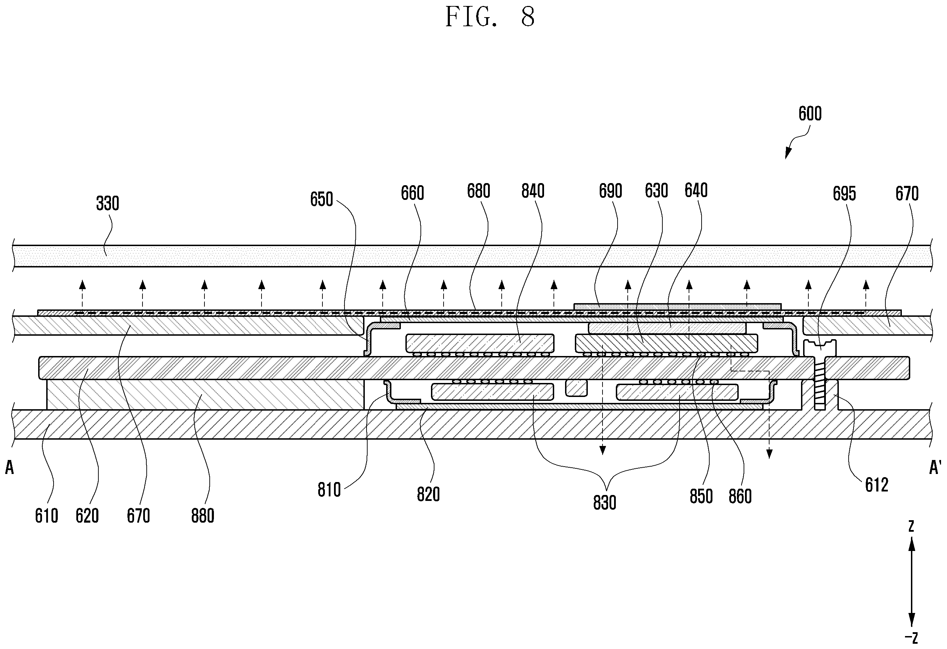

According to an embodiment, a digitizer (e.g., the digitizer 860 of FIG. 8) may be disposed below the rollable display 530 (e.g., on a lower side in the z-axis direction).

According to an embodiment, the first sensor modules 504 and/or the second sensor module 517 may include at least one of a gesture sensor, a gyro sensor, a grip sensor, a color sensor, an infrared (IR) sensor, an illuminance sensor, an ultrasonic sensor, a proximity sensor, a biometric sensor (e.g., an iris recognition sensor), a distance detection sensor (e.g., a time-of-flight (TOF) sensor or a light detection and ranging (LiDAR) sensor), a pressure sensor, a magnetic sensor (e.g., a 6-axis sensor or a geomagnetic sensor), an acceleration sensor, a temperature sensor, a humidity sensor, or a fingerprint recognition sensor.

According to an embodiment, the camera module may include a first camera module 505 disposed on a front surface 500a of the electronic device 500 and a second camera module 516 disposed on a rear surface 500b of the electronic device 500. According to an embodiment, the electronic device 500 may include a flash 518 located near the second camera module 516. According to an embodiment, the camera modules 505 and 516 may include one or more lenses, an image sensor, a memory, and/or an image signal processor.

According to an embodiment, the first camera module 505 may be disposed under the rollable display 530 and may be configured to photograph a subject through at least a portion of an active area of the rollable display 530. According to an embodiment, the flash 518 may include, for example, a light-emitting diode or a xenon lamp.

According to an embodiment, among the camera modules, the first camera module 505, and among the sensor modules 504 and 517, at least one sensor module 504 may be disposed to detect an external environment through the rollable display 530. For example, the first camera module 505 or the at least one sensor module 504 may be disposed in the first space 5201 of the first housing 510 to be in contact with the external environment through a transmissive region or a perforated opening formed in the rollable display 530.

According to an embodiment, a region of the rollable display 530 that faces the first camera module 505 is a portion of a content display region and may be formed as a transmissive region having a predetermined transmittance.

According to an embodiment, the transmissive region of the rollable display 530 may be formed to have a transmittance in a range of about 5% to about 20%. The transmissive region may include a region overlapping an effective region (e.g., a field of view region) of the first camera module 505 through which light imaged by an image sensor to generate an image passes. For example, the transmissive region of the rollable display 530 may include a region having a lower pixel density and/or a lower wire density than the surrounding region. For example, the transmissive region may replace the above-mentioned opening. For example, some camera modules 505 may include an under-display camera (UDC).

According to an embodiment, some of the sensor modules 504 may be disposed in the internal space of the electronic device 500 so as to perform their functions without being visually exposed through the rollable display 530.

According to an embodiment, the electronic device 500 may include one or more antennas A1 and A2 that are electrically connected to a wireless communication circuit (e.g., the wireless communication module 192 of FIG. 1) disposed in a first space 5101 of the first housing 510.

According to an embodiment, the one or more antennas A1 and A2 may include a first antenna A1 disposed in an upper region of the electronic device 500 and a second antenna A2 disposed in a lower region of the electronic device 500.

According to an embodiment, the electronic device 500 may further include at least one additional antenna disposed on the second side surface 5112 of the first housing 510 and/or on the fifth side surface 5212 of the second housing 520.

According to an embodiment, the first antenna A1 may include a first conductive portion 511 that is segmented through one or more non-conductive portions 5111 and 5112 on the third side surface 5113 of the first side surface member 511.

According to an embodiment, the first conductive portion 511 may be disposed to be segmented through a first non-conductive portion 5111 and a second non-conductive portion 5112 spaced apart from each other at a predetermined interval, and may be electrically connected to the wireless communication circuit (e.g., the wireless communication module 192 of FIG. 1).

According to an embodiment, the second antenna A2 may include a second conductive portion 521 that is segmented through one or more non-conductive portions 5211 and 5212 on the first side surface 5111 of the first side surface member 511.

According to an embodiment, the second conductive portion 521 may be disposed to be segmented through a third non-conductive portion 5211 and a fourth non-conductive portion 5212 spaced apart from each other at a predetermined interval, and may be electrically connected to the wireless communication circuit (e.g., the wireless communication module 192 of FIG. 1).

According to an embodiment, the wireless communication circuit (e.g., the wireless communication module 192 of FIG. 1) may be configured to transmit and/or receive wireless signals in a predetermined frequency band (e.g., about 800 MHz to about 6000 MHz (e.g., a legacy band)) through the first conductive portion 511 and/or the second conductive portion 512.

According to an embodiment, the electronic device 500 may further include at least one antenna module (e.g., a 5G antenna module or an antenna structure) disposed in an internal space (e.g., the first space 5101 or the second space 5201). The at least one antenna module (e.g., the 5G antenna module or the antenna structure) may be disposed to transmit and receive wireless signals in a frequency band in a range of about 3 GHz to about 100 GHz through another wireless communication circuit (e.g., the wireless communication module 192 of FIG. 1).

According to exemplary embodiments of the disclosure, the electronic device 500 may include a driving module disposed in an internal space (e.g., the second space 5201) for slide-in/slide-out operations.

According to an embodiment, when the driving module is not driven and the electronic device 500 is in the first state (e.g., the slide-out state), the electronic device 500 may detect a triggering operation in which the second housing 520 is pressed by a push-pull section in the second direction (e.g., direction ②) in which the second housing 520 is to be slid in. When the triggering operation is detected, the second housing 520 may be automatically slid in through the driving module (e.g., a push-and-pull-in operation (e.g., the slide-in operation)).

According to an embodiment, the electronic device 500 may employ a push-pull operation as a triggering operation for driving the driving module. For example, when the driving module is not driven and the electronic device 500 is in the second state (e.g., the slide-in state), the electronic device 500 may detect a triggering operation in which the second housing 500 is pressed by a push-pull section in the second direction (e.g., direction ②) in which the second housing 520 is to be slid in. When the triggering operation is detected, the second housing 520 may be automatically slid out through the driving module (e.g., a push-and-pull-in operation (e.g., the slide-out operation)).

The electronic device 500 of FIG. 5A may include a touch circuit including a touch sensor and a touch sensor integrated circuit (IC).

The electronic device 500 of FIG. 5A may include an electronic pen (e.g., a stylus pen) and a digitizer.

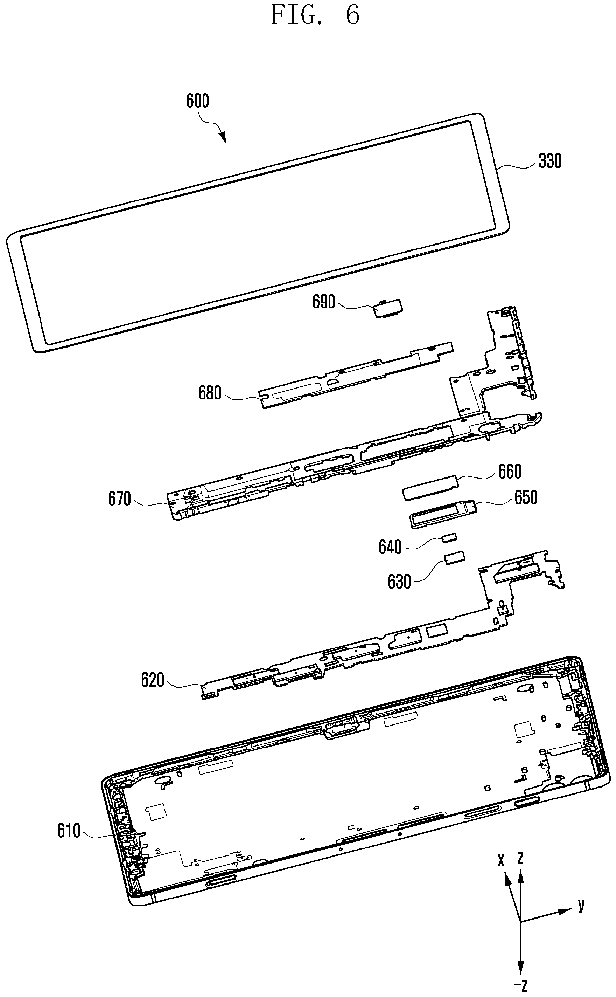

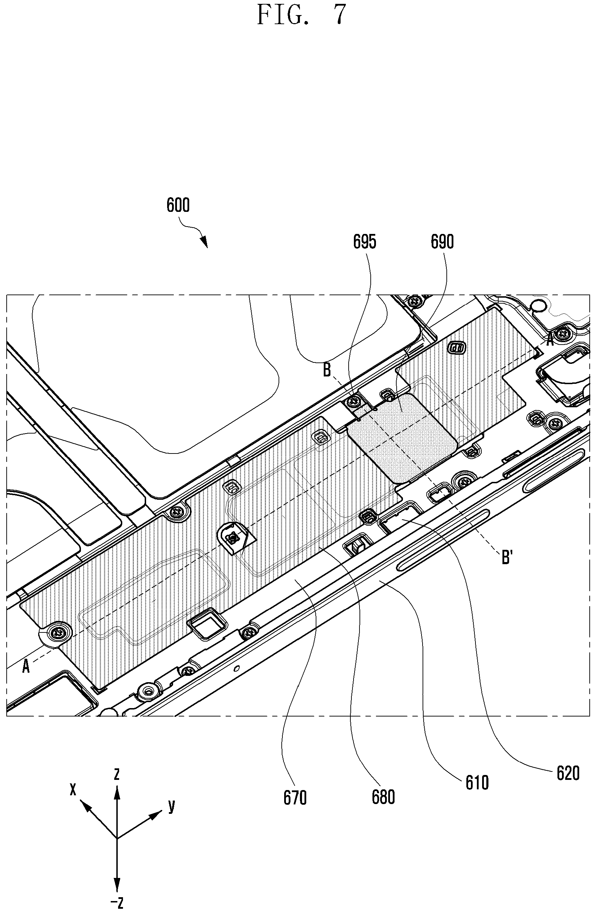

FIG. 6 is an exploded perspective view of an electronic device according to an embodiment of the present disclosure. FIG. 7 illustrates a state in which the electronic device of FIG. 6 is assembled, in which a housing, a bracket, a heat dissipation member, and a cover plate (e.g., a metal plate, a metal sheet, or a cover sheet) are shown.

The electronic device 600 of FIGS. 6 and 7 may be at least partially similar to the electronic device 101 of FIG. 1, or may further include other embodiments of the electronic device. The electronic device 600 of FIGS. 6 and 7 may be at least partially similar to the electronic device 300 of FIG. 3A, or may further include other embodiments of the electronic device.

Referring to FIGS. 6 and 7, the electronic device 600 according to an embodiment of the disclosure may include a housing 610 (e.g., a rear housing), a printed circuit board 620 (e.g., a PCB or a PBA), a processor 630 (e.g., the processor 120 of FIG. 1 or an application processor), a heat transfer member 640 (e.g., a thermal interface material (TIM) or a heat spreading member), a first shield can 650, a first shielding sheet 660 (e.g., a shielding plate), a bracket 670 (e.g., a front bracket), a heat dissipation member 680 (e.g., a heat dissipation plate or a heat dissipation sheet), a cover plate 690 (e.g., a metal plate, a metal sheet, or a cover sheet), and a display 330 (e.g., a flexible display).

According to an embodiment, the electronic device 600 may include a touch circuit including a touch sensor and a touch sensor integrated circuit (IC).

According to an embodiment, the electronic device 600 may include an electronic pen (e.g., a stylus pen) and a digitizer.

According to an embodiment, the electronic device 600 may include an interface. For example, the interface may include, for example, a high-definition multimedia interface (HDMI), a universal serial bus (USB) interface, an SD card interface, and/or an audio interface. For example, the interface may electrically or physically connect the electronic device 300 to an external electronic device, and may include a USB connector, an SD card/MMC connector, or an audio connector.

According to an embodiment, the electronic device 600 may include a battery (e.g., the battery 189 of FIG. 1). The battery 189 may serve as a device that supplies power to at least one component of the electronic device 600, and may include, for example, a non-rechargeable primary cell, a rechargeable secondary cell, or a fuel cell.

According to an embodiment, the electronic device 600 may include an antenna module (e.g., the antenna module 197 of FIG. 1). For example, the antenna module may include an antenna and an antenna driving circuit. For example, the antenna may include an near-field communication (NFC) antenna, a wireless charging antenna, and/or a magnetic secure transmission (MST) antenna. For example, the antenna may perform near-field communication with an external device or may wirelessly transmit and receive power required for charging. For example, an antenna structure may be formed by at least a portion of a side surface bezel structure of the electronic device 600 and/or at least a portion of the housing 610 (e.g., a rear housing).

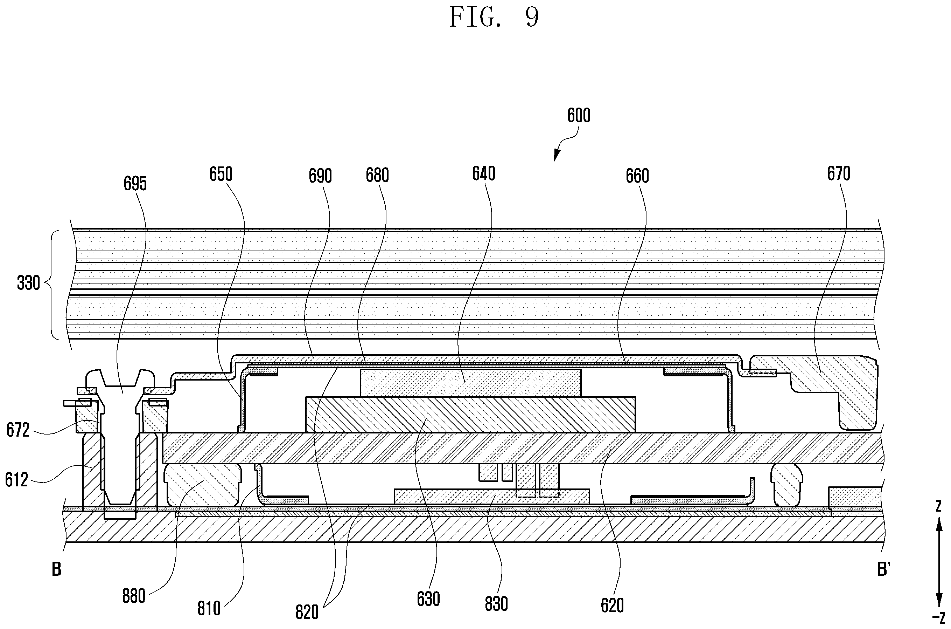

FIG. 8 is a cross-sectional view of the electronic device taken along line A-A' of FIG. 7. FIG. 9 is a cross-sectional view of the electronic device taken along line B-B' of FIG. 7.

According to an embodiment, with reference to FIGS. 6 to 9, the housing 610 (e.g., a rear housing) may include a top surface, a bottom surface opposite to the top surface, and a side surface surrounding the top surface and the bottom surface. A space capable of accommodating the display 330 (e.g., a flexible display) and components may be formed inside the housing 610 (e.g., a rear housing).

According to an embodiment, the bracket 670 (e.g., a front bracket) may be disposed on the top surface of the housing 610 (e.g., a rear housing). For example, the bracket 670 (e.g., a front bracket) may be accommodated in a space formed inside the housing 610 (e.g., a rear housing). For example, the bracket 670 may be disposed between the display 330 and the printed circuit board 620.

According to an embodiment, the printed circuit board 620 (e.g., a PCB or a PBA) may be disposed on the top surface of the housing 610 (e.g., a rear housing). For example, the printed circuit board 620 (e.g., a PCB or a PBA) may be accommodated in a space formed inside the housing 610 (e.g., a rear housing). For example, the printed circuit board 620 (e.g., a PCB or a PBA) may be disposed between the housing 610 and the bracket 670 (e.g., a front bracket). For example, the processor 630 and electronic components may be disposed on the printed circuit board 620 (e.g., a PCB or a PBA). According to an embodiment, the electronic components may include at least one PMIC 830 and a memory 840 (e.g., the memory 130 of FIG. 1). For example, the memory 840 (e.g., the memory 130 of FIG. 1) may include a volatile memory or a non-volatile memory.

According to an embodiment, the processor 630 (e.g., the processor 120 of FIG. 1 or an application processor) and the electronic components may be disposed on one surface or both surfaces of the printed circuit board 620 (e.g., a PCB or a PBA) to face the display 330 (e.g., a flexible display). For example, the processor 630 (e.g., the processor 120 of FIG. 1 or an application processor) and the memory 840 (e.g., the memory 130 of FIG. 1) may be disposed on a first surface (e.g., a top surface) of the printed circuit board 620 (e.g., a PCB or a PBA). For example, the processor 630 (e.g., the processor 120 of FIG. 1 or an application processor) and the memory 840 (e.g., the memory 130 of FIG. 1) may be electrically connected to the printed circuit board 620 (e.g., a PCB or a PBA) by a first connection member 850 (e.g., a solder ball).

For example, the PMIC 830 may be disposed on a second surface (e.g., a bottom surface) of the printed circuit board 620 (e.g., a PCB or a PBA). For example, the PMIC 830 may be electrically connected to the printed circuit board 620 (e.g., a PCB or a PBA) by a second connection member 860 (e.g., a solder ball).

According to an embodiment, a support member 880 (e.g., a support bracket) may be disposed on a top surface of the housing 610 (e.g., a rear housing) and may support the printed circuit board 620 (e.g., a PCB or a PBA). For example, the support member 880 (e.g., a support bracket) may be disposed between the housing 610 (e.g., a rear housing) and the printed circuit board 620 (e.g., a PCB or a PBA) to support the printed circuit board 620 (e.g., a PCB or a PBA).

According to an embodiment, the first shield can 650 may be disposed on the printed circuit board 620 (e.g., a PCB or a PBA) to surround the processor 630 (e.g., the processor 120 of FIG. 1 or an application processor). For example, an opening may be formed in a portion of a top surface of the first shield can 650, such that the first shield can 650 may have an open top.

For example, the first shield can 650 may be located on the first surface (e.g., a top surface) of the printed circuit board 620 (e.g., a PCB or a PBA). For example, the first shield can 650 may be disposed to surround the processor 630 (e.g., the processor 120 of FIG. 1 or an application processor), thereby shielding electromagnetic waves generated from the processor 630 (e.g., the processor 120 of FIG. 1 or an application processor). The first shield can 650 may dissipate heat generated from the processor 630 (e.g., the processor 120 of FIG. 1 or an application processor).

According to an embodiment, the first shielding sheet 660 (e.g., a shielding plate) may be disposed to cover the top surface of the first shield can 650. For example, an upper portion of the first shield can 650 may be shielded by the first shielding sheet 660 (e.g., a shielding plate). For example, the first shielding sheet 660 (e.g., a shielding plate) may have a function of shielding noise generated from the processor 630 (e.g., the processor 120 of FIG. 1 or an application processor) and the memory 840, and may also dissipate heat generated from the processor 630 (e.g., the processor 120 of FIG. 1 or an application processor) and the memory 840. To this end, the first shielding sheet 660 (e.g., a shielding plate) may be formed of a metal material having high thermal conductivity. For example, the first shielding sheet 660 (e.g., a shielding plate) may be formed of a metal material having high thermal conductivity, such as copper (Cu) or aluminum (Al).

According to an embodiment, the heat dissipation member 680 (e.g., a heat dissipation plate or a heat dissipation sheet) may overlap (e.g., overlap in the z-axis direction) at least a portion of the bracket 670 (e.g., a front bracket). For example, the heat dissipation member 680 (e.g., a heat dissipation plate or a heat dissipation sheet) may be disposed above (e.g., on an upper side in the z-axis direction) the bracket 670 (e.g., a front bracket).

According to an embodiment, the heat dissipation member 680 (e.g., a heat dissipation plate or a heat dissipation sheet) may overlap (e.g., overlap in the z-axis direction) at least a portion of the first shield can 650. For example, the heat dissipation member 680 (e.g., a heat dissipation plate or a heat dissipation sheet) may be disposed above (e.g., on an upper side in the z-axis direction) the first shield can 650.

According to an embodiment, the cover plate 690 (e.g., a metal plate, a metal sheet, or a cover sheet) may be disposed on a region of the heat dissipation member 680 (e.g., a heat dissipation plate or a heat dissipation sheet). The cover plate 690 (e.g., a metal plate, a metal sheet, or a cover sheet) may be disposed to fix the heat dissipation member 680 (e.g., a heat dissipation plate or a heat dissipation sheet) to the first shield can 650.

The cover plate 690 (e.g., a metal plate, a metal sheet, or a cover sheet) may press the heat dissipation member 680 (e.g., a heat dissipation plate or a heat dissipation sheet) in a downward direction (e.g., the -z-axis direction) when viewing a screen of the display 330 (e.g., a flexible display), so that the heat dissipation member 680 (e.g., a heat dissipation plate or a heat dissipation sheet) may be fixed to the first shield can 650.

According to an embodiment, the heat transfer member 640 (e.g., a TIM or a heat spreading member) may be disposed on a top surface of the processor 630 (e.g., the processor 120 of FIG. 1 or an application processor).

According to an embodiment, the heat transfer member 640 (e.g., a TIM or a heat spreading member) may be disposed between the processor 630 (e.g., the processor 120 of FIG. 1 or an application processor) and a first shielding sheet 660 (e.g., a shielding plate). For example, the heat transfer member 640 (e.g., a TIM or a heat spreading member) may include a liquid TIM or a solid TIM. The heat transfer member 640 (e.g., a TIM or a heat spreading member) may be a liquid or solid thermal conductive medium, and may increase a thermal contact area between the processor 630 (e.g., the processor 120 of FIG. 1 or an application processor) and the shielding sheet 660 (e.g., a shielding plate).

According to an embodiment, a heat dissipation member 680 (e.g., a heat dissipation plate, or a heat dissipation sheet) may overlap (e.g., overlap in the z-axis direction) the display 330 (e.g., a flexible display). For example, the heat dissipation member 680 (e.g., a heat dissipation plate or a heat dissipation sheet) may be disposed below (e.g., on a lower side in the z-axis direction) the display 330 (e.g., a flexible display).

According to an embodiment, the heat dissipation member 680 (e.g., a heat dissipation plate or a heat dissipation sheet) may be disposed between the bracket 670 (e.g., a front bracket) and the display 330 (e.g., a flexible display).

According to an embodiment, the heat dissipation member 680 (e.g., a heat dissipation plate or a heat dissipation sheet) may be disposed between the first shield can 650 and the display 330 (e.g., a flexible display).

According to an embodiment, the heat dissipation member 680 (e.g., a heat dissipation plate or a heat dissipation sheet) may be disposed to overlap the entire cover plate 690 (e.g., a metal plate, a metal sheet, or a cover sheet).

According to an embodiment, the heat dissipation member 680 (e.g., a heat dissipation plate or a heat dissipation sheet) may be disposed to overlap at least a portion of the bracket 670 (e.g., a front bracket).

For example, the heat dissipation member 680 (e.g., a heat dissipation plate or a heat dissipation sheet) may rapidly spread heat transferred from a processor 630 (e.g., the processor 120 of FIG. 1 or an application processor) and may transfer the heat to air. The heat dissipation member 680 (e.g., a heat dissipation plate or a heat dissipation sheet) may be formed of a graphite sheet or a copper (Cu) sheet.

According to an embodiment, the display 330 (e.g., a flexible display) may be disposed on the top surface of the housing 610 (e.g., a rear housing). For example, the display 330 (e.g., a flexible display) may be accommodated in a space formed inside the housing 610 (e.g., a rear housing).

For example, the display 330 (e.g., a flexible display) may be disposed with a predetermined gap from a heat dissipation member 680 (e.g., a heat dissipation plate or a heat dissipation sheet) in the z-axis direction.

For example, a heat dissipation path may be formed through the gap between the heat dissipation member 680 (e.g., a heat dissipation plate or a heat dissipation sheet) and the display 330 (e.g., a flexible display).

According to an embodiment, the electronic device 600 may include a second shield can 810 and a second shielding sheet 820 (e.g., a shielding plate).

According to an embodiment, the second shield can 810 may be disposed on the printed circuit board 620 (e.g., a PCB or a PBA) to surround electronic components. For example, the electronic components may include one or more PMICs 830.

For example, the second shield can 810 may be located on the second surface (e.g., a bottom surface) of the printed circuit board 620 (e.g., a PCB or a PBA). For example, the second shield can 810 may be disposed to surround the one or more PMICs 830 so as to shield electromagnetic waves generated from the one or more PMICs 830. The second shield can 810 may dissipate heat generated from the one or more PMICs 830.

For example, the second shielding sheet 820 (e.g., a shielding plate) may have a function of shielding noise generated from the one or more PMICs 830, and at the same time, may dissipate heat generated from the one or more PMICs 830. To this end, the second shielding sheet 820 (e.g., a shielding plate) may be formed of a metal material having high thermal conductivity.

For example, an opening may be formed in a portion of a top surface of the second shield can 810, such that an upper portion of the second shield can 810 may open. In FIG. 8, the first shield can 650 is disposed on the first surface (e.g., the top surface) of the printed circuit board 620 (e.g., a PCB or a PBA), and the second shield can 810 is disposed on the second surface (e.g., the bottom surface) of the printed circuit board 620 (e.g., a PCB or a PBA). Accordingly, the opening of the top surface of the first shield can 650 and the opening of the top surface of the second shield can 810 may be formed in directions opposite to each other.

According to an embodiment, the second shielding sheet 820 (e.g., a shielding plate) may be disposed to cover a top surface of the second shield can 810 (which corresponds to a lower side in FIGS. 8 and 9). For example, an upper portion of the second shield can 810 (which corresponds to a lower portion in FIGS. 8 and 9) may be shielded by the second shielding sheet 820 (e.g., a shielding plate).

According to an embodiment, the cover plate 690 (e.g., a metal plate, a metal sheet, or a cover sheet) may be disposed on the heat dissipation member 680 (e.g., a heat dissipation plate or a heat dissipation sheet) at a portion corresponding to the first shield can 650.

For example, the cover plate 690 (e.g., a metal plate, a metal sheet, or a cover sheet) may be disposed to overlap a portion of the first shield can 650.

For example, the cover plate 690 (e.g., a metal plate, a metal sheet, or a cover sheet) may be disposed to overlap the entire first shield can 650.

For example, the cover plate 690 (e.g., a metal plate, a metal sheet, or a cover sheet) may be disposed to overlap a part or an entirety of the processor 630 (e.g., the processor 120 of FIG. 1 or an application processor), with the heat transfer member 640 (e.g., a TIM or a heat spreading member), the first shielding sheet 660 (e.g., a shielding plate), and the heat dissipation member 680 (e.g., a heat dissipation plate or a heat dissipation sheet) interposed therebetween.

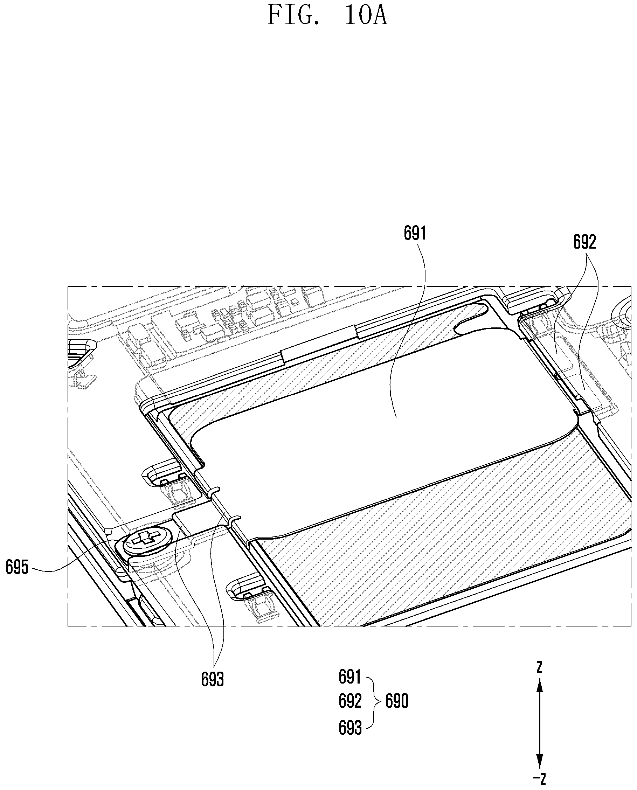

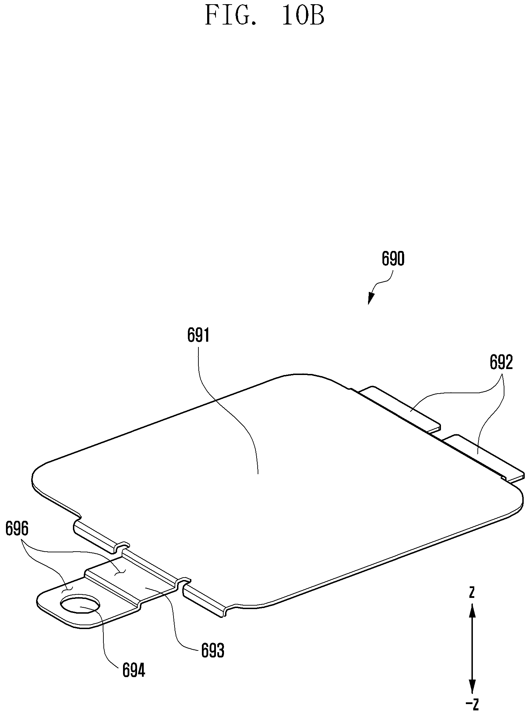

FIGS. 10A and 10B are views illustrating a fixing structure of a cover plate (e.g., a metal plate, a metal sheet, or a cover sheet) according to an embodiment of the disclosure.

Referring to FIGS. 8, 9, 10A, and 10B, the cover plate 690 (e.g., a metal plate, a metal sheet, or a cover sheet) may include a cover portion 691, a first fixing portion 692, and a second fixing portion 693.

According to an embodiment, the cover portion 691 of the cover plate 690 (e.g., a metal plate, a metal sheet, or a cover sheet) may correspond to the top surface of the first shield can 650 and may be formed to cover the top surface of the first shield can 650.

According to an embodiment, the first fixing portion 692 of the cover plate 690 (e.g., a metal plate, a metal sheet, or a cover sheet) may protrude (e.g., protrude in a horizontal direction) from a first side of the cover plate 690 (e.g., a metal plate, a metal sheet, or a cover sheet). For example, the first fixing portion 692 may be bent such that its top surface is positioned lower than the top surface of the cover portion 691.

For example, the first fixing portion 692 may be disposed under one side of the bracket 670 (e.g., a front bracket). For example, a groove may be formed in the first fixing portion 692, and a protrusion may be formed on a lower portion of one side of the bracket 670 (e.g., a front bracket). The first fixing portion 692 may be fixed to the bracket 670 (e.g., a front bracket) by a coupling structure between the groove formed in the first fixing portion 692 and the protrusion formed on the bracket 670 (e.g., a front bracket). The bracket 670 (e.g., a front bracket) may press the first fixing portion 692 in a downward direction (e.g., the -z-axis direction), so that the heat dissipation member 680 (e.g., a heat dissipation plate or a heat dissipation sheet) is brought into close contact with the first shielding sheet 660 (e.g., a shielding plate).

According to an embodiment, the second fixing portion 693 of the cover plate 690 (e.g., a metal plate, a metal sheet, or a cover sheet) may protrude (e.g., protrude in a horizontal direction) from a second side of the cover plate 690 (e.g., a metal plate, a metal sheet, or a cover sheet). For example, the second fixing portion 693 may be bent (696) (e.g., double bending) such that its top surface is positioned lower than the top surface of the cover portion 691.

According to an embodiment, the second fixing portion 693 may be fixed to the housing 610 (e.g., a rear housing) by a screw 695. For example, the second fixing portion 693 may include a screw hole 694. The screw 695 may be inserted into the screw hole 694 formed in the second fixing portion 693. For example, the bracket 670 (e.g., a front bracket) may include a bracket hole 672 into which the screw 695 is insertable. For example, the housing 610 (e.g., a rear housing) may include a screw groove 612 formed at a portion corresponding to the screw hole 694 and the bracket hole 672. For example, the screw 695 may pass through the screw hole 694 and the bracket hole 672 and may be inserted into the screw groove 612. By a coupling structure between the second fixing portion 693 and the housing 610 (e.g., a rear housing) using the screw 695, the second fixing portion 693 may be fixed to the housing 610 (e.g., a rear housing). By this fixing structure, the second fixing portion 693 may be pressed in a downward direction (e.g., the -z-axis direction) such that the heat dissipation member 680 (e.g., a heat dissipation plate or a heat dissipation sheet) is brought into close contact with the first shielding sheet 660 (e.g., a shielding plate).

The electronic device 600 according to an embodiment of the disclosure, described with reference to FIGS. 6 to 10B, may spread heat generated from the processor 630 (e.g., the processor 120 of FIG. 1 or an application processor) over a wide area through the heat dissipation member 680 (e.g., a heat dissipation plate or a heat dissipation sheet) and the cover plate 690 (e.g., a metal plate, a metal sheet, or a cover sheet), thereby improving heat dissipation efficiency.

The electronic device 600 according to an embodiment of the disclosure, described with reference to FIGS. 6 to 10B, may bring the heat dissipation member 680 (e.g., a heat dissipation plate or a heat dissipation sheet) into close contact with the shielding sheet 660 (e.g., a shielding plate) through the cover plate 690 (e.g., a metal plate, a metal sheet, or a cover sheet), thereby forming a gap between the display 330 (e.g., a flexible display) and the heat dissipation member 680 (e.g., a heat dissipation plate or a heat dissipation sheet). Heat dissipation efficiency may be improved by dispersing heat through the heat dissipation member 680 (e.g., a heat dissipation plate or a heat dissipation sheet), the shielding sheet 660 (e.g., a shielding plate), and the cover plate 690 (e.g., a metal plate, a metal sheet, or a cover sheet).

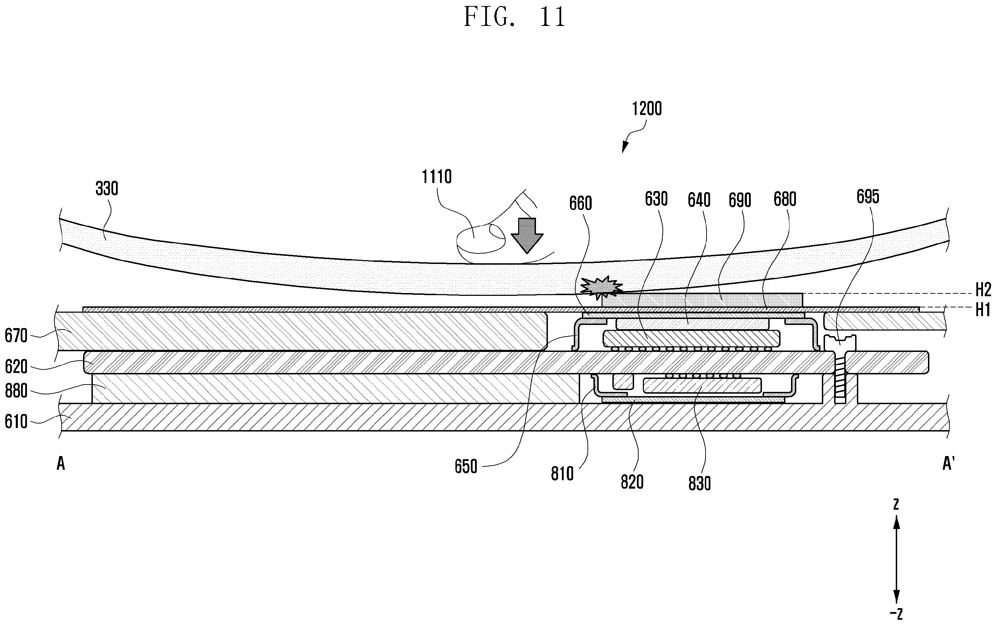

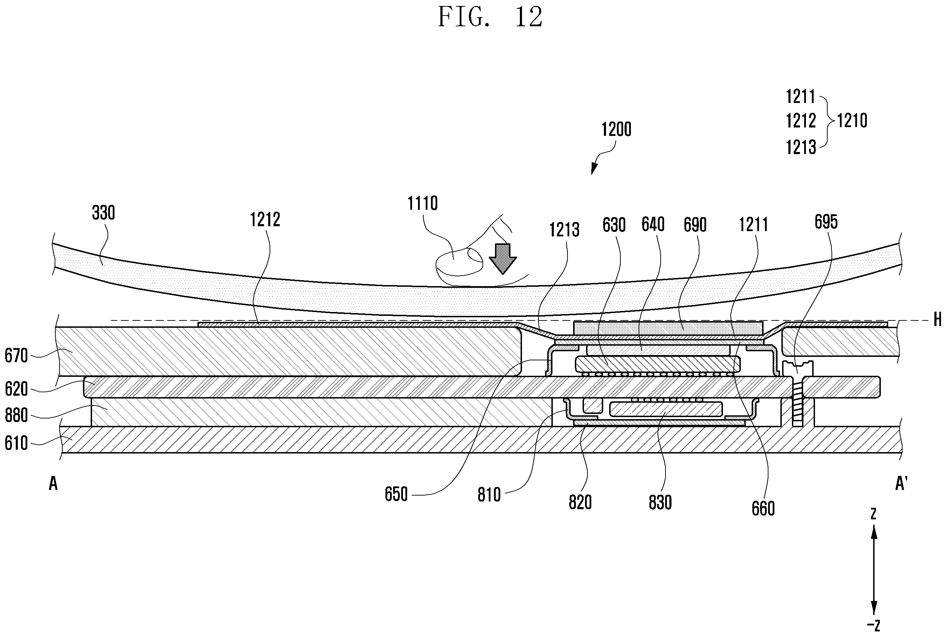

FIGS. 11 and 12 are cross-sectional views of an electronic device according to an embodiment of the disclosure.

The electronic device 1200 of FIGS. 11 and 12 may be at least partially similar to the electronic device 101 of FIG. 1, or may further include other embodiments of the electronic device. The electronic device 1200 of FIGS. 11 and 12 may be at least partially similar to the electronic device 300 of FIG. 3A, or may further include other embodiments of the electronic device. The electronic device 1200 of FIGS. 11 and 12 may be at least partially similar to the electronic device 600 of FIGS. 6 to 9, or may further include other embodiments of the electronic device.

In describing the electronic device 1200 of FIGS. 11 and 12, detailed descriptions of components that are the same as or similar to those of the electronic device 600 of FIGS. 6 to 9 may be omitted.

Referring to FIGS. 11 and 12, the electronic device 1200 according to an embodiment of the disclosure may include a housing 610 (e.g., a rear housing), a printed circuit board 620 (e.g., a PCB or a PBA), a processor 630 (e.g., the processor 120 of FIG. 1 or an application processor), a heat transfer member 640 (e.g., a thermal interface material (TIM) or a heat spreading member), a first shield can 650, a first shielding sheet 660 (e.g., a shielding plate), a bracket 670 (e.g., a front bracket), a heat dissipation member 1210 (e.g., a heat dissipation plate, a heat dissipation sheet, or the heat dissipation member 680 of FIGS. 6 to 9), a cover plate 690 (e.g., a metal plate, a metal sheet, or a cover sheet), and a display 330 (e.g., a flexible display).

According to an embodiment, the electronic device 1200 may include a touch circuit including a touch sensor and a touch sensor integrated circuit (IC).

According to an embodiment, the electronic device 1200 may include an electronic pen (e.g., a stylus pen) and a digitizer.

According to an embodiment, the electronic device 1200 may include an interface. For example, the interface may include, for example, a high-definition multimedia interface (HDMI), a universal serial bus (USB) interface, an SD card interface, and/or an audio interface. For example, the interface may electrically or physically connect the electronic device 1200 to an external electronic device, and may include a USB connector, an SD card/MMC connector, or an audio connector.

According to an embodiment, the electronic device 1200 may include a battery (e.g., the battery 189 of FIG. 1). The battery 189 may serve as a device that supplies power to at least one component of the electronic device 1200, and may include, for example, a non-rechargeable primary cell, a rechargeable secondary cell, or a fuel cell.

According to an embodiment, the electronic device 1200 may include an antenna module (e.g., the antenna module 197 of FIG. 1). For example, the antenna module may include an antenna and an antenna driving circuit. For example, the antenna may include an near-field communication (NFC) antenna, a wireless charging antenna, and/or a magnetic secure transmission (MST) antenna. For example, the antenna may perform near-field communication with an external device or may wirelessly transmit and receive power required for charging. For example, an antenna structure may be formed by at least a portion of a side surface bezel structure of the electronic device 1200 and/or at least a portion of the housing 610 (e.g., a rear housing).

According to an embodiment, the printed circuit board 620 (e.g., a PCB or a PBA) may be disposed on the top surface of the housing 610 (e.g., a rear housing). For example, the printed circuit board 620 (e.g., a PCB or a PBA) may be accommodated in a space formed inside the housing 610 (e.g., a rear housing). For example, the printed circuit board 620 (e.g., a PCB or a PBA) may be disposed between the housing 610 and the bracket 670 (e.g., a front bracket). For example, the processor 630 and electronic components may be disposed on the printed circuit board 620 (e.g., a PCB or a PBA). The electronic components may include at least one PMIC 830 and a memory 840 (e.g., the memory 130 of FIG. 1). For example, the memory 840 (e.g., the memory 130 of FIG. 1) may include a volatile memory or a non-volatile memory.

According to an embodiment, the processor 630 (e.g., the processor 120 of FIG. 1 or an application processor) and the electronic components may be disposed on one surface or both surfaces of the printed circuit board 620 (e.g., a PCB, a PBA) to face the display 330 (e.g., a flexible display). For example, the processor 630 (e.g., the processor 120 of FIG. 1 or an application processor) and the memory 840 (e.g., the memory 130 of FIG. 1) may be disposed on a first surface (e.g., a top surface) of the printed circuit board 620 (e.g., a PCB or a PBA).

For example, the PMIC 830 may be disposed on a second surface (e.g., a bottom surface) of the printed circuit board 620 (e.g., a PCB or a PBA).

According to an embodiment, a support member 880 (e.g., a support bracket) may be disposed on a top surface of the housing 610 (e.g., a rear housing) and may support the printed circuit board 620 (e.g., a PCB or a PBA).

According to an embodiment, the first shield can 650 may be disposed on the printed circuit board 620 (e.g., a PCB or a PBA) to surround the processor 630 (e.g., the processor 120 of FIG. 1 or an application processor). For example, an opening may be formed in a portion of a top surface of the first shield can 650, such that the first shield can 650 may have an open top.

For example, the first shield can 650 may be located on the first surface (e.g., a top surface) of the printed circuit board 620 (e.g., a PCB or a PBA). For example, the first shield can 650 may be disposed to surround the processor 630 (e.g., the processor 120 of FIG. 1 or an application processor), thereby shielding electromagnetic waves generated from the processor 630 (e.g., the processor 120 of FIG. 1 or an application processor). The first shield can 650 may dissipate heat generated from the processor 630 (e.g., the processor 120 of FIG. 1 or an application processor).

According to an embodiment, the first shielding sheet 660 (e.g., a shielding plate) may be disposed to cover the top surface of the first shield can 650. For example, an upper portion of the first shield can 650 may be shielded by the first shielding sheet 660 (e.g., a shielding plate). For example, the first shielding sheet 660 (e.g., a shielding plate) may have a function of shielding noise generated from the processor 630 (e.g., the processor 120 of FIG. 1 or an application processor), and may also dissipate heat generated from the processor 630 (e.g., the processor 120 of FIG. 1 or an application processor). To this end, the first shielding sheet 660 (e.g., a shielding plate) may be formed of a metal material (e.g., copper (Cu)) having high thermal conductivity.

According to an embodiment, the heat dissipation member 1210 (e.g., a heat dissipation plate or a heat dissipation sheet) may overlap (e.g., overlap in the z-axis direction) at least a portion of the bracket 670 (e.g., a front bracket). For example, the heat dissipation member 1210 (e.g., a heat dissipation plate or a heat dissipation sheet) may be disposed above (e.g., on an upper side in the z-axis direction) the bracket 670 (e.g., a front bracket).

According to an embodiment, the heat dissipation member 1210 (e.g., a heat dissipation plate or a heat dissipation sheet) may overlap (e.g., overlap in the z-axis direction) at least a portion of the first shield can 650. For example, the heat dissipation member 1210 (e.g., a heat dissipation plate or a heat dissipation sheet) may be disposed above (e.g., on an upper side in the z-axis direction) the first shield can 650.

According to an embodiment, the cover plate 690 (e.g., a metal plate, a metal sheet, or a cover sheet) may be disposed on a region of the heat dissipation member 1210 (e.g., a heat dissipation plate or a heat dissipation sheet). The cover plate 690 (e.g., a metal plate, a metal sheet, or a cover sheet) may be disposed to fix the heat dissipation member 1210 (e.g., a heat dissipation plate or a heat dissipation sheet) to the first shield can 650.

According to an embodiment, the cover plate 690 (e.g., a metal plate, a metal sheet, or a cover sheet) may press the heat dissipation member 1210 (e.g., a heat dissipation plate or a heat dissipation sheet) in a downward direction (e.g., the -z-axis direction) when viewing a screen of the display 330 (e.g., a flexible display), so that the heat dissipation member 1210 (e.g., a heat dissipation plate or a heat dissipation sheet) may be fixed to the first shield can 650.

According to an embodiment, the heat transfer member 640 (e.g., a TIM or a heat spreading member) may be disposed on a top surface of the processor 630 (e.g., the processor 120 of FIG. 1 or an application processor).

According to an embodiment, the heat transfer member 640 (e.g., a TIM or a heat spreading member) may be disposed between the processor 630 (e.g., the processor 120 of FIG. 1 or an application processor) and a first shielding sheet 660 (e.g., a shielding plate).

According to an embodiment, a heat dissipation member 1210 (e.g., a heat dissipation plate or a heat dissipation sheet) may overlap (e.g., overlap in the z-axis direction) the display 330 (e.g., a flexible display). For example, the heat dissipation member 1210 (e.g., a heat dissipation plate or a heat dissipation sheet) may be disposed below (e.g., on a lower side in the z-axis direction) the display 330 (e.g., a flexible display).

According to an embodiment, the heat dissipation member 1210 (e.g., a heat dissipation plate or a heat dissipation sheet) may be disposed between the bracket 670 (e.g., a front bracket) and the display 330 (e.g., a flexible display).

According to an embodiment, the heat dissipation member 1210 (e.g., a heat dissipation plate or a heat dissipation sheet) may be disposed between the first shield can 650 and the display 330 (e.g., a flexible display).

According to an embodiment, the heat dissipation member 1210 (e.g., a heat dissipation plate or a heat dissipation sheet) may be disposed to overlap the entire cover plate 690 (e.g., a metal plate, a metal sheet, or a cover sheet).

According to an embodiment, the heat dissipation member 1210 (e.g., a heat dissipation plate or a heat dissipation sheet) may be disposed to overlap at least a portion of the bracket 670 (e.g., a front bracket).

For example, the heat dissipation member 1210 (e.g., a heat dissipation plate or a heat dissipation sheet) may rapidly spread heat transferred from a processor 630 (e.g., the processor 120 of FIG. 1 or an application processor) and may transfer the heat to air. The heat dissipation member 1210 (e.g., a heat dissipation plate or a heat dissipation sheet) may be formed of a graphite sheet or a copper (Cu) sheet.

According to an embodiment, the display 330 (e.g., a flexible display) may be disposed on the top surface of the housing 610 (e.g., a rear housing). For example, the display 330 (e.g., a flexible display) may be accommodated in a space formed inside the housing 610 (e.g., a rear housing).

For example, the display 330 (e.g., a flexible display) may be disposed with a predetermined gap from a heat dissipation member 1210 (e.g., a heat dissipation plate or a heat dissipation sheet) in the z-axis direction.

For example, a heat dissipation path may be formed through the gap between the heat dissipation member 1210 (e.g., a heat dissipation plate or a heat dissipation sheet) and the display 330 (e.g., a flexible display).

According to an embodiment, the electronic device 1200 may include a second shield can 810 and a second shielding sheet 820 (e.g., a shielding plate).

According to an embodiment, the second shield can 810 may be disposed on the printed circuit board 620 (e.g., a PCB or a PBA) to surround electronic components. For example, the electronic components may include one or more PMICs 830.

For example, the second shield can 810 may be located on the second surface (e.g., a bottom surface) of the printed circuit board 620 (e.g., a PCB or a PBA). For example, the second shield can 810 may be disposed to surround the one or more PMICs 830 so as to shield electromagnetic waves generated from the one or more PMICs 830. The second shield can 810 may dissipate heat generated from the one or more PMICs 830.

For example, the second shielding sheet 820 (e.g., a shielding plate) may have a function of shielding noise generated from the one or more PMICs 830, and at the same time, may dissipate heat generated from the one or more PMICs 830. To this end, the second shielding sheet 820 (e.g., a shielding plate) may be formed of a metal material having high thermal conductivity.

For example, an opening may be formed in a portion of a top surface of the second shield can 810, such that an upper portion of the second shield can 810 may open. In FIGS. 11 and 12, the first shield can 650 is disposed on the first surface (e.g., the top surface) of the printed circuit board 620 (e.g., a PCB or a PBA), and the second shield can 810 is disposed on the second surface (e.g., the bottom surface) of the printed circuit board 620 (e.g., a PCB or a PBA). Accordingly, the opening of the top surface of the first shield can 650 and the opening of the top surface of the second shield can 810 may be formed in directions opposite to each other.

According to an embodiment, the second shielding sheet 820 (e.g., a shielding plate) may be disposed to cover a top surface of the second shield can 810 (which corresponds to a lower side in FIGS. 11 and 12). For example, an upper portion of the second shield can 810 (which corresponds to a lower portion in FIGS. 11 and 12) may be shielded by the second shielding sheet 820 (e.g., a shielding plate).

According to an embodiment, the cover plate 690 (e.g., a metal plate, a metal sheet, or a cover sheet) may be disposed on the heat dissipation member 1210 (e.g., a heat dissipation plate or a heat dissipation sheet) at a portion corresponding to the first shield can 650.

For example, the cover plate 690 (e.g., a metal plate, a metal sheet, or a cover sheet) may be disposed to overlap a portion of the first shield can 650.

For example, the cover plate 690 (e.g., a metal plate, a metal sheet, or a cover sheet) may be disposed to overlap the entire first shield can 650.

For example, the cover plate 690 (e.g., a metal plate, a metal sheet, or a cover sheet) may be disposed to overlap a part or an entirety of the processor 630 (e.g., the processor 120 of FIG. 1 or an application processor), with the heat transfer member 640 (e.g., a TIM or a heat spreading member), the first shielding sheet 660 (e.g., a shielding plate), and the heat dissipation member 1210 (e.g., a heat dissipation plate or a heat dissipation sheet) interposed therebetween.

Referring to FIGS. 10A and 10B, the cover plate 690 (e.g., a metal plate, a metal sheet, or a cover sheet) may include a cover portion 691, a first fixing portion 692, and a second fixing portion 693.

According to an embodiment, the cover portion 691 of the cover plate 690 (e.g., a metal plate, a metal sheet, or a cover sheet) may correspond to the top surface of the first shield can 650 and may be formed to cover the top surface of the first shield can 650 (e.g., to overlap the top surface of the first shield can 650).

According to an embodiment, the first fixing portion 692 of the cover plate 690 (e.g., a metal plate, a metal sheet, or a cover sheet) may protrude (e.g., protrude in a horizontal direction) from a first side of the cover plate 690 (e.g., a metal plate, a metal sheet, or a cover sheet). For example, the first fixing portion 692 may be bent such that its top surface is positioned lower than the top surface of the cover portion 691.

For example, the first fixing portion 692 may be disposed under one side of the bracket 670 (e.g., a front bracket). For example, a groove may be formed in the first fixing portion 692, and a protrusion may be formed on a lower portion of one side of the bracket 670 (e.g., a front bracket). The first fixing portion 692 may be fixed to the bracket 670 (e.g., a front bracket) by a coupling structure between the groove formed in the first fixing portion 692 and the protrusion formed on the bracket 670 (e.g., a front bracket). The bracket 670 (e.g., a front bracket) may press the first fixing portion 692 in a downward direction (e.g., the -z-axis direction), so that the heat dissipation member 1210 (e.g., a heat dissipation plate or a heat dissipation sheet) is brought into close contact with the first shielding sheet 660 (e.g., a shielding plate).

According to an embodiment, the second fixing portion 693 of the cover plate 690 (e.g., a metal plate, a metal sheet, or a cover sheet) may protrude (e.g., protrude in a horizontal direction) from a second side of the cover plate 690a (e.g., a metal plate, a metal sheet, or a cover sheet). For example, the second fixing portion 693 may be bent (696) (e.g., double bending) such that its top surface is positioned lower than the top surface of the cover portion 691.

According to an embodiment, the second fixing portion 693 may be fixed to the housing 610 (e.g., a rear housing) by a screw 695. For example, the second fixing portion 693 may include a screw hole 694. The screw 695 may be inserted into the screw hole 694 formed in the second fixing portion 693. For example, the bracket 670 (e.g., a front bracket) may include a bracket hole 672 into which the screw 695 is insertable. For example, the housing 610 (e.g., a rear housing) may include a screw groove 612 formed at a portion corresponding to the screw hole 694 and the bracket hole 672. For example, the screw 695 may pass through the screw hole 694 and the bracket hole 672 and may be inserted into the screw groove 612. By a coupling structure between the second fixing portion 693 and the housing 610 (e.g., a rear housing) using the screw 695, the second fixing portion 693 may be fixed to the housing 610 (e.g., a rear housing). By this fixing structure, the second fixing portion 693 may be pressed in a downward direction (e.g., the -z-axis direction) such that the heat dissipation member 1210 (e.g., a heat dissipation plate or a heat dissipation sheet) is brought into close contact with the first shielding sheet 660 (e.g., a shielding plate).

As illustrated in FIG. 11, when the cover plate 690 (e.g., a metal plate, a metal sheet, or a cover sheet) is disposed on the top surface of the heat dissipation member 680 (e.g., a heat dissipation plate or a heat dissipation sheet), the height of the top surface of the heat dissipation member 680 (e.g., a heat dissipation plate or a heat dissipation sheet)and the height of the top surface of the cover plate 690 (e.g., a metal plate, a metal sheet, or a cover sheet) may be different from each other. For example, the top surface of the heat dissipation member 680 (e.g., a heat dissipation plate or a heat dissipation sheet) may be positioned at a first height H1, and the top surface of the cover plate 690 (e.g., a metal plate, a metal sheet, or a cover sheet) may be positioned at a second height H2 that is higher than the first height H1. When a user's finger 1110 presses (e.g., presses in the -z-axis direction) the display 330 (e.g., a flexible display), the display 330 (e.g., a flexible display) may be damaged due to a step difference between the top surface of the heat dissipation member 680 (e.g., a heat dissipation plate or a heat dissipation sheet) and the top surface of the cover plate 690 (e.g., a metal plate, a metal sheet, or a cover sheet).

As illustrated in FIG. 12, the heat dissipation member 1210 (e.g., a heat dissipation plate or a heat dissipation sheet) may include a first portion 1211, a second portion 1212, and a bending portion 1213.

According to an embodiment, the first portion 1211 of the heat dissipation member 1210 (e.g., a heat dissipation plate or a heat dissipation sheet) may be disposed to overlap the cover plate 690 (e.g., a metal plate, a metal sheet, or a cover sheet). For example, the first portion 1211 of the heat dissipation member 1210 (e.g., a heat dissipation plate or a heat dissipation sheet) may be disposed to overlap the entire cover plate 690 (e.g., a metal plate, a metal sheet, or a cover sheet).

According to an embodiment, the second portion 1212 of the heat dissipation member 1210 (e.g., a heat dissipation plate or a heat dissipation sheet) may be disposed to overlap the bracket 670 (e.g., a front bracket). For example, the second portion 1212 of the heat dissipation member 1210 (e.g., a heat dissipation plate or a heat dissipation sheet) may be disposed to overlap at least a portion of the bracket 670 (e.g., a front bracket).

According to an embodiment, the bending portion 1213 of the heat dissipation member 1210 (e.g., a heat dissipation plate or a heat dissipation sheet) may be disposed between the first portion 1211 and the second portion 1212.

For example, a first side of the bending portion 1213 of the heat dissipation member 1210 (e.g., a heat dissipation plate or a heat dissipation sheet) may be connected to the first portion 1211, and a second side thereof may be connected to the second portion 1212.

According to an embodiment, the bending portion 1213 of the heat dissipation member 1210 (e.g., a heat dissipation plate or a heat dissipation sheet) may be bent such that the height of the top surface of the first portion 1211 and the height of the top surface of the second portion 1212 are different from each other.

For example, the first portion 1211 may be disposed to correspond to a first height H1. The second portion 1212 may be disposed to correspond to a second height H2 that is higher than the first height H1. The difference between the first height H1 of the first portion 1211 and the second height H2 of the second portion 1212 may be substantially equal to the height of the cover plate 690 (e.g., a metal plate, a metal sheet, or a cover sheet). The height H1 of the first portion 1211 of the heat dissipation member 1210 (e.g., a heat dissipation plate or a heat dissipation sheet) may be positioned lower than the height H2 of the second portion 1212, such that the height of the top surface of the cover plate 690 (e.g., a metal plate, a metal sheet, or a cover sheet) may be substantially equal to the height H2 of the second portion 1212 of the heat dissipation member 1210 (e.g., a heat dissipation plate or a heat dissipation sheet).

The electronic device 1200 according to an embodiment of the disclosure, described with reference to FIGS. 11 and 12, may spread heat generated from the processor 630 (e.g., the processor 120 of FIG. 1 or an application processor) over a wide area through the heat dissipation member 1210 (e.g., a heat dissipation plate or a heat dissipation sheet) and the cover plate 690 (e.g., a metal plate, a metal sheet, or a cover sheet), thereby improving heat dissipation efficiency.

The electronic device 1200 according to an embodiment of the disclosure, described with reference to FIGS. 11 and 12, may bring the heat dissipation member 1210 (e.g., a heat dissipation plate or a heat dissipation sheet) into close contact with the shielding sheet 660 (e.g., a shielding plate) through the cover plate 690 (e.g., a metal plate, a metal sheet, or a cover sheet), thereby forming a gap between the display 330 (e.g., a flexible display) and the heat dissipation member 1210 (e.g., a heat dissipation plate or a heat dissipation sheet). Heat dissipation efficiency may be improved by dispersing heat through the heat dissipation member 1210 (e.g., a heat dissipation plate or a heat dissipation sheet), the shielding sheet 660 (e.g., a shielding plate), and the cover plate 690 (e.g., a metal plate, a metal sheet, or a cover sheet).

The electronic device 1200 according to an embodiment of the disclosure, described with reference to FIGS. 11 and 12, may be configured such that the height of the top surface of the cover plate 690 (e.g., a metal plate, a metal sheet, or a cover sheet) is substantially equal to the height H2 of the second portion 1212 of the heat dissipation member 1210 (e.g., a heat dissipation plate or a heat dissipation sheet), thereby preventing damage to the display 330 (e.g., a flexible display) when the user presses (e.g., presses in the -z-axis direction) the display 330 (e.g., a flexible display) with a finger 1110.

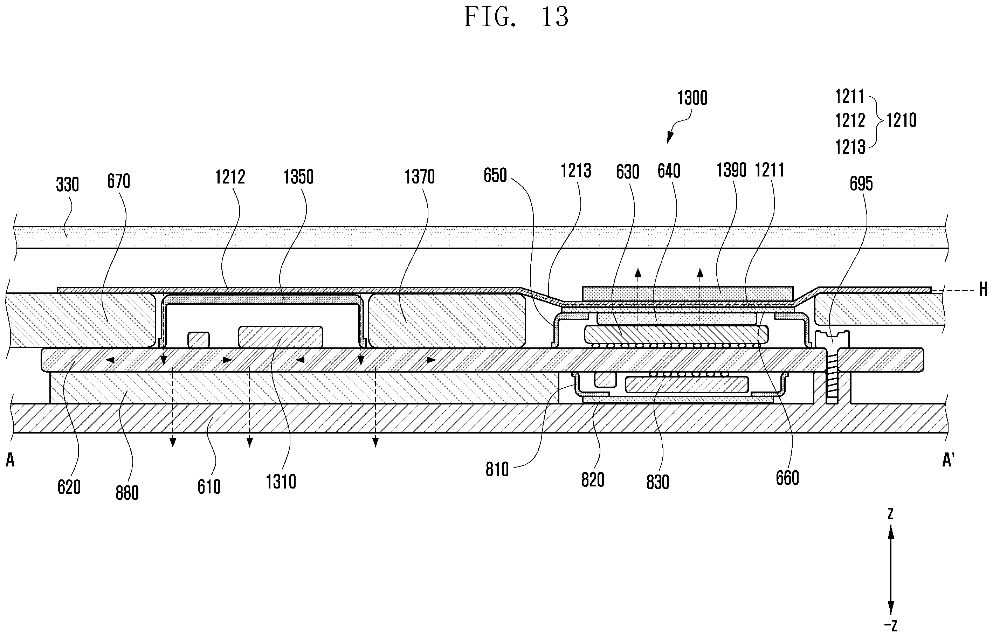

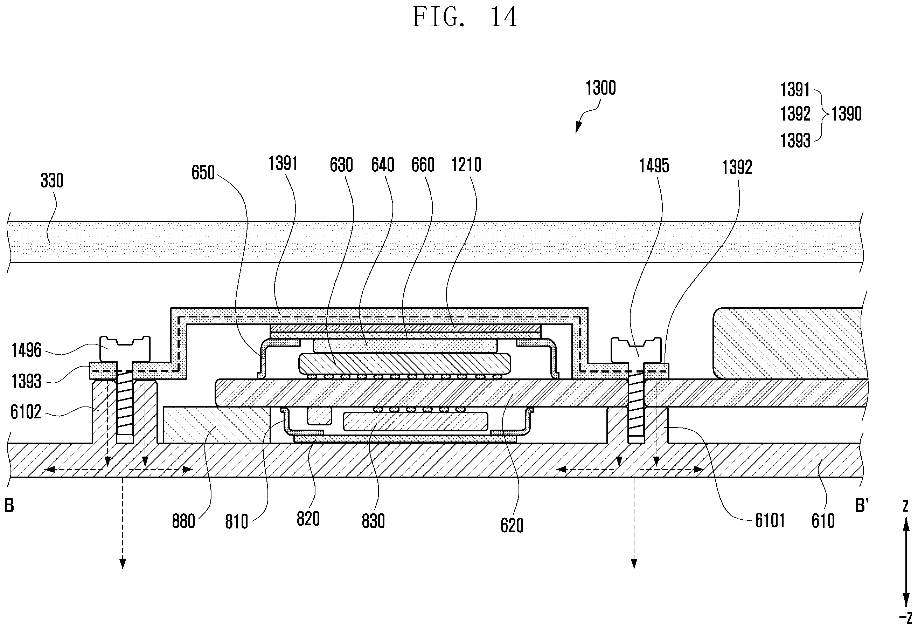

FIGS. 13 and 14 are cross-sectional views of an electronic device according to an embodiment of the disclosure.

The electronic device 1300 of FIGS. 13 and 14 may be at least partially similar to the electronic device 101 of FIG. 1, or may further include other embodiments of the electronic device. The electronic device 1300 of FIGS. 13 and 14 may be at least partially similar to the electronic device 300 of FIG. 3A, or may further include other embodiments of the electronic device. The electronic device 1300 of FIGS. 13 and 14 may be at least partially similar to the electronic device 600 of FIGS. 6 to 9, or may further include other embodiments of the electronic device. The electronic device 1300 of FIGS. 13 and 14 may be at least partially similar to the electronic device 1200 of FIG. 12, or may further include other embodiments of the electronic device.

In describing the electronic device 1300 of FIGS. 13 and 14, detailed descriptions of components that are the same as or similar to those of the electronic device 600 of FIGS. 6 to 9 may be omitted.

In describing the electronic device 1300 of FIGS. 13 and 14, detailed descriptions of components that are the same as or similar to those of the electronic device 1200 of FIG. 12 may be omitted.

FIG. 13 is a cross-sectional view of the electronic device 1300 taken along line A-A' of FIG. 7.

FIG. 14 is a cross-sectional view of the electronic device 1300 taken along line B-B' of FIG. 7.

Referring to FIGS. 13 and 14, the electronic device 1300 according to an embodiment of the disclosure may include a housing 610 (e.g., a rear housing), a printed circuit board 620 (e.g., a PCB or a PBA), a processor 630 (e.g., the processor 120 of FIG. 1 or an application processor), a heat transfer member 640 (e.g., a thermal interface material (TIM) or a heat spreading member), a first shield can 650, a first shielding sheet 660 (e.g., a shielding plate), a second shield can 810, a second shielding sheet 820, a bracket 670 (e.g., a front bracket), a heat dissipation member 1210 (e.g., a heat dissipation plate, a heat dissipation sheet, or the heat dissipation member 1210 of FIG. 12), a cover plate 1390 (e.g., a metal plate, a metal sheet, or a cover sheet), at least one electronic component 1310, a shielding member 1350, and a display 330 (e.g., a flexible display).

According to an embodiment, the electronic device 1300 may include a touch circuit including a touch sensor and a touch sensor integrated circuit (IC).

According to an embodiment, the electronic device 1300 may include an electronic pen (e.g., a stylus pen) and a digitizer.

According to an embodiment, the electronic device 1300 may include an interface. For example, the interface may include, for example, a high-definition multimedia interface (HDMI), a universal serial bus (USB) interface, an SD card interface, and/or an audio interface. For example, the interface may electrically or physically connect the electronic device 1300 to an external electronic device, and may include a USB connector, an SD card/MMC connector, or an audio connector.

According to an embodiment, the electronic device 1300 may include a battery (e.g., the battery 189 of FIG. 1). The battery 189 may serve as a device that supplies power to at least one component of the electronic device 1300, and may include, for example, a non-rechargeable primary cell, a rechargeable secondary cell, or a fuel cell.

According to an embodiment, the electronic device 1300 may include an antenna module (e.g., the antenna module 197 of FIG. 1). For example, the antenna module may include an antenna and an antenna driving circuit. For example, the antenna may include an near-field communication (NFC) antenna, a wireless charging antenna, and/or a magnetic secure transmission (MST) antenna. For example, the antenna may perform near-field communication with an external device or may wirelessly transmit and receive power required for charging. For example, an antenna structure may be formed by at least a portion of a side surface bezel structure of the electronic device 1300 and/or at least a portion of the housing 610 (e.g., a rear housing).

According to an embodiment, the printed circuit board 620 (e.g., a PCB or a PBA) may be disposed on the top surface of the housing 610 (e.g., a rear housing). For example, the printed circuit board 620 (e.g., a PCB or a PBA) may be accommodated in a space formed inside the housing 610 (e.g., a rear housing). For example, the printed circuit board 620 (e.g., a PCB or a PBA) may be disposed above the bracket 670 (e.g., a front bracket). For example, the processor 630 and electronic components may be disposed on the printed circuit board 620 (e.g., a PCB or a PBA). The electronic components may include at least one PMIC 830 and a memory 840 (e.g., the memory 130 of FIG. 1). For example, the memory 840 (e.g., the memory 130 of FIG. 1) may include a volatile memory or a non-volatile memory.

According to an embodiment, the processor 630 (e.g., the processor 120 of FIG. 1 or an application processor) and the electronic components may be disposed on one surface or both surfaces of the printed circuit board 620 (e.g., a PCB or a PBA) to face the display 330 (e.g., a flexible display). For example, the processor 630 (e.g., the processor 120 of FIG. 1 or an application processor) and the memory 840 (e.g., the memory 130 of FIG. 1) may be disposed on a first surface (e.g., a top surface) of the printed circuit board 620 (e.g., a PCB or a PBA).

For example, the PMIC 830 may be disposed on a second surface (e.g., a bottom surface) of the printed circuit board 620 (e.g., a PCB or a PBA).

According to an embodiment, a support member 880 (e.g., a support bracket) may be disposed on the top surface of the housing 610 (e.g., a rear housing) and may support the printed circuit board 620 (e.g., a PCB or a PBA).

According to an embodiment, the first shield can 650 may be disposed on the printed circuit board 620 (e.g., a PCB or a PBA) to surround the processor 630 (e.g., the processor 120 of FIG. 1 or an application processor). For example, an opening may be formed in a portion of a top surface of the first shield can 650, such that the first shield can 650 may have an open top.

For example, the first shield can 650 may be located on the first surface (e.g., a top surface) of the printed circuit board 620 (e.g., a PCB or a PBA). For example, the first shield can 650 may be disposed to surround the processor 630 (e.g., the processor 120 of FIG. 1 or an application processor), thereby shielding electromagnetic waves generated from the processor 630 (e.g., the processor 120 of FIG. 1 or an application processor). The first shield can 650 may dissipate heat generated from the processor 630 (e.g., the processor 120 of FIG. 1 or an application processor).

According to an embodiment, the first shielding sheet 660 (e.g., a shielding plate) may be disposed to cover the top surface of the first shield can 650. For example, an upper portion of the first shield can 650 may be shielded by the first shielding sheet 660 (e.g., a shielding plate). For example, the first shielding sheet 660 (e.g., a shielding plate) may have a function of shielding noise generated from the processor 630 (e.g., the processor 120 of FIG. 1 or an application processor), and may also dissipate heat generated from the processor 630 (e.g., the processor 120 of FIG. 1 or an application processor). To this end, the first shielding sheet 660 (e.g., a shielding plate) may be formed of a metal material having high thermal conductivity.

According to an embodiment, at least one electronic component 1310 may be disposed on the first surface (e.g., the top surface) of the printed circuit board 620 (e.g., a PCB or a PBA).

According to an embodiment, a shielding member 1350 may be disposed to surround the at least one electronic component 1310. For example, the shielding member 1350 may be disposed to surround the at least one electronic component 1310, thereby shielding electromagnetic waves generated from the at least one electronic component 1310. The shielding member 1350 may dissipate heat generated from the at least one electronic component 1310. For example, the shielding member 1350 may be formed to have the same shape and the same material as the first shield can 650 or the second shield can 810. For example, the shielding member 1350 may include a first shielding sheet 660 (e.g., a shielding plate) or a second shielding sheet 820 (e.g., a shielding plate). For example, the shielding member 1350 may be formed in a form in which the first shield can 650 and the first shielding sheet 660 (e.g., a shielding plate) are integrated. For example, the shielding member 1350 may be formed in a form in which the second shield can 810 and the second shielding sheet 820 (e.g., a shielding plate) are integrated.

According to an embodiment, the shielding member 1350 may be disposed in an open portion of a part of the bracket 670 (e.g., a front bracket). For example, the first shield can 650 and the shielding member 1350 may be disposed to be spaced apart from each other with at least a portion of the bracket 670 (e.g., a front bracket) interposed therebetween.

According to an embodiment, the heat dissipation member 1210 (e.g., a heat dissipation plate or a heat dissipation sheet) may overlap (e.g., overlap in the z-axis direction) at least a portion of the bracket 670 (e.g., a front bracket). For example, the heat dissipation member 1210 (e.g., a heat dissipation plate or a heat dissipation sheet) may be disposed above (e.g., on an upper side in the z-axis direction) the bracket 670 (e.g., a front bracket).

According to an embodiment, the heat dissipation member 1210 (e.g., a heat dissipation plate or a heat dissipation sheet) may overlap (e.g., overlap in the z-axis direction) at least a portion of the first shield can 650. For example, the heat dissipation member 1210 (e.g., a heat dissipation plate or a heat dissipation sheet) may be disposed above (e.g., on an upper side in the z-axis direction) the first shield can 650.

According to an embodiment, the heat dissipation member 1210 (e.g., a heat dissipation plate or a heat dissipation sheet) may overlap (e.g., overlap in the z-axis direction) at least a portion (or entirety) of the shielding member 1350. For example, the heat dissipation member 1210 (e.g., a heat dissipation plate or a heat dissipation sheet) may be disposed above (e.g., on an upper side in the z-axis direction) the shielding member 1350.

According to an embodiment, the cover plate 1390 (e.g., a metal plate, a metal sheet, or a cover sheet) may be disposed on a region of the heat dissipation member 1210 (e.g., a heat dissipation plate, or a heat dissipation sheet). The cover plate 1390 (e.g., a metal plate, a metal sheet, or a cover sheet) may be disposed to fix the heat dissipation member 1210 (e.g., a heat dissipation plate or a heat dissipation sheet) to the first shield can 650.

According to an embodiment, the cover plate 1390 (e.g., a metal plate, a metal sheet, or a cover sheet) may press the heat dissipation member 1210 (e.g., a heat dissipation plate or a heat dissipation sheet) in a downward direction (e.g., the -z-axis direction) when viewing a screen of the display 330 (e.g., a flexible display), so that the heat dissipation member 1210 (e.g., heat dissipation plate or a heat dissipation sheet) may be fixed to the first shield can 650.

According to an embodiment, the heat transfer member 640 (e.g., a TIM or a heat spreading member) may be disposed on a top surface of the processor 630 (e.g., the processor 120 of FIG. 1 or an application processor).

According to an embodiment, the heat transfer member 640 (e.g., a TIM or a heat spreading member) may be disposed between the processor 630 (e.g., the processor 120 of FIG. 1 or an application processor) and a first shielding sheet 660 (e.g., a shielding plate).

According to an embodiment, a heat dissipation member 1210 (e.g., a heat dissipation plate, a heat dissipation sheet) may overlap (e.g., overlap in the z-axis direction) the display 330 (e.g., a flexible display). For example, the heat dissipation member 1210 (e.g., a heat dissipation plate or a heat dissipation sheet) may be disposed below (e.g., on a lower side in the z-axis direction) the display 330 (e.g., a flexible display).

According to an embodiment, the heat dissipation member 1210 (e.g., a heat dissipation plate or a heat dissipation sheet) may be disposed between the bracket 670 (e.g., a front bracket) and the display 330 (e.g., a flexible display).

According to an embodiment, the heat dissipation member 1210 (e.g., a heat dissipation plate or a heat dissipation sheet) may be disposed between the first shield can 650 and the display 330 (e.g., a flexible display).

According to an embodiment, the heat dissipation member 1210 (e.g., a heat dissipation plate or a heat dissipation sheet) may be disposed to overlap the entire cover plate 1390 (e.g., a metal plate, a metal sheet, or a cover sheet).

According to an embodiment, the heat dissipation member 1210 (e.g., a heat dissipation plate or a heat dissipation sheet) may be disposed to overlap at least a portion of the bracket 670 (e.g., a front bracket).

For example, the heat dissipation member 1210 (e.g., a heat dissipation plate or a heat dissipation sheet) may rapidly spread heat transferred from a processor 630 (e.g., the processor 120 of FIG. 1 or an application processor) and the at least one electronic component 1310 and may transfer the heat to air. The heat dissipation member 1210 (e.g., a heat dissipation plate or a heat dissipation sheet) may be formed of a graphite sheet or a copper (Cu) sheet.

According to an embodiment, the display 330 (e.g., a flexible display) may be disposed on the top surface of the housing 610 (e.g., a rear housing). For example, the display 330 (e.g., a flexible display) may be accommodated in a space formed inside the housing 610 (e.g., a rear housing).

For example, the display 330 (e.g., a flexible display) may be disposed with a predetermined gap from a heat dissipation member 1210 (e.g., a heat dissipation plate or a heat dissipation sheet) in the z-axis direction.

For example, a heat dissipation path may be formed through the gap between the heat dissipation member 1210 (e.g., a heat dissipation plate or a heat dissipation sheet) and the display 330 (e.g., a flexible display).

According to an embodiment, the electronic device 1300 may include a second shield can 810 and a second shielding sheet 820 (e.g., a shielding plate).

According to an embodiment, the second shield can 810 may be disposed on the printed circuit board 620 (e.g., a PCB or a PBA) to surround electronic components. For example, the electronic components may include one or more PMICs 830.

For example, the second shield can 810 may be located on the second surface (e.g., a bottom surface) of the printed circuit board 620 (e.g., a PCB or a PBA). For example, the second shield can 810 may be disposed to surround the one or more PMICs 830 so as to shield electromagnetic waves generated from the one or more PMICs 830. The second shield can 810 may dissipate heat generated from the one or more PMICs 830.

For example, the second shielding sheet 820 (e.g., a shielding plate) may have a function of shielding noise generated from the one or more PMICs 830, and at the same time, may dissipate heat generated from the one or more PMICs 830. To this end, the second shielding sheet 820 (e.g., a shielding plate) may be formed of a metal material having high thermal conductivity.

For example, an opening may be formed in a portion of a top surface of the second shield can 810, such that an upper portion of the second shield can 810 may open. In FIGS. 13 and 14, the first shield can 650 is disposed on the first surface (e.g., the top surface) of the printed circuit board 620 (e.g., a PCB or a PBA), and the second shield can 810 is disposed on the second surface (e.g., the bottom surface) of the printed circuit board 620 (e.g., a PCB or a PBA). Accordingly, the opening of the top surface of the first shield can 650 and the opening of the top surface of the second shield can 810 may be formed in directions opposite to each other.

According to an embodiment, the second shielding sheet 820 (e.g., a shielding plate) may be disposed to cover a top surface of the second shield can 810 (which corresponds to a lower side in FIGS. 13 and 14). For example, an upper portion of the second shield can 810 (which corresponds to a lower portion in FIGS. 13 and 14) may be shielded by the second shielding sheet 820 (e.g., a shielding plate).

According to an embodiment, the cover plate 1390 (e.g., a metal plate, a metal sheet, or a cover sheet) may be disposed on the heat dissipation member 1210 (e.g., a heat dissipation plate or a heat dissipation sheet) at a portion corresponding to the first shield can 650.

For example, the cover plate 1390 (e.g., a metal plate, a metal sheet, or a cover sheet) may be disposed to overlap a portion of the first shield can 650.

For example, the cover plate 1390 (e.g., a metal plate, a metal sheet, or a cover sheet) may be disposed to overlap the entire first shield can 650.

For example, the cover plate 1390 (e.g., a metal plate, a metal sheet, or a cover sheet) may be disposed to overlap a part or an entirety of the processor 630 (e.g., the processor 120 of FIG. 1 or an application processor), with the heat transfer member 640 (e.g., a TIM or a heat spreading member), the first shielding sheet 660 (e.g., a shielding plate), and the heat dissipation member 1210 (e.g., a heat dissipation plate or a heat dissipation sheet) interposed therebetween.

According to an embodiment, the cover plate 1390 (e.g., a metal plate, a metal sheet, or a cover sheet) may include a cover portion 1391, a first fixing portion 1392, and a second fixing portion 1393.

According to an embodiment, the cover portion 1391 of the cover plate 1390 (e.g., a metal plate, a metal sheet, or a cover sheet) may correspond to the top surface of the first shield can 650 and may be formed to cover the top surface of the first shield can 650.

According to an embodiment, the cover portion 1391 of the cover plate 1390 (e.g., a metal plate, a metal sheet, or a cover sheet) may be formed to cover a top surface of the heat dissipation member 1210 (e.g., a heat dissipation plate or a heat dissipation sheet). For example, the cover portion 1391 of the cover plate 1390 (e.g., a metal plate, a metal sheet, or a cover sheet) may press the heat dissipation member 1210 (e.g., a heat dissipation plate, or a heat dissipation sheet) in a downward direction (e.g., the -z-axis direction), so that the heat dissipation member 1210 (e.g., a heat dissipation plate or a heat dissipation sheet) is brought into close contact with the shielding sheet 660 (e.g., a shielding plate).

According to an embodiment, the first fixing portion 1392 of the cover plate 1390 (e.g., a metal plate, a metal sheet, or a cover sheet) may protrude (e.g., protrude in a horizontal direction) from a first side of the cover plate 1390 (e.g., a metal plate, a metal sheet, or a cover sheet). For example, the first fixing portion 1392 may be bent such that its top surface is positioned lower than the top surface of the cover portion 1391.

According to an embodiment, the second fixing portion 1393 of the cover plate 1390 (e.g., a metal plate, a metal sheet, or a cover sheet) may protrude (e.g., protrude in a horizontal direction) from a second side of the cover plate 1390 (e.g., a metal plate, a metal sheet, or a cover sheet). For example, the second fixing portion 1393 may be bent such that its top surface is positioned lower than the top surface of the cover portion 1391.

According to an embodiment, the first fixing portion 1392 may be fixed to the housing 610 (e.g., a rear housing) by a first screw 1495. For example, the first fixing portion 1392 may include a first screw hole. The first screw 1495 may be inserted into the first screw hole formed in the first fixing portion 1392. For example, the housing 610 (e.g., a rear housing) may include a first screw groove 6101 formed at a portion corresponding to the first screw hole. For example, the first screw 1495 may pass through the first screw hole to be inserted into the first screw groove 6101.

According to an embodiment, the second fixing portion 1393 may be fixed to the housing 610 (e.g., a rear housing) by a second screw 1496. For example, the first fixing portion 1393 may include a second screw hole. The second screw 1496 may be inserted into the second screw hole formed in the second fixing portion 1393. For example, the housing 610 (e.g., a rear housing) may include a second screw groove 6102 formed at a portion corresponding to the second screw hole. For example, the second screw 1496 may pass through the second screw hole to be inserted into the second screw groove 6102.

According to an embodiment, by a coupling structure between the first fixing portion 1392 and the housing 610 (e.g., a rear housing) using the first screw 1495, the first fixing portion 1392 may be fixed to the housing 610 (e.g., a rear housing). By a coupling structure between the second fixing portion 1393 and the housing 610 (e.g., a rear housing) using the second screw 1496, the second fixing portion 1393 may be fixed to the housing 610 (e.g., a rear housing). By this fixing structure, the first fixing portion 1392 and the second fixing portion 1393 may be pressed in a downward direction (e.g., the -z-axis direction) such that the heat dissipation member 1210 (e.g., a heat dissipation plate or a heat dissipation sheet) is brought into close contact with the first shielding sheet 660 (e.g., a shielding plate).

According to an embodiment, the heat dissipation member 1210 (e.g., a heat dissipation plate or a heat dissipation sheet) may include a first portion 1211, a second portion 1212, and a bending portion 1213.

According to an embodiment, the first portion 1211 of the heat dissipation member 1210 (e.g., a heat dissipation plate or a heat dissipation sheet) may be disposed to overlap the cover plate 1390 (e.g., a metal plate, a metal sheet, or a cover sheet). For example, the first portion 1211 of the heat dissipation member 1210 (e.g., a heat dissipation plate or a heat dissipation sheet) may be disposed to overlap the entire cover plate 1390 (e.g., a metal plate, a metal sheet, or a cover sheet).

According to an embodiment, the second portion 1212 of the heat dissipation member 1210 (e.g., a heat dissipation plate or a heat dissipation sheet) may be disposed to overlap the bracket 670 (e.g., a front bracket). For example, the second portion 1212 of the heat dissipation member 1210 (e.g., a heat dissipation plate or a heat dissipation sheet) may be disposed to overlap at least a portion of the bracket 670 (e.g., a front bracket).

According to an embodiment, the bending portion 1213 of the heat dissipation member 1210 (e.g., a heat dissipation plate or a heat dissipation sheet) may be disposed between the first portion 1211 and the second portion 1212.

For example, a first side of the bending portion 1213 of the heat dissipation member 1210 (e.g., a heat dissipation plate or a heat dissipation sheet) may be connected to the first portion 1211, and a second side thereof may be connected to the second portion 1212.

According to an embodiment, the bending portion 1213 of the heat dissipation member 1210 (e.g., a heat dissipation plate or a heat dissipation sheet) may be bent such that the height of the top surface of the first portion 1211 and the height of the top surface of the second portion 1212 are different from each other.

The height of the first portion 1211 of the heat dissipation member 1210 (e.g., a heat dissipation plate or a heat dissipation sheet) may be positioned lower than the height of the second portion 1212, such that the height H of the top surface of the cover plate 1390 (e.g., a metal plate, a metal sheet, or a cover sheet) may be substantially equal to the height H of the second portion 1212 of the heat dissipation member 1210 (e.g., a heat dissipation plate or a heat dissipation sheet).

The electronic device 1300 according to an embodiment of the disclosure, described with reference to FIGS. 13 and 14, may spread heat generated from the processor 630 (e.g., the processor 120 of FIG. 1 or an application processor) and the at least one electronic component 1310 over a wide area through the heat dissipation member 1210 (e.g., a heat dissipation plate or a heat dissipation sheet) and the cover plate 1390 (e.g., a metal plate, a metal sheet, or a cover sheet), thereby improving heat dissipation efficiency.

The electronic device 1300 according to an embodiment of the disclosure, described with reference to FIGS. 13 and 14, may bring he heat dissipation member 1210 (e.g., a heat dissipation plate or a heat dissipation sheet) into close contact with the shielding sheet 660 (e.g., a shielding plate) through the cover plate 1390 (e.g., a metal plate, a metal sheet, or a cover sheet), thereby forming a gap between the display 330 (e.g., a flexible display) and the heat dissipation member 1210 (e.g., a heat dissipation plate or a heat dissipation sheet). Heat dissipation efficiency may be improved by dispersing heat through the heat dissipation member 1210 (e.g., a heat dissipation plate or a heat dissipation sheet), the shielding sheet 660 (e.g., a shielding plate), and the cover plate 1390 (e.g., a metal plate, a metal sheet, or a cover sheet).

The electronic device 1300 according to an embodiment of the disclosure, described with reference to FIGS. 13 and 14, may be configured such that the height H of the top surface of the cover plate 1390 (e.g., a metal plate, a metal sheet, or a cover sheet) is substantially equal to the height H of the second portion 1212 of the heat dissipation member 1210 (e.g., a heat dissipation plate or a heat dissipation sheet), thereby preventing damage to the display 330 (e.g., a flexible display) when the user presses (e.g., presses in the -z-axis direction) the display 330 (e.g., a flexible display) with a finger.

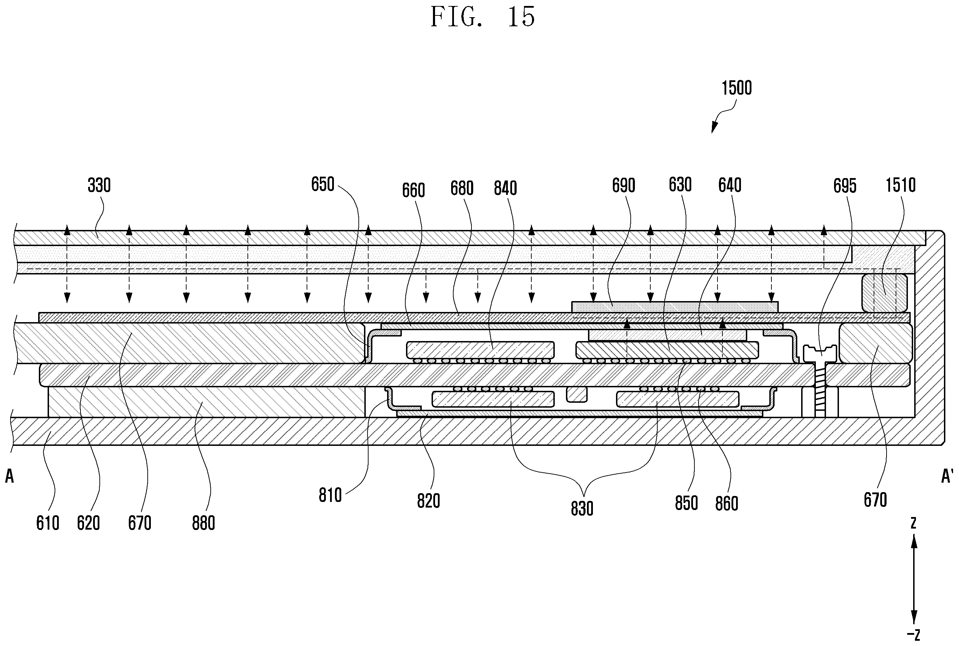

FIG. 15 is a cross-sectional view of an electronic device according to an embodiment of the disclosure.

The electronic device 1500 of FIG. 15 may be at least partially similar to the electronic device 101 of FIG. 1, or may further include other embodiments of the electronic device. The electronic device 1500 of FIG. 15 may be at least partially similar to the electronic device 300 of FIG. 3A, or may further include other embodiments of the electronic device. The electronic device 1500 of FIG. 15 may be at least partially similar to the electronic device 600 of FIGS. 6 to 9, or may further include other embodiments of the electronic device.

In describing the electronic device 1500 of FIG. 15, detailed descriptions of components that are the same as or similar to those of the electronic device 1500 of FIGS. 6 to 9 may be omitted.

Referring to FIG. 15, the electronic device 1500 according to an embodiment of the disclosure may include a housing 610 (e.g., a rear housing), a printed circuit board 620 (e.g., a PCB or a PBA), a processor 630 (e.g., the processor 120 of FIG. 1 or an application processor), a heat transfer member 640 (e.g., a thermal interface material (TIM) or a heat dissipation member), a first shield can 650, a first shielding sheet 660 (e.g., a shielding plate), a bracket 670 (e.g., a front bracket), a heat dissipation member 680 (e.g., a heat dissipation plate or a heat dissipation sheet), a cover plate 690 (e.g., a metal plate, a metal sheet, or a cover sheet), a thermally conductive compression member 1510 (e.g., a thermally conductive gasket), and a display 330 (e.g., a flexible display).

According to an embodiment, the electronic device 1500 may include a touch circuit including a touch sensor and a touch sensor integrated circuit (IC).

According to an embodiment, the electronic device 1500 may include an electronic pen (e.g., a stylus pen) and a digitizer.

According to an embodiment, the electronic device 1500 may include an interface. For example, the interface may include, for example, a high-definition multimedia interface (HDMI), a universal serial bus (USB) interface, an SD card interface, and/or an audio interface. For example, the interface may electrically or physically connect the electronic device 300 to an external electronic device, and may include a USB connector, an SD card/MMC connector, or an audio connector.

According to an embodiment, the electronic device 1500 may include a battery (e.g., the battery 189 of FIG. 1). The battery 189 may serve as a device that supplies power to at least one component of the electronic device 1500, and may include, for example, a non-rechargeable primary cell, a rechargeable secondary cell, or a fuel cell.

According to an embodiment, the electronic device 1500 may include an antenna module (e.g., the antenna module 197 of FIG. 1). For example, the antenna module may include an antenna and an antenna driving circuit. For example, the antenna may include an near-field communication (NFC) antenna, a wireless charging antenna, and/or a magnetic secure transmission (MST) antenna. For example, the antenna may perform near-field communication with an external device or may wirelessly transmit and receive power required for charging. For example, an antenna structure may be formed by at least a portion of a side surface bezel structure of the electronic device 1500 and/or at least a portion of the housing 610 (e.g., a rear housing).

The electronic device 1500 according to an embodiment of the disclosure, described with reference to FIG. 15, may spread heat generated from the processor 630 (e.g., the processor 120 of FIG. 1 or an application processor) over a wide area through the heat dissipation member 680 (e.g., a heat dissipation plate or a heat dissipation sheet) and the cover plate 690 (e.g., a metal plate, a metal sheet, or a cover sheet), thereby improving heat dissipation efficiency.

According to an embodiment, the cover plate 690 (e.g., a metal plate, a metal sheet, or a cover sheet) may be fixed to the housing 610 (e.g., a rear housing) by a screw 695. By a coupling structure between the cover plate 690 (e.g., a metal plate, a metal sheet, or a cover sheet) and the housing 610 (e.g., a rear housing) using the screw 695, the cover plate 690 (e.g., a metal plate, a metal sheet, or a cover sheet) may be fixed. By this fixing structure, the cover plate 690 (e.g., a metal plate, a metal sheet, or a cover sheet) may be pressed in a downward direction (e.g., the -z-axis direction), such that the heat dissipation member 680 (e.g., a heat dissipation plate or a heat dissipation sheet) is brought into close contact with the first shielding sheet 660 (e.g., a shielding plate).

According to an embodiment, the thermally conductive compression member 1510 (e.g., a thermally conductive gasket) may be disposed on one side of an upper portion of the heat dissipation member 680 (e.g., a heat dissipation plate or a heat dissipation sheet).

For example, the thermally conductive compression member 1510 (e.g., a thermally conductive gasket) may be disposed between the heat dissipation member 680 (e.g., a heat dissipation plate or a heat dissipation sheet) and the display 330 (e.g., a flexible display). For example, the thermally conductive compression member 1510 (e.g., a thermally conductive gasket) may be disposed at a position corresponding to a non-display region (e.g., a bezel region) of the display 330 (e.g., a flexible display). By the thermally conductive compression member 1510 (e.g., a thermally conductive gasket), heat transferred through the heat dissipation member 680 (e.g., a heat dissipation plate or a heat dissipation sheet) may be spread to a lower structure of the display 330 (e.g., a flexible display), thereby improving heat dissipation efficiency.

The electronic device 1500 according to an embodiment of the disclosure, described with reference to FIG. 15, may bring the heat dissipation member 680 (e.g., a heat dissipation plate or a heat dissipation sheet) into close contact with the shielding sheet 660 (e.g., a shielding plate) through the cover plate 690 (e.g., a metal plate, a metal sheet, or a cover sheet), thereby forming a gap between the display 330 (e.g., a flexible display) and the heat dissipation member 680 (e.g., a heat dissipation plate or a heat dissipation sheet). Heat dissipation efficiency may be improved by dispersing heat through the heat dissipation member 680 (e.g., a heat dissipation plate or a heat dissipation sheet), the shielding sheet 660 (e.g., a shielding plate), and the cover plate 690 (e.g., a metal plate, a metal sheet, or a cover sheet).

According to an electronic device 1500 of an embodiment of the disclosure described above with reference to FIG. 15, heat dissipation efficiency may be improved by allowing heat transferred through a heat dissipation member 680 (e.g., a heat dissipation plate or a heat dissipation sheet) to be spread to a lower structure of a display 330 (e.g., a flexible display) through a thermally conductive compression member 1510 (e.g., a thermally conductive gasket) disposed at a position corresponding to a non-display region (e.g., a bezel region) of the display 330 (e.g., a flexible display).

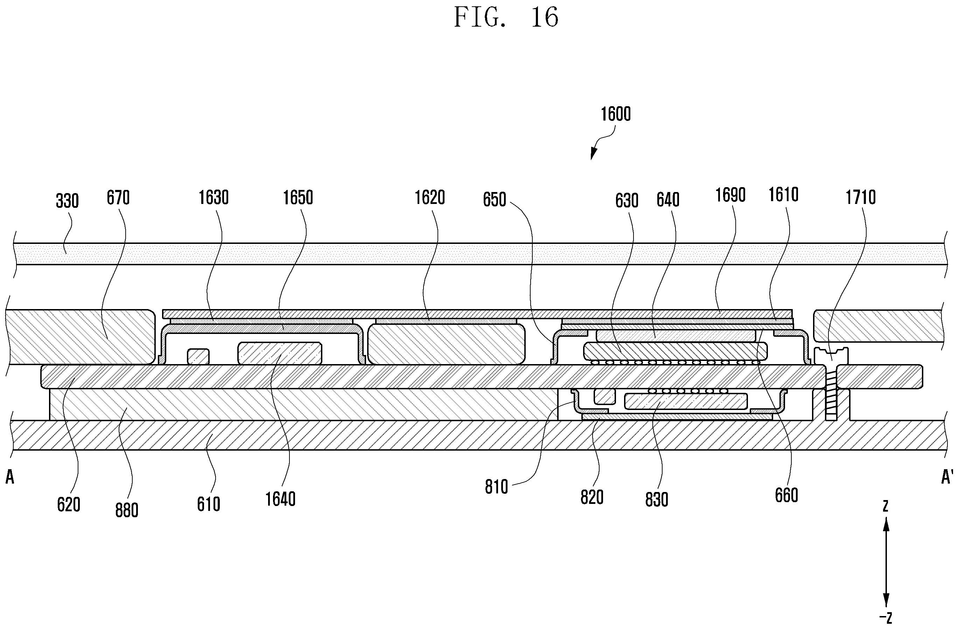

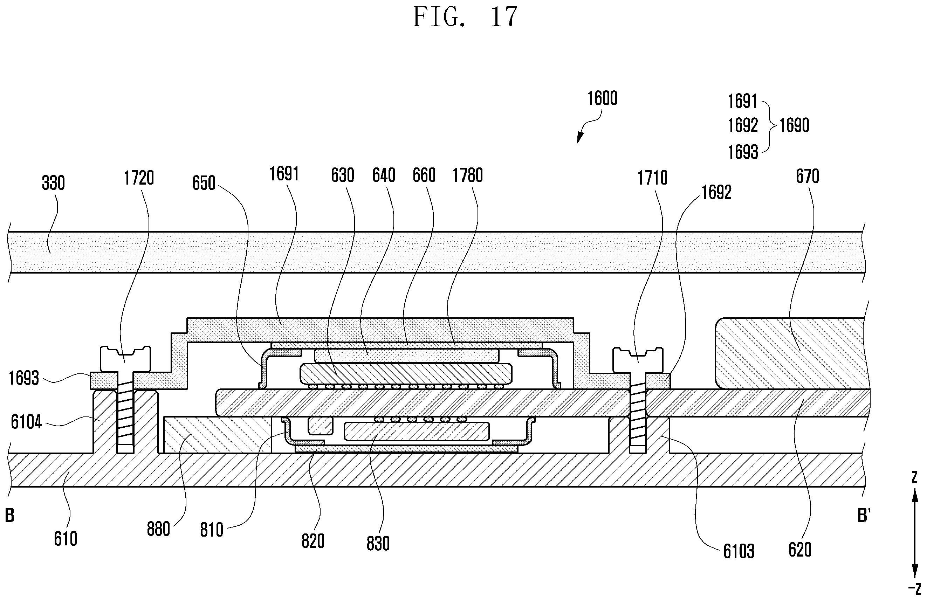

FIGS. 16 and 17 are cross-sectional views of an electronic device according to an embodiment of the disclosure.

The electronic device 1600 of FIGS. 16 and 17 may be at least partially similar to the electronic device 101 of FIG. 1, or may further include other embodiments of the electronic device. The electronic device 1600 of FIGS. 16 and 17 may be at least partially similar to the electronic device 300 of FIG. 3A, or may further include other embodiments of the electronic device. The electronic device 1600 of FIGS. 16 and 17 may be at least partially similar to the electronic device 600 of FIGS. 6 to 9, or may further include other embodiments of the electronic device. The electronic device 1600 of FIGS. 16 and 17 may be at least partially similar to the electronic device 1200 of FIG. 12, or may further include other embodiments of the electronic device. The electronic device 1600 of FIGS. 16 and 17 may be at least partially similar to the electronic device 1300 of FIGS. 13 and 14, or may further include other embodiments of the electronic device.

In describing the electronic device 1600 of FIGS. 16 and 17, detailed descriptions of components that are the same as or similar to those of the electronic device 600 of FIGS. 6 to 9 may be omitted.

In describing the electronic device 1600 of FIGS. 16 and 17, detailed descriptions of components that are the same as or similar to those of the electronic device 1200 of FIG. 12 may be omitted.

In describing the electronic device 1600 of FIGS. 16 and 17, detailed descriptions of components that are the same as or similar to those of the electronic device 1300 of FIGS. 13 and 14 may be omitted.

In describing the electronic device 1600 of FIGS. 16 and 17, detailed descriptions of components that are the same as or similar to those of the electronic device 1500 of FIG. 15 may be omitted.

FIG. 16 is a cross-sectional view of the electronic device 1600 taken along line A-A' of FIG. 7.

FIG. 17 is a cross-sectional view of the electronic device 1600 taken along line B-B' of FIG. 7.

Referring to FIGS. 16 and 17, the electronic device 1600 according to an embodiment of the disclosure may include a housing 610 (e.g., a rear housing), a printed circuit board 620 (e.g., a PCB or a PBA), a processor 630 (e.g., the processor 120 of FIG. 1 or an application processor), a heat transfer member 640 (e.g., a thermal interface material (TIM) or a heat spreading member), a first shield can 650, a first shielding sheet 660 (e.g., a shielding plate), a second shield can 810, a second shielding sheet 820 (e.g., a shielding plate), a plurality of adhesive members 1610, 1620, and 1630, a bracket 670 (e.g., a front bracket), a cover plate 1690 (e.g., a vapor chamber, a heat pipe, a heat plate, a metal plate, a metal sheet, or a cover sheet), at least one electronic component 1640, a shielding member 1650, and a display 330 (e.g., a flexible display).

According to an embodiment, the electronic device 1600 may include a touch circuit including a touch sensor and a touch sensor integrated circuit (IC).

According to an embodiment, the electronic device 1600 may include an electronic pen (e.g., a stylus pen) and a digitizer.

According to an embodiment, the electronic device 1600 may include an interface. For example, the interface may include, for example, a high-definition multimedia interface (HDMI), a universal serial bus (USB) interface, an SD card interface, and/or an audio interface. For example, the interface may electrically or physically connect the electronic device 1600 to an external electronic device, and may include a USB connector, an SD card/MMC connector, or an audio connector.

According to an embodiment, the electronic device 1600 may include a battery (e.g., the battery 189 of FIG. 1). The battery 189 may serve as a device that supplies power to at least one component of the electronic device 1600, and may include, for example, a non-rechargeable primary cell, a rechargeable secondary cell, or a fuel cell.

According to an embodiment, the electronic device 1600 may include an antenna module (e.g., the antenna module 197 of FIG. 1). For example, the antenna module may include an antenna and an antenna driving circuit. For example, the antenna may include an near-field communication (NFC) antenna, a wireless charging antenna, and/or a magnetic secure transmission (MST) antenna. For example, the antenna may perform near-field communication with an external device or may wirelessly transmit and receive power required for charging. For example, an antenna structure may be formed by at least a portion of a side surface bezel structure of the electronic device 1600 and/or at least a portion of the housing 610 (e.g., a rear housing).

According to an embodiment, the printed circuit board 620 (e.g., a PCB or a PBA) may be disposed on the top surface of the housing 610 (e.g., a rear housing). For example, the printed circuit board 620 (e.g., a PCB or a PBA) may be accommodated in a space formed inside the housing 610 (e.g., a rear housing). For example, the printed circuit board 620 (e.g., a PCB or a PBA) may be disposed above the bracket 670 (e.g., a front bracket). For example, the processor 630 and electronic components may be disposed on the printed circuit board 620 (e.g., a PCB or a PBA). The electronic components may include at least one PMIC 830 and/or a memory. For example, the memory may include a volatile memory or a non-volatile memory.

According to an embodiment, the processor 630 (e.g., the processor 120 of FIG. 1 or an application processor) and the electronic components may be disposed on one surface or both surfaces of the printed circuit board 620 (e.g., a PCB or a PBA) to face the display 330 (e.g., a flexible display). For example, the processor 630 (e.g., the processor 120 of FIG. 1 or an application processor) and the memory 840 (e.g., the memory 130 of FIG. 1) may be disposed on a first surface (e.g., a top surface) of the printed circuit board 620 (e.g., a PCB or a PBA).

According to an embodiment, a support member 880 (e.g., a support bracket) may be disposed on the top surface of the housing 610 (e.g., a rear housing) and may support the printed circuit board 620 (e.g., a PCB or a PBA).

According to an embodiment, the first shield can 650 may be disposed on the printed circuit board 620 (e.g., a PCB or a PBA) to surround the processor 630 (e.g., the processor 120 of FIG. 1 or an application processor). For example, an opening may be formed in a portion of a top surface of the first shield can 650, such that the first shield can 650 may have an open top.

For example, the first shield can 650 may be located on the first surface (e.g., a top surface) of the printed circuit board 620 (e.g., a PCB or a PBA). For example, the first shield can 650 may be disposed to surround the processor 630 (e.g., the processor 120 of FIG. 1 or an application processor), thereby shielding electromagnetic waves generated from the processor 630 (e.g., the processor 120 of FIG. 1 or an application processor). The first shield can 650 may dissipate heat generated from the processor 630 (e.g., the processor 120 of FIG. 1 or an application processor).

According to an embodiment, the first shielding sheet 660 (e.g., a shielding plate) may be disposed to cover the top surface of the first shield can 650. For example, an upper portion of the first shield can 650 may be shielded by the first shielding sheet 660 (e.g., a shielding plate). For example, the first shielding sheet 660 (e.g., a shielding plate) may have a function of shielding noise generated from the processor 630 (e.g., the processor 120 of FIG. 1 or an application processor), and may also dissipate heat generated from the processor 630 (e.g., the processor 120 of FIG. 1 or an application processor). To this end, the first shielding sheet 660 (e.g., a shielding plate) may be formed of a metal material having high thermal conductivity.

According to an embodiment, at least one electronic component 1640 may be disposed on the first surface (e.g., the top surface) of the printed circuit board 620 (e.g., a PCB or a PBA).

According to an embodiment, a shielding member 1650 may be disposed to surround the at least one electronic component 1640. For example, the shielding member 1650 may be disposed to surround the at least one electronic component 1640, thereby shielding electromagnetic waves generated from the at least one electronic component 1640. The shielding member 1650 may dissipate heat generated from the at least one electronic component 1640. For example, the shielding member 1650 may be formed to have the same shape and the same material as the first shield can 650 or the second shield can 810. For example, the shielding member 1650 may include a first shielding sheet 660 (e.g., a shielding plate) or a second shielding sheet 820 (e.g., a shielding plate). For example, the shielding member 1650 may be formed in a form in which the first shield can 650 and the first shielding sheet 660 (e.g., a shielding plate) are integrated. For example, the shielding member 1650 may be formed in a form in which the second shield can 810 and the second shielding sheet 820 (e.g., a shielding plate) are integrated.

According to an embodiment, the shielding member 1650 may be disposed in an open portion of a part of the bracket 670 (e.g., a front bracket). For example, the first shield can 650 and the shielding member 1650 may be disposed to be spaced apart from each other with at least a portion of the bracket 670 (e.g., a front bracket) interposed therebetween.

According to an embodiment, the cover plate 1690 (e.g., a vapor chamber, a heat pipe, a heat plate, a metal plate, a metal sheet, or a cover sheet) may be disposed to overlap the first shield can 650, the first shielding sheet 660 (e.g., a shielding plate), and the shielding member 1650. The cover plate 1690 (e.g., a vapor chamber, a heat pipe, a heat plate, a metal plate, a metal sheet, or a cover sheet) may be disposed to overlap at least a portion of the bracket 670 (e.g., a front bracket).

According to an embodiment, the first adhesive member 1610 may be disposed between the cover plate 1690 (e.g., a vapor chamber, a heat pipe, a heat plate, a metal plate, a metal sheet, or a cover sheet) and the first shielding sheet 660 (e.g., a shielding plate). For example, by the first adhesive member 1610, the cover plate 1690 (e.g., a vapor chamber, a heat pipe, a heat plate, a metal plate, a metal sheet, or a cover sheet) may be attached to and fixed to the top surface of the first shielding sheet 660 (e.g., a shielding plate).

According to an embodiment, a second adhesive member 1620 may be disposed between the cover plate 1690 (e.g., a vapor chamber, a heat pipe, a heat plate, a metal plate, a metal sheet, or a cover sheet) and at least a portion of the bracket 670 (e.g., a front bracket). For example, by the second adhesive member 1620, the cover plate 1690 (e.g., a vapor chamber, a heat pipe, a heat plate, a metal plate, a metal sheet, or a cover sheet) may be attached to and fixed to the top surface of at least a portion of the bracket 670 (e.g., a front bracket).

According to an embodiment, a third adhesive member 1630 may be disposed between the cover plate 1690 (e.g., a vapor chamber, a heat pipe, a heat plate, a metal plate, a metal sheet, or a cover sheet) and the shielding member 1650. For example, by the third adhesive member 1630, the cover plate 1690 (e.g., a vapor chamber, a heat pipe, a heat plate, a metal plate, a metal sheet, or a cover sheet) may be attached to and fixed to the top surface of the shielding member 1650.

According to an embodiment, the heat transfer member 640 (e.g., a TIM or a heat spreading member) may be disposed on a top surface of the processor 630 (e.g., the processor 120 of FIG. 1 or an application processor).

According to an embodiment, the heat transfer member 640 (e.g., a TIM or a heat spreading member) may be disposed between the processor 630 (e.g., the processor 120 of FIG. 1 or an application processor) and a first shielding sheet 660 (e.g., a shielding plate).

According to an embodiment, the cover plate 1690 (e.g., a vapor chamber, a heat pipe, a heat plate, a metal plate, a metal sheet, or a cover sheet) may overlap (e.g., overlap in the z-axis direction) the display 330 (e.g., a flexible display). For example, the cover plate 1690 (e.g., a vapor chamber, a heat pipe, a heat plate, a metal plate, a metal sheet, or a cover sheet) may be disposed below (e.g., below in the z-axis direction) the display 330 (e.g., a flexible display).

According to an embodiment, the cover plate 1690 (e.g., a vapor chamber, a heat pipe, a heat plate, a metal plate, a metal sheet, or a cover sheet) may be disposed between the first shield can 650 and the display 330 (e.g., a flexible display).

According to an embodiment, the cover plate 1690 (e.g., a vapor chamber, a heat pipe, a heat plate, a metal plate, a metal sheet, or a cover sheet) may overlap at least a part or an entirety of the first shield can 650.

According to an embodiment, the cover plate 1690 (e.g., a vapor chamber, a heat pipe, a heat plate, a metal plate, a metal sheet, or a cover sheet) may overlap at least a part or an entirety of the shielding member 1650.

According to an embodiment, the cover plate 1690 (e.g., a vapor chamber, a heat pipe, a heat plate, a metal plate, a metal sheet, or a cover sheet) may rapidly spread heat transferred from the processor 630 (e.g., the processor 120 of FIG. 1 or an application processor) and the at least one electronic component 1640, and may transfer the heat to air. The cover plate 1690 (e.g., a vapor chamber, a heat pipe, a heat plate, a metal plate, a metal sheet, or a cover sheet) may be formed of a graphite sheet or a copper (Cu) sheet.

According to an embodiment, the display 330 (e.g., a flexible display) may be disposed on the top surface of the housing 610 (e.g., a rear housing). For example, the display 330 (e.g., a flexible display) may be accommodated in a space formed inside the housing 610 (e.g., a rear housing).

For example, the display 330 (e.g., a flexible display) may be disposed with a predetermined gap from the cover plate 1690 (e.g., a vapor chamber, a heat pipe, a heat plate, a metal plate, a metal sheet, or a cover sheet) in the z-axis direction.

For example, a heat dissipation path may be formed through the gap between the cover plate 1690 (e.g., a vapor chamber, a heat pipe, a heat plate, a metal plate, a metal sheet, or a cover sheet) and the display 330 (e.g., a flexible display).

According to an embodiment, the second shield can 810 may be disposed on the printed circuit board 620 (e.g., a PCB or a PBA) to surround electronic components. For example, the electronic components may include one or more PMICs 830.

For example, the second shield can 810 may be located on the second surface (e.g., a bottom surface) of the printed circuit board 620 (e.g., a PCB or a PBA). For example, the second shield can 810 may be disposed to surround the one or more PMICs 830 so as to shield electromagnetic waves generated from the one or more PMICs 830. According to an embodiment, the second shield can 810 may dissipate heat generated from the one or more PMICs 830.

For example, the second shielding sheet 820 (e.g., a shielding plate) may have a function of shielding noise generated from the one or more PMICs 830, and at the same time, may dissipate heat generated from the one or more PMICs 830. To this end, the second shielding sheet 820 (e.g., a shielding plate) may be formed of a metal material having high thermal conductivity.

For example, an opening may be formed in a portion of a top surface of the second shield can 810, such that an upper portion of the second shield can 810 may open. In FIGS. 11 and 12, the first shield can 650 is disposed on the first surface (e.g., the top surface) of the printed circuit board 620 (e.g., a PCB or a PBA), and the second shield can 810 is disposed on the second surface (e.g., the bottom surface) of the printed circuit board 620 (e.g., a PCB or a PBA). Accordingly, the opening of the top surface of the first shield can 650 and the opening of the top surface of the second shield can 810 may be formed in directions opposite to each other.

According to an embodiment, the second shielding sheet 820 (e.g., a shielding plate) may be disposed to cover a top surface of the second shield can 810 (which corresponds to a lower side in FIGS. 16 and 17). For example, an upper portion of the second shield can 810 (which corresponds to a lower portion in FIGS. 16 and 17) may be shielded by the second shielding sheet 820 (e.g., a shielding plate).

According to an embodiment, the cover plate 1690 (e.g., a vapor chamber, a heat pipe, a heat plate, a metal plate, a metal sheet, or a cover sheet) may include a cover portion 1691, a first fixing portion 1692, and a second fixing portion 1693.

According to an embodiment, the cover portion 1691 of the cover plate 1690 (e.g., a vapor chamber, a heat pipe, a heat plate, a metal plate, a metal sheet, or a cover sheet) may correspond to the top surface of the first shield can 650 and may be formed to cover the top surface of the first shield can 650.

According to an embodiment, the cover portion 1691 of the cover plate 1690 (e.g., a vapor chamber, a heat pipe, a heat plate, a metal plate, a metal sheet, or a cover sheet) may correspond to the top surface of the shielding member 1650 and may be formed to cover the top surface of the shielding member 1650.

For example, the cover portion 1691 of the cover plate 1690 (e.g., a vapor chamber, a heat pipe, a heat plate, a metal plate, a metal sheet, or a cover sheet) may press the first shielding sheet 660 (e.g., a shielding plate) in a downward direction (e.g., the -z-axis direction) such that the first shielding sheet 660 (e.g., a shielding plate) is brought into close contact with the heat transfer member 640 (e.g., a TIM or a heat spreading member).

For example, the cover portion 1691 of the cover plate 1690 (e.g., a vapor chamber, a heat pipe, a heat plate, a metal plate, a metal sheet, or a cover sheet) may press the shielding member 1650 in a downward direction (e.g., the -z-axis direction) so as to be in close contact.

According to an embodiment, the first fixing portion 1692 of the cover plate 1690 (e.g., a vapor chamber, a heat pipe, a heat plate, a metal plate, a metal sheet, or a cover sheet) may protrude (e.g., protrude in a horizontal direction) from a first side of the cover plate 1690 (e.g., a vapor chamber, a heat pipe, a heat plate, a metal plate, a metal sheet, or a cover sheet). For example, the first fixing portion 1692 may be bent such that its top surface is positioned lower than the top surface of the cover portion 1691.

According to an embodiment, the second fixing portion 1693 of the cover plate 1690 (e.g., a vapor chamber, a heat pipe, a heat plate, a metal plate, a metal sheet, or a cover sheet) may protrude (e.g., protrude in a horizontal direction) from a second side of the cover plate 1690 (e.g., a vapor chamber, a heat pipe, a heat plate, a metal plate, a metal sheet, or a cover sheet). For example, the second fixing portion 1693 may be bent such that its top surface is positioned lower than the top surface of the cover portion 1691.

According to an embodiment, the first fixing portion 1692 may be fixed to the housing 610 (e.g., a rear housing) by a first screw 1710. For example, the first fixing portion 1692 may include a first screw hole. The first screw 1710 may be inserted into the first screw hole formed in the first fixing portion 1692. For example, the housing 610 (e.g., a rear housing) may include a first screw groove 6103 formed at a portion corresponding to the first screw hole. For example, the first screw 1710 may pass through the first screw hole to be inserted into the first screw groove 6103.

According to an embodiment, the second fixing portion 1693 may be fixed to the housing 610 (e.g., a rear housing) by a second screw 1720. For example, the second fixing portion 1693 may include a second screw hole. The second screw 1720 may be inserted into the second screw hole formed in the second fixing portion 1693. For example, the housing 610 (e.g., a rear housing) may include a second screw groove 6104 formed at a portion corresponding to the second screw hole. For example, the second screw 1720 may pass through the second screw hole to be inserted into the second screw groove 6104.

According to an embodiment, by a coupling structure between the first fixing portion 1692 and the housing 610 (e.g., a rear housing) using the first screw 1710, the first fixing portion 1692 may be fixed to the housing 610 (e.g., a rear housing). By a coupling structure between the second fixing portion 1693 and the housing 610 (e.g., a rear housing) using the second screw 1720, the second fixing portion 1693 may be fixed to the housing 610 (e.g., a rear housing). By this fixing structure, the first fixing portion 1692 and the second fixing portion 1693 may be pressed in a downward direction (e.g., the-z-axis direction), so that the cover plate 1690 (e.g., a vapor chamber, a heat pipe, a heat plate, a metal plate, a metal sheet, or a cover sheet) is brought into close contact with the first shielding sheet 660 (e.g., a shielding plate).

According to the electronic device 1600 of an embodiment of the disclosure, described with reference to FIGS. 16 and 17, heat dissipation efficiency may be improved by dispersing heat generated from the processor 630 (e.g., the processor 120 of FIG. 1 or an application processor) and the at least one electronic component 1640 over a wide area through the cover plate 1690 (e.g., a vapor chamber, a heat pipe, a heat plate, a metal plate, a metal sheet, or a cover sheet).

In the electronic device 1600 according to an embodiment of the disclosure, described with reference to FIGS. 16 and 17, the cover plate 1690 (e.g., a vapor chamber, a heat pipe, a heat plate, a metal plate, a metal sheet, or a cover sheet) may be brought into close contact with the first shielding sheet 660 (e.g., a shielding plate), thereby forming a gap between the display 330 (e.g., a flexible display) and the cover plate 1690 (e.g., a vapor chamber, a heat pipe, a heat plate, a metal plate, a metal sheet, or a cover sheet). Heat dissipation efficiency may be improved by dispersing heat through the first shielding sheet 660 (e.g., a shielding plate) and the cover plate 1690 (e.g., a vapor chamber, a heat pipe, a heat plate, a metal plate, a metal sheet, or a cover sheet).

According to the electronic device 1600 of an embodiment of the disclosure, described with reference to FIGS. 16 and 17, damage to the display 330 (e.g., a flexible display) may be prevented when a user presses (e.g., presses in the -z-axis direction) the display 330 (e.g., a flexible display) with a finger, by allowing the height of the top surface of the cover plate 1690 (e.g., a vapor chamber, a heat pipe, a heat plate, a metal plate, a metal sheet, or a cover sheet) to be substantially equal to the height of the top surface of the bracket 670 (e.g., a front bracket).

According to an embodiment of the disclosure, an electronic device (e.g., the electronic device 600 of FIG. 6) may include a housing including a top surface, a bottom surface opposite to the top surface, and a side surface surrounding the top surface and the bottom surface (e.g., the housing 610 of FIGS. 6 to 9), a display (e.g., the display 330 of FIGS. 8 and 9) disposed on the top surface of the housing 610, a bracket (e.g., the bracket 670 of FIGS. 8 and 9) disposed inside the housing 610, a printed circuit board (e.g., the printed circuit board 620 of FIG. 6) disposed between the housing 610 and the bracket 670, a first electronic component (e.g., the processor 630 of FIGS. 8 and 9) disposed on one surface of the printed circuit board 620, the one surface facing the display 330, a first shield can (e.g., the first shield can 650 of FIGS. 8 and 9) disposed so as to surround the first electronic component 630, a heat dissipation member (e.g., the heat dissipation member 680 of FIGS. 8 and 9) overlapping a portion of the bracket 670 and the first shield can 650 and disposed between the first shield can 650 and the display 330, and a cover plate (e.g., the cover plate 690 of FIGS. 8 and 9) disposed on a region of the heat dissipation member 680 and configured to fix the heat dissipation member 680 to the first shield can 650.

According to an embodiment, the cover plate 690 may be disposed at a portion corresponding to the first shield can 650.

According to an embodiment, the cover plate 690 may include a cover portion 691 corresponding to the first shield can 650, a first fixing portion 692 formed on a first side, and a second fixing portion 693 formed on a second side opposite to the first side.

According to an embodiment, the first fixing portion 692 may be fixed to the bracket 670.

According to an embodiment, the second fixing portion 693 may be fixed to the housing 610.

According to an embodiment, the second fixing portion 693 may include a hole 694. The housing 610 may include a screw groove 612 formed at a portion corresponding to the hole 694. A screw 695 may pass through a screw hole 694 and may be coupled to the screw groove 612.

According to an embodiment, the heat dissipation member 680 may overlap the entire cover plate 690 and at least a portion of the bracket 670.

According to an embodiment, the heat dissipation member 1210 may include a first portion 1211 overlapping the cover plate 690, a second portion 1212 overlapping the bracket 670, and a bending portion 1213 disposed between the first portion 1211 and the second portion 1212. The first portion 1211 may be disposed to correspond to a first height. The second portion 1212 may be disposed to correspond to a second height higher than the first height.

According to an embodiment, a top surface of the cover plate 690 may be located at a height equal to or lower than a height of a top surface of the heat dissipation member 1210.

According to an embodiment, a second shield can 1350 disposed to surround a second electronic component 1310 may be further included. The heat dissipation member 1210 may be disposed to overlap the second shield can 1350.

According to an embodiment of the disclosure, an electronic device (e.g., the electronic device 1600 of FIGS. 16 and 17) may include a housing (e.g., the housing 610 of FIGS. 16 and 17) including a top surface, a bottom surface opposite to the top surface, and a side surface surrounding the top surface and the bottom surface, a display (e.g., the display 330 of FIG. 6) disposed on the top surface of the housing, a bracket (e.g., the bracket 670 of FIGS. 16 and 17) disposed inside the housing, a printed circuit board (e.g., the printed circuit board 620 of FIGS. 16 and 17) disposed between the housing 610 and the bracket 670, a first electronic component (e.g., the electronic component 630 of FIGS. 16 and 17) and a second electronic component (e.g., the second electronic component 1640 of FIGS. 16 and 17) disposed on one surface of the printed circuit board 620, a shield can (e.g., the shield can 650 of FIGS. 16 and 17) disposed to surround the first electronic component 630, a shielding sheet (e.g., the shielding sheet 660 of FIGS. 16 and 17) disposed to cover an upper portion of the shield can 650, a shielding member disposed to surround the second electronic component 1640 (e.g., the shielding member 1650), and a cover plate (e.g., the cover plate 1690 of FIGS. 16 and 17) disposed under the display 330 to overlap a portion of the bracket 670, the shield can 650, and the shielding member 1650.

According to an embodiment, the electronic device 1600 may include a first adhesive member (e.g., the first adhesive member 1610 of FIG. 16) configured to attach the cover plate 1690 to the shielding sheet 660. The electronic device 1600 may include a second adhesive member configured to attach the cover plate 1690 to the bracket 670 (e.g., the second adhesive member 1620 of FIG. 16). The electronic device 1600 may include a third adhesive member configured to attach the cover plate 1690 to the shielding member 1650 (e.g., the third adhesive member 1630 of FIG. 16).

According to an embodiment, the cover plate 1690 may be disposed at a portion corresponding to a part or an entirety of the shield can 650.

According to an embodiment, the cover plate 1690 may be disposed at a portion corresponding to a part or an entirety of the shielding member 1650.

According to an embodiment, the cover plate 1690 may include a cover portion 1691 corresponding to the shield can 650 and the shielding member 1650. The cover plate 1690 may include a first fixing portion 1692 formed on a first side. The cover plate 1690 may include a second fixing portion 1693 formed on a second side opposite to the first side.

According to an embodiment, the electronic device 1600 may include a first screw 1710 configured to fix the first fixing portion 1692 to the housing and a second screw 1720 configured to fix the second fixing portion 1693 to the housing.

According to an embodiment, the first fixing portion 1692 may include a first screw hole. The housing 610 may include a first screw groove 6103 formed at a portion corresponding to the first screw hole. The first screw 1710 may pass through the first screw hole and may be coupled to the first screw groove 6103.

According to an embodiment, the second fixing portion 1693 may include a second screw hole. The housing 610 may include a second screw groove 6104 formed at a portion corresponding to the second screw hole. The second screw 1720 may pass through the second screw hole and may be coupled to the second screw groove 6104.

According to an embodiment, a top surface of the cover plate 1690 and a top surface of the bracket 670 may be located at substantially the same height.

According to an embodiment, the electronic device 1600 may further include an electronic component 830 disposed on the printed circuit board, a second shield can 810 disposed to surround the electronic component 830, and a second shielding sheet 820.

According to an embodiment of the disclosure, an electronic device may disperse heat generated by a processor (e.g., an application processor) over a wide area through a heat dissipation member (e.g., a heat dissipation plate or a heat dissipation sheet) and a cover plate (e.g., a metal plate, a metal sheet, or a cover sheet), and may improve heat dissipation efficiency.

According to an electronic device of an embodiment of the disclosure, a heat dissipation member (e.g., a heat dissipation plate or a heat dissipation sheet) may be brought into close contact with a shielding sheet (e.g., a shielding plate) via a cover plate (e.g., a metal plate, a metal sheet, or a cover sheet) so that a gap may be formed between a display (e.g., a flexible display) and the heat dissipation member (e.g., a heat dissipation plate or a heat dissipation sheet). Heat dissipation efficiency may be improved by dispersing heat through the heat dissipation member (e.g., a heat dissipation plate or a heat dissipation sheet), the shielding sheet (e.g., a shielding plate), and the cover plate (e.g., a metal plate, a metal sheet, or a cover sheet).

According to an electronic device of the disclosure, damage to a display (e.g., a flexible display) may be prevented when a user presses (e.g., presses in the -z-axis direction) the display with a finger, by allowing a height of a top surface of a cover plate (e.g., a metal plate, a metal sheet, or a cover sheet) and a height of a second portion of a heat dissipation member (e.g., a heat dissipation plate or a heat dissipation sheet) to be substantially the same.

According to an electronic device of an embodiment of the disclosure, heat dissipation efficiency may be improved by allowing heat transferred through a heat dissipation member (e.g., a heat dissipation plate or a heat dissipation sheet) to be spread to a lower structure of a display (e.g., a flexible display) through a thermally conductive compression member (e.g., a thermally conductive gasket) disposed at a position corresponding to a non-display area (e.g., a bezel region) of the display (e.g., a flexible display).

According to an electronic device of an embodiment of the disclosure, heat dissipation efficiency may be improved by allowing heat generated by a processor and at least one electronic component to be dispersed over a wide area through a cover plate (e.g., a vapor chamber, a heat pipe, a heat plate, a metal plate, a metal sheet, or a cover sheet).

According to an electronic device of an embodiment of the disclosure, by bringing a cover plate (e.g., a vapor chamber, a heat pipe, a heat plate, a metal plate, a metal sheet, or a cover sheet) into close contact with a first shielding sheet (e.g., a shielding plate) through the cover plate, a gap may be formed between a display (e.g., a flexible display) and the cover plate (e.g., a vapor chamber, a heat pipe, a heat plate, a metal plate, a metal sheet, or a cover sheet). Heat dissipation efficiency may be improved by dispersing heat through the first shielding sheet (e.g., a shielding plate) and the cover plate (e.g., a vapor chamber, a heat pipe, a heat plate, a metal plate, a metal sheet, or a cover sheet).

The effects obtainable from the disclosure are not limited to the effects described above, and other effects that are not mentioned may be clearly understood by those of ordinary skill in the art to which the disclosure pertains from the following description.

## Claims

1. An electronic device (600) comprising:
a housing (610) including a top surface, a bottom surface opposite to the top surface, and a side surface surrounding the top surface and the bottom surface;
a display (330) disposed on the top surface of the housing (610);
a bracket (670) disposed inside the housing (610);
a printed circuit board (620) disposed between the housing (610) and the bracket (670);
a first electronic component (630) disposed on one surface of the printed circuit board (620), the one surface facing the display (330);
a first shield can (650) disposed to surround the first electronic component (630);
a heat dissipation member (680) overlapping a portion of the bracket (670) and the first shield can (650), and disposed between the first shield can (650) and the display (330); and
a cover plate (690) disposed on a region of the heat dissipation member (680) and configured to fix the heat dissipation member (680) to the first shield can (650).

2. The electronic device of claim 1, wherein the cover plate (690) is disposed at a portion corresponding to the first shield can (650).

3. The electronic device of claim 2, wherein the cover plate (690) comprises:
a cover portion (691) corresponding to the first shield can (650);
a first fixing portion (692) formed on a first side; and
a second fixing portion (693) formed on a second side opposite to the first side.

4. The electronic device of claim 3, wherein the first fixing portion (692) is fixed to the bracket (670).

5. The electronic device of claim 4, wherein the second fixing portion (693) is fixed to the housing (610).

6. The electronic device of claim 5, wherein the second fixing portion (693) comprises a hole (694),
wherein the housing (610) comprises a screw groove (612) formed at a portion corresponding to the hole (694), and
wherein a screw (695) passes through the screw hole (694) and is coupled to the screw groove (612).

7. The electronic device of claim 2, wherein the heat dissipation member (680) overlaps an entirety of the cover plate (690) and at least a portion of the bracket (670).

8. The electronic device of claim 2, wherein the heat dissipation member (1210) comprises:
a first portion (1211) overlapping the cover plate (690);
a second portion (1212) overlapping the bracket (670); and
a bending portion (1213) disposed between the first portion (1211) and the second portion (1212),
wherein the first portion (1211) is disposed to correspond to a first height, and
wherein the second portion (1212) is disposed to correspond to a second height higher than the first height.

9. The electronic device of claim 8, wherein a top surface of the cover plate (690) is located at a height equal to or lower than a height of a top surface of the heat dissipation member (1210).

10. The electronic device of claim 9, further comprising:
a second shield can (1350) disposed to surround a second electronic component (1310),
wherein the heat dissipation member (1210) is disposed to overlap the second shield can (1350).
